(19) Europäisches Patentamt
European Patent Office
Office européen des brevets

(11) EP 4 694 636 A1

(12) EUROPEAN PATENT APPLICATION

(43) Date of publication:
**11.02.2026 Bulletin 2026/07**

(21) Application number: **25194459.1**

(22) Date of filing: **06.08.2025**

(51) International Patent Classification (IPC):
***H10K 50/155*** *(2023.01)* ***H10K 50/15*** *(2023.01)*
*H10K 101/30* *(2023.01)* *H10K 101/40* *(2023.01)*

(52) Cooperative Patent Classification (CPC):
**H10K 50/156; H10K 50/155;** H10K 85/631; H10K 85/633; H10K 85/6572; H10K 2101/30; H10K 2101/40

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **09.08.2024 KR 20240106528**

(71) Applicant: **Samsung Display Co., Ltd.**
**Yongin-si, Gyeonggi-do (KR)**

(72) Inventors:
- **KIM, Beomjin**
  **Yongin-si (KR)**
- **PARK, Hye Jeong**
  **Yongin-si (KR)**
- **JEON, Sangho**
  **Yongin-si (KR)**
- **CHOI, Sunmi**
  **Yongin-si (KR)**

(74) Representative: **Marks & Clerk LLP**
**15 Fetter Lane**
**London EC4A 1BW (GB)**

# (54) LIGHT EMITTING ELEMENT AND ELECTRONIC DEVICE INCLUDING THE SAME

(57) A light emitting element includes a first electrode, a hole transport region on the first electrode, an emission layer on the hole transport region, an electron transport region on the emission layer, and a second electrode on the electron transport region. The hole transport region includes a first hole transport layer between the first electrode and the emission layer and including a first hole transport material. The first hole transport layer includes a first sub-hole transport layer on the first electrode and including the first hole transport material doped with a first p-dopant, a second sub-hole transport layer between the emission layer and the first sub-hole transport layer and including the first hole transport material doped with a second p-dopant, and a third sub-hole transport layer between the first sub-hole transport layer and the second sub-hole transport layer and including the first hole transport material and not including a p-dopant.

FIG. 5A

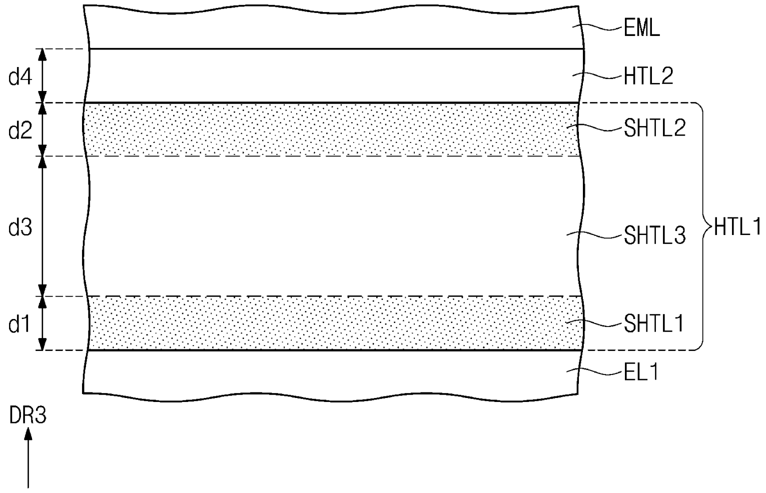




Processed by Luminess, 75001 PARIS (FR)

## Description

## BACKGROUND

### 1. Field

One or more embodiments of the present disclosure relate to a light emitting element and an electronic device including the same.

### 2. Description of the Related Art

Recently, organic electroluminescence display devices have been actively developed as image display devices. Unlike liquid crystal display devices and/or the like, the organic electroluminescence display devices are self-luminescent. In these organic electroluminescence display devices, holes and electrons respectively injected from a first electrode and a second electrode recombine in an emission layer. Consequently, a light emitting material, including an organic compound in the emission layer, emits light to accomplish display (e.g., to display images).

For application of light emitting elements to display devices, there is a consistent demand for light emitting elements that have high luminous efficiency and a long life. Therefore, the development of materials and structures, for light emitting elements that can stably attain these desired characteristics is being actively pursued.

## SUMMARY

One or more aspects of embodiments of the present disclosure are directed toward a light emitting element that has improved element service life.

One or more aspects of embodiments of the present disclosure are directed toward an electronic device including a light emitting element that has improved element service life.

Additional aspects will be set forth in part in the description which follows and, in part, will be apparent from the description, or may be learned by practice of the presented embodiments.

According to one or more embodiments of the present disclosure, a light emitting element includes a first electrode, a hole transport region on (e.g., arranged on) the first electrode, an emission layer on (e.g., arranged on) the hole transport region, an electron transport region on (e.g., arranged on) the emission layer, and a second electrode on (e.g., arranged on) the electron transport region. The hole transport region includes a first hole transport layer between (e.g., arranged between) the first electrode and the emission layer and including a first hole transport material. The first hole transport layer includes a first sub-hole transport layer on (e.g., arranged on) the first electrode and including the first hole transport material and a first p-dopant with which the first hole transport material is doped, a second sub-hole transport layer between (e.g., arranged between) the emission layer and the first sub-hole transport layer and including the first hole transport material and a second p-dopant with which the first hole transport material is doped, and a third sub-hole transport layer between (e.g., arranged between) the first sub-hole transport layer and the second sub-hole transport layer and including the first hole transport material and not including a p-dopant (e.g., excluding a p-dopant).

In one or more embodiments, the first p-dopant and the second p-dopant may each have a lowest unoccupied molecular orbital (LUMO) energy level with an absolute value of about 4.5 eV to about 6.0 eV.

In one or more embodiments, the first hole transport material may have a lower absolute value of highest occupied molecular orbital (HOMO) energy level than each of the first p-dopant and the second p-dopant. For example, the absolute value of HOMO energy level of the first hole transport material may be lower than that of each of the first p-dopant and the second p-dopant.

In one or more embodiments, the absolute value of HOMO energy level of the first hole transport material is H1, and the absolute value of LUMO energy level of each of the first p-dopant and the second p-dopant is P1, a case in which H1 is equal to or greater than P1 may satisfy Equation 1, and a case in which P1 is greater than H1 may satisfy Equation 2.

**Equation 1**

$$H1 - P1 \leq 0.5 \text{ eV}$$

**Equation 2**

$$P1 - H1 < 1.0 \text{ eV}.$$

In one or more embodiments, the first p-dopant and the second p-dopant may be identical to each other.

In one or more embodiments, the first hole transport layer may further include a fourth sub-hole transport layer between (e.g., arranged between) the second sub-hole transport layer and the emission layer and including the first hole transport material and not including a p-dopant (e.g., excluding a p-dopant).

In one or more embodiments, the first hole transport material may include a (1-1)-th hole transport material (e.g., may also be referred to as a first-first hole transport material), and a (1-2)-th hole transport material (e.g., may also be referred to as a first-second hole transport material) different from the (1-1)-th hole transport material.

In one or more embodiments, the hole transport region may further include a second hole transport layer between (e.g., arranged between) the first hole transport layer and the emission layer and including a second hole transport material different from the first hole transport material.

In one or more embodiments, the first hole transport material may have a first refractive index, and the second hole transport material may have a second refractive index greater than the first refractive index.

In one or more embodiments, the first hole transport material may have a refractive index of about 1.7 to about 2.2 in a wavelength range of about 460 nm to about 800 nm.

In one or more embodiments, the hole transport region may further include a third hole transport layer between (e.g., arranged between) the first electrode and the first hole transport layer and including a third hole transport material.

In one or more embodiments, the first hole transport material may be represented by Formula 1 or Formula 2.

**Formula 1**

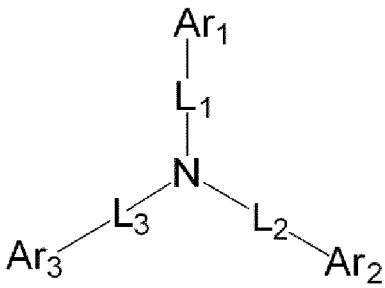

**Formula 2**

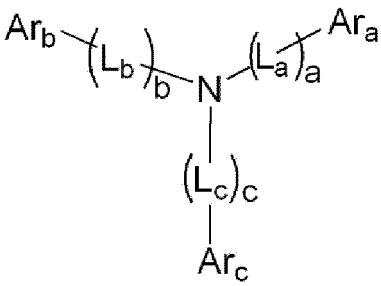

In Formula 1 and Formula 2, $Ar_1$ to $Ar_3$ are each independently a substituted or unsubstituted aryl group having 6 to 30 ring-forming carbon atoms or a substituted or unsubstituted heteroaryl group having 2 to 30 ring-forming carbon atoms, $Ar_a$ to $Ar_c$ are each independently a substituted or unsubstituted amine group, a substituted or unsubstituted aryl group having 6 to 30 ring-forming carbon atoms, or a substituted or unsubstituted heteroaryl group having 2 to 30 ring-forming carbon atoms, $L_1$ to $L_3$ and $L_a$ to $L_c$ are each independently a direct linkage, a substituted or unsubstituted arylene group having 6 to 30 ring-forming carbon atoms, or a substituted or unsubstituted heteroarylene group having 2 to 30 ring-forming carbon atoms, a to c are each independently an integer of 0 to 3, and in Formula 1, at least one selected from among $L_1$ through $L_3$ is a phenylene group represented by Formula A-1 or Formula A-2, or a substituted or unsubstituted divalent naphthyl group, and/or at least one of $Ar_1$ or $Ar_3$ is substituted with a substituted or unsubstituted cycloalkyl group having 3 to 20 carbon atoms.

**Formula A-1**

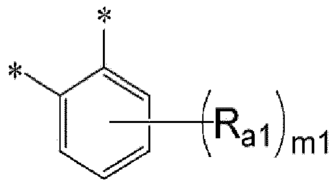

**Formula A-2**

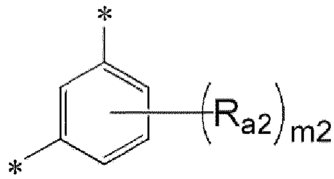

In Formula A-1 and Formula A-2, $R_{a1}$ and $R_{a2}$ are each independently hydrogen, deuterium, a halogen, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and m1 and m2 are each independently an integer of 0 to 4.

In one or more embodiments, the first sub-hole transport layer and the second sub-hole transport layer may each have a thickness of about 30 angstroms (Å) (i.e., $10^{-10}$ meter) to about 200 Å.

In one or more embodiments, the second sub-hole transport layer may be spaced and/or apart (e.g., spaced apart or separated) from the emission layer in a thickness direction, and the second sub-hole transport layer and the emission layer may be separated with a distance of about 100 Å to about 300 Å.

In one or more embodiments, the first p-dopant may be present at a content (e.g., amount) level of about 10 wt% or less with respect to a total content (e.g., amount) of 100 wt% of the first sub-hole transport layer, and the second p-dopant may be present at a content (e.g., amount) level of about 10 wt% or less with respect to a total content (e.g., amount) of 100 wt% of the second sub-hole transport layer.

In one or more embodiments, the first hole transport material may include at least one selected from among compounds in Compound Group 1 and Compound Group 2.

## Compound Group 1

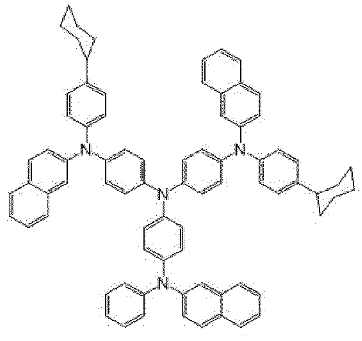

A1

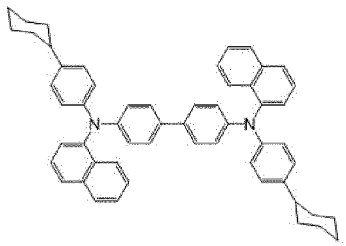

A2

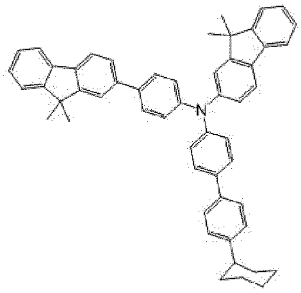

A3

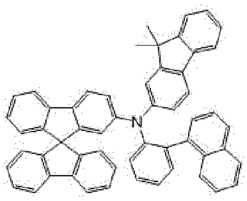

A4

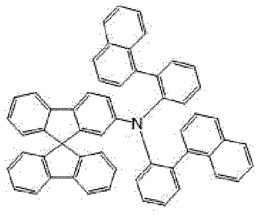

A5

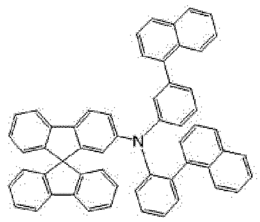

A6

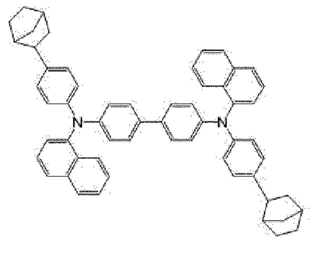

A7

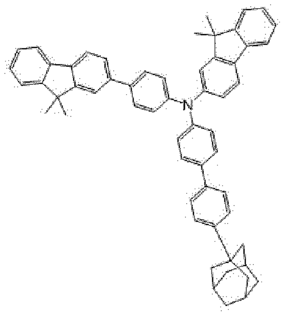

A8

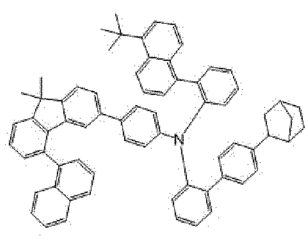

A9

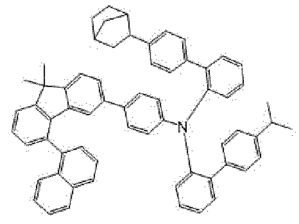

A10

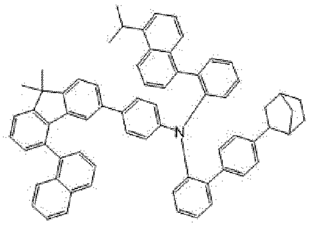

A11

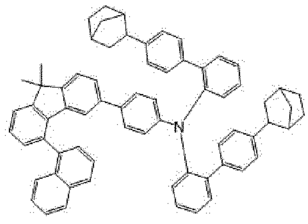

A12

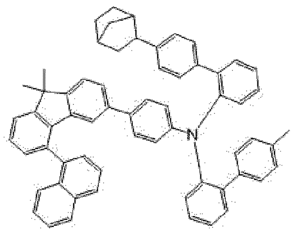

A13

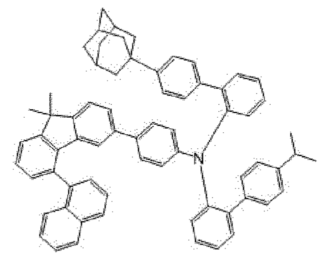

A14

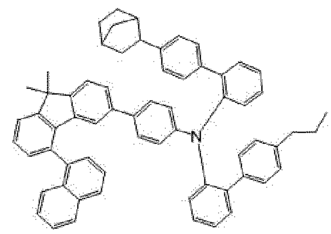

A15

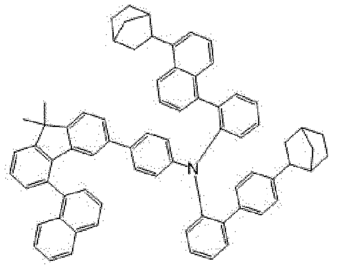

A16

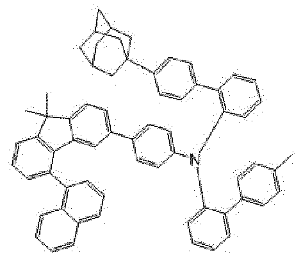

A17

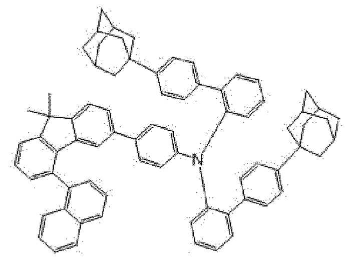

A18

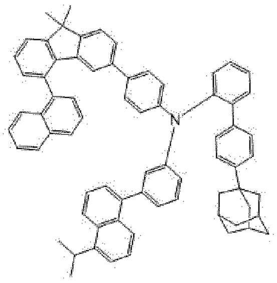

A19

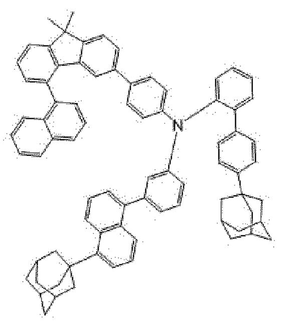

A20

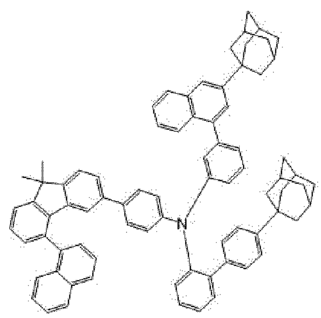

A21

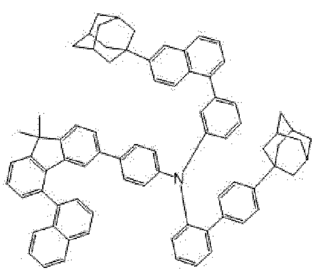

A22

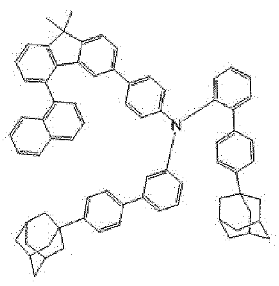

A23

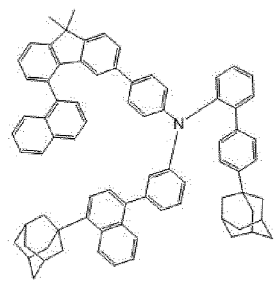

A24

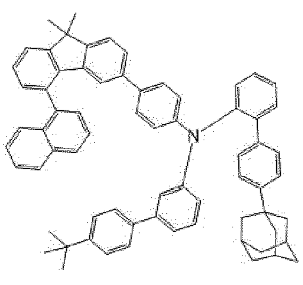

A25

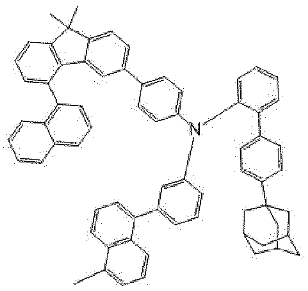

A26

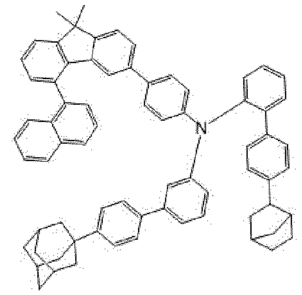

A27

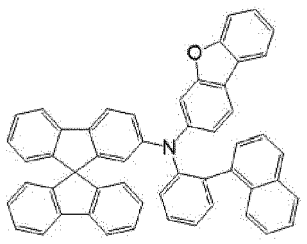

A28

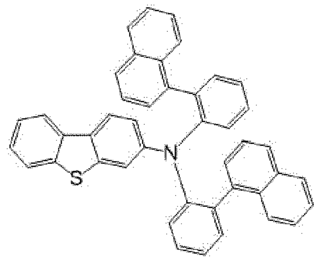

A29

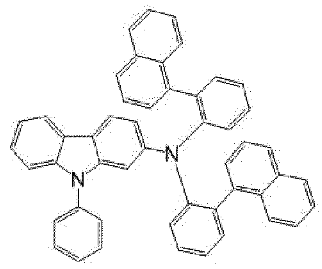

A30

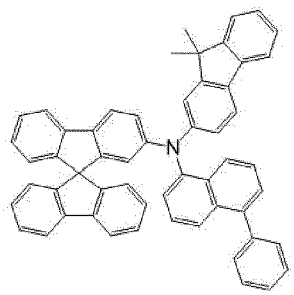

A31

## Compound Group 2

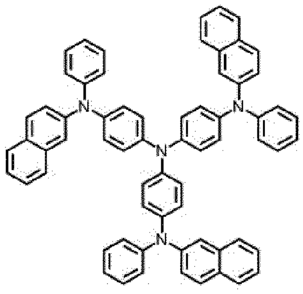

B1

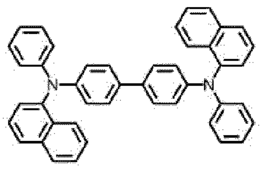

B2

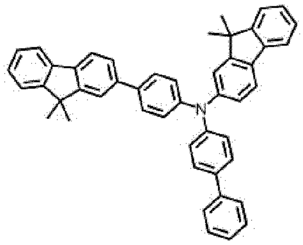

B3

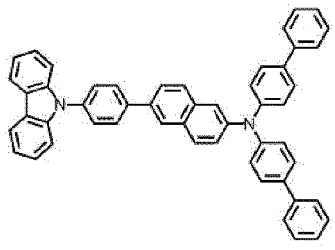

B4

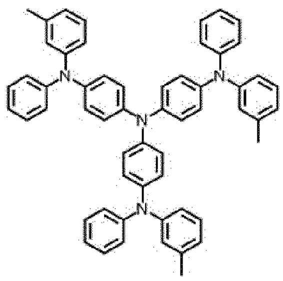

B5

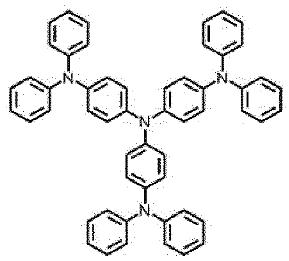

B6

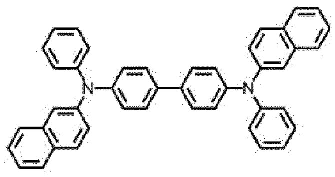

B7

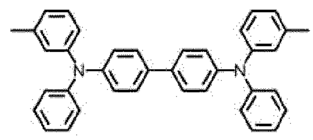

B8

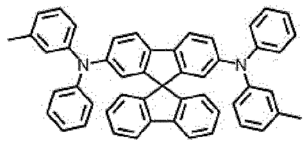

B9

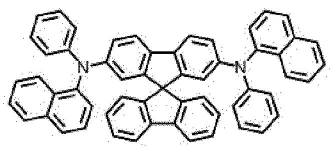

B10

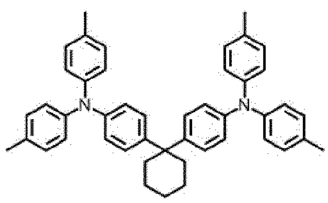

B11

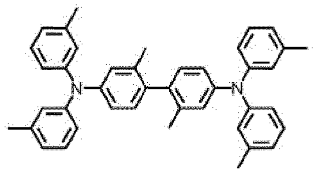

B12

According to one or more embodiments of the present disclosure, a light emitting element includes a first electrode, a hole transport region on (e.g., arranged on) the first electrode, an emission layer on (e.g., arranged on) the hole transport region, an electron transport region on (e.g., arranged on) the emission layer, and a second electrode on (e.g., arranged on) the electron transport region. The hole transport region includes a first hole transport layer between (e.g., arranged between) the first electrode and the emission layer and including a first hole transport material having a refractive index of about 1.7 to about 2.2 in a wavelength range of about 460 nm to about 800 nm. The first hole transport layer includes a first sub-hole transport layer on (e.g., arranged on) the first electrode and including the first hole transport material and a first p-dopant with which the first hole transport material is doped, a second sub-hole transport layer between (e.g., arranged between) the emission layer and the first sub-hole transport layer and including the first hole transport material and a second p-dopant with which the first hole transport material is doped, and a third sub-hole

transport layer between (e.g., arranged between) the first sub-hole transport layer and the second sub-hole transport layer and including the first hole transport material. The first hole transport material has a lower HOMO energy level than each of the first p-dopant and the second p-dopant (e.g., the HOMO energy level of the first hole transport material may be lower than that of each of the first p-dopant and the second p-dopant), and the HOMO energy level of the first hole transport material is H1, and an LUMO energy level of each of the first p-dopant and the second p-dopant is P1, a case in which H1 is equal to or greater than P1 satisfies Equation 1, and a case in which P1 is greater than H1 satisfies Equation 2. For example, the HOMO energy level of the first hole transport material is H1, and the LUMO energy levels of each of the first p-dopant and the second p-dopant are P1, (1) a case in which H1 is equal to or greater than P1 satisfies Equation 1 and (2) a case in which P1 is greater than H1 satisfies Equation 2.

## Equation 1

$$H1 - P1 \leq 0.5 \text{ eV}$$

## Equation 2

$$P1 - H1 < 1.0 \text{ eV}.$$

According to one or more embodiments of the present disclosure, an electronic device includes a base layer including a plurality of light emitting regions and a non-light emitting region adjacent to the plurality of light emitting regions, a circuit layer on (e.g., arranged on) the base layer, and a display element layer on (e.g., arranged on) the circuit layer and including a plurality of light emitting elements respectively corresponding to each of the plurality of light emitting regions. At least some selected from among the plurality of light emitting elements each include a first electrode, a hole transport region on (e.g., arranged on) the first electrode, an emission layer on (e.g., arranged on) the hole transport region, an electron transport region on (e.g., arranged on) the emission layer, and a second electrode on (e.g., arranged on) the electron transport region. The hole transport region includes a first hole transport layer between (e.g., arranged between) the first electrode and the emission layer and including a first hole transport material. The first hole transport layer includes a first sub-hole transport layer on (e.g., arranged on) the first electrode and including the first hole transport material and a first p-dopant with which the first hole transport material is doped, a second sub-hole transport layer between (e.g., arranged between) the emission layer and the first sub-hole transport layer and including the first hole transport material and a second p-dopant with which the first hole transport material is doped, and a third sub-hole transport layer between (e.g., arranged between) the first sub-hole transport layer and the second sub-hole transport layer and including the first hole transport material and not including a p-dopant (e.g., excluding any p-dopant).

In one or more embodiments, the light emitting element may further include a capping layer on (e.g., arranged on) the second electrode. The capping layer may have a refractive index of about 1.6 or greater in a wavelength range of about 550 nm to about 660 nm.

In one or more embodiments, the electronic device may further include a light control layer on (e.g., arranged on) the display element layer and including quantum dots. The light emitting element may be to emit first color light, and the light control layer may include a first light control portion including a first quantum dot that converts the first color light into second color light having a longer wavelength than the first color light, a second light control portion including a second quantum dot that converts the first color light into third color light having a longer wavelength than the first color light and the second color light, and a third light control portion that transmits the first color light.

At least some of the above and other features of the invention are set out in the claims.

## BRIEF DESCRIPTION OF DRAWINGS

The accompanying drawings are included to provide a further understanding of the present disclosure, and are incorporated in and constitute a part of this disclosure. The drawings illustrate embodiments of the present disclosure and, together with the description, serve to explain principles of the disclosure. Above and/or other aspects of the disclosure should become apparent and appreciated from the following description of embodiments taken in conjunction with the accompanying drawings. In the drawings:

FIG. 1 is a plan view of a display apparatus according to one or more embodiments of the present disclosure;
FIG. 2 is a cross-sectional view of a display apparatus according to one or more embodiments of the present disclosure;
FIG. 3 is a cross-sectional view schematically showing a light emitting element according to one or more embodiments of the present disclosure;

FIG. 4 is a cross-sectional view schematically showing a light emitting element according to one or more embodiments of the present disclosure;

FIG. 5A and FIG. 5B are each a cross-sectional view schematically showing a light emitting element according to one or more embodiments of the present disclosure;

FIG. 6 is a cross-sectional view schematically showing a light emitting element according to one or more embodiments of the present disclosure;

FIG. 7 is a cross-sectional view schematically showing a light emitting element according to one or more embodiments of the present disclosure;

FIG. 8 is a cross-sectional view schematically showing a light emitting element according to one or more embodiments of the present disclosure;

FIG. 9 is a cross-sectional view showing a display apparatus according to one or more embodiments of the present disclosure;

FIG. 10 is a cross-sectional view showing a display apparatus according to one or more embodiments of the present disclosure;

FIG. 11 is a cross-sectional view showing a display apparatus according to one or more embodiments of the present disclosure;

FIG. 12 is a cross-sectional view showing a display apparatus according to one or more embodiments of the present disclosure; and

FIG. 13 is a view showing a vehicle in which display apparatuses according to one or more embodiments are arranged.

## DETAILED DESCRIPTION

The present disclosure may be modified in one or more suitable manners and have many forms, and thus specific/example embodiments will be illustrated in the drawings and described in more detail in the detailed description of the present disclosure. It should be understood, however, that it is not intended to limit the disclosure to the particular forms disclosed, but rather, is intended to cover all modifications, equivalents, and alternatives falling within the scope of the disclosure.

When explaining each of the drawings, like reference numbers are used for referring to like elements. In the accompanying drawings, the dimensions of each structure may be exaggeratingly illustrated for clarity of the present disclosure. It will be understood that, although the terms "first," "second," and/or the like, may be used herein to describe one or more suitable components, these components should not be limited by these terms. These terms are only used to distinguish one component from another. For example, a first component could be termed a second component, and, similarly, a second component could be termed a first component, without departing from the scope of example embodiments of the disclosure. As used herein, the singular forms, "a," "an," "one," and "the" are intended to include the plural forms as well, unless the context clearly indicates otherwise. Further, the utilization of "may" when describing embodiments of the present disclosure refers to "one or more embodiments of the present disclosure."

In the present disclosure, it will be understood that the terms "comprise(s)/comprising," "include(s)/including," "have(has)/having," and/or the like specify the presence of features, numbers, steps, operations, component, parts, and/or one or more (e.g., any suitable) combinations thereof disclosed in the disclosure, but do not exclude the possibility of presence or addition of one or more other features, numbers, steps, operations, component, parts, and/or one or more (e.g., any suitable) combinations thereof. Additionally, the terms "comprise(s)/comprising," "include(s)/including," "have/has/having", or other similar terms include or support the terms "consisting of" and "consisting essentially of," indicating the presence of stated features, numbers, steps, operations, components and/or parts, without or essentially without the presence of other features, numbers, steps, operations, components, and/or parts thereof. As used herein, the terms "and," "or," and "and/or" may include any and all combinations of one or more of the associated listed items. Expressions such as "at least one of," "one of," and "selected from," when preceding a list of elements, modify the entire list of elements and do not modify the individual elements of the list. For example, "at least one of a, b, or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

In the present disclosure, if (e.g., when) a layer, a film, a region, or a plate is referred to as being "on" or "in an upper portion of" another layer, film, region, or plate, it may be not only "directly on" the layer, film, region, or plate, but one or more intervening layers, films, regions, or plates may also be present therebetween. On the contrary to this, if (e.g., when) a layer, a film, a region, or a plate is referred to as being "below" or "in a lower portion of" another layer, film, region, or plate, it can be not only directly under the layer, film, region, or plate, but one or more intervening layers, films, regions, or plates may also be present therebetween. In addition, it will be understood that if (e.g., when) a part is referred to as being "on" another part, the part may be arranged above the other part, or arranged under the other part as well. In the present disclosure, "directly on" may refer to that there are no additional layers, films, regions, plates, and/or like, between a layer, a

film, a region, a plate, *etc.* and the other part. For example, "directly on" may refer to two layers or two members are arranged without utilizing an additional member such as an adhesive member therebetween.

In the present disclosure, the term "substituted or unsubstituted" may refer to substituted or unsubstituted with at least one substituent selected from the group consisting of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In addition, each of the substituents exemplified above may be substituted or unsubstituted. For example, a biphenyl group may be interpreted as an aryl group or a phenyl group substituted with a phenyl group.

In the present disclosure, the phrase "bonded to an adjacent group to form a ring" may refer to that a group is bonded to an adjacent group to form a substituted or unsubstituted hydrocarbon ring, or a substituted or unsubstituted heterocycle. The hydrocarbon ring may include an aliphatic hydrocarbon ring and/or an aromatic hydrocarbon ring. The heterocycle may include an aliphatic heterocycle and/or an aromatic heterocycle. The hydrocarbon ring and the heterocycle may each be monocyclic or polycyclic. In addition, the rings formed by adjacent groups being bonded to each other may be connected to another ring to form a spiro structure.

In the present disclosure, the term "adjacent group" may refer to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as "adjacent groups" to each other and two ethyl groups in 1,1-diethylcyclopentane may be interpreted as "adjacent groups" to each other. In addition, two methyl groups in 4,5-dimethylphenanthrene may be interpreted as "adjacent groups" to each other.

In the present disclosure, examples of a halogen may include fluorine, chlorine, bromine, and/or iodine.

In the present disclosure, an alkyl group may be linear or branched. The number of carbons in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, and/or the like, but embodiments of the present disclosure are not limited thereto.

In the present disclosure, a cycloalkyl group may refer to a cyclic alkyl group. The number of carbons in the cycloalkyl group may be 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, and/or the like, but embodiments of the present disclosure are not limited thereto.

In the present disclosure, an alkenyl group refers to a hydrocarbon group including at least one carbon-carbon double bond in the middle or terminal of an alkyl group having 2 or more carbon atoms. The alkenyl group may be linear or branched. The number of carbon atoms in the alkenyl group is not specifically limited, for example, may be 2 to 30, 2 to 20, or 2 to 10. Examples of the alkenyl group may include a vinyl group, a 1-butenyl group, a 1-pentenyl group, a 1,3-butadienyl aryl group, a styrenyl group, a styryl vinyl group, and/or the like, but embodiments of the present disclosure are not limited thereto.

In the present disclosure, an alkynyl group refers to a hydrocarbon group including at least one carbon-carbon triple bond in the middle or terminal of an alkyl group having 2 or more carbon atoms. The alkynyl group may be linear or branched. Although the number of carbon atoms is not specifically limited, it may be 2 to 30, 2 to 20, or 2 to 10. Examples of the alkynyl group may include an ethynyl group, a propynyl group, and/or the like, but embodiments of the present disclosure are not limited thereto.

In the present disclosure, a hydrocarbon ring group refers to any functional group or substituent derived from an aliphatic hydrocarbon ring. The hydrocarbon ring group may be a saturated hydrocarbon ring group having 5 to 20 ring-forming carbon atoms.

In the present disclosure, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 36, 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like, but embodiments of the present disclosure are not limited thereto.

In the present disclosure, a fluorenyl group may be substituted, and two substituents may be bonded to each other to form a spiro structure. Examples of the substituted fluorenyl group are as follows. However, embodiments of the present disclosure are not limited thereto.

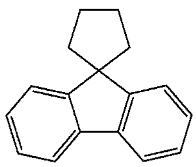 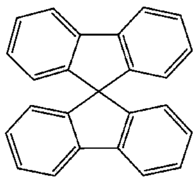 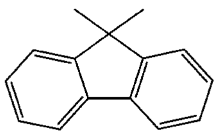 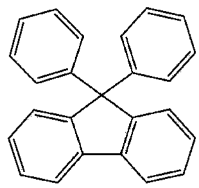

A heterocyclic group as used herein refers to any functional group or substituent derived from a ring containing at least one of B, O, N, P, Si, or Se as a heteroatom. The heterocyclic group includes an aliphatic heterocyclic group and/or an aromatic heterocyclic group. The aromatic heterocyclic group may be a heteroaryl group. The aliphatic heterocycle and the aromatic heterocycle may each be monocyclic or polycyclic.

In the present disclosure, the heterocyclic group may contain at least one of B, O, N, P, Si, or S as a heteroatom. If (e.g., when) the heterocyclic group contains two or more heteroatoms, the two or more heteroatoms may be the same as or different from each other. The heterocyclic group may be a monocyclic heterocyclic group or a polycyclic heterocyclic group, and may include a heteroaryl group. The number of ring-forming carbon atoms in the heterocyclic group may be 2 to 30, 2 to 20, or 2 to 10.

In the present disclosure, the aliphatic heterocyclic group may include at least one of B, O, N, P, Si, or S as a heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, but embodiments of the present disclosure are not limited thereto.

In the present disclosure, the heteroaryl group may contain at least one of B, O, N, P, Si, or S as a heteroatom. If (e.g., when) the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridine group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, and/or the like, but embodiments of the present disclosure are not limited thereto.

In the present disclosure, the above description of the aryl group may be applied to an arylene group except that the arylene group is a divalent group. The above description of the heteroaryl group may be applied to a heteroarylene group except that the heteroarylene group is a divalent group.

In the present disclosure, a silyl group may include an alkylsilyl group and/or an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but embodiments of the present disclosure are not limited thereto.

In the present disclosure, the number of carbon atoms in a carbonyl group is not specifically limited, for example, may be 1 to 40, 1 to 30, or 1 to 20. For example, the carbonyl group may have the following structures, but embodiments of the present disclosure are not limited thereto.

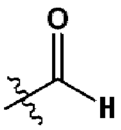 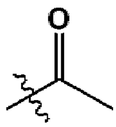 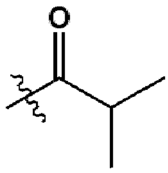 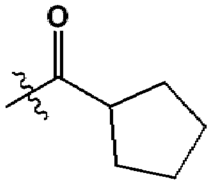 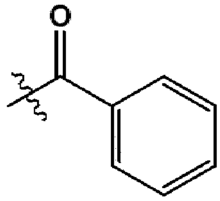

In the present disclosure, the number of carbon atoms in a sulfinyl group or a sulfonyl group is not particularly limited, for example, may be 1 to 30. The sulfinyl group may include an alkyl sulfinyl group and/or an aryl sulfinyl group. The sulfonyl group may include an alkyl sulfonyl group and/or an aryl sulfonyl group.

In the present disclosure, a thio group may include an alkylthio group and/or an arylthio group. The thio group may refer to that a sulfur atom is bonded to the alkyl group or the aryl group defined above. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, and a naphthylthio group, but embodiments of the present disclosure are not limited thereto.

In the present disclosure, an oxy group may refer to that an oxygen atom is bonded to the alkyl group or the aryl group defined above. The oxy group may include an alkoxy group and/or an aryl oxy group. The alkoxy group may be a linear chain, a branched chain, or a ring. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, and/or the like, but embodiments of the present disclosure are not limited thereto.

A boron group as used herein may refer to that a boron atom is bonded to the alkyl group or the aryl group defined above. The boron group includes an alkyl boron group and/or an aryl boron group. Examples of the boron group may include a dimethylboron group, a diethylboron group, a t-butylmethylboron group, a diphenylboron group, a phenylboron group, and/or the like, but embodiments of the present disclosure are not limited thereto.

In the present disclosure, the number of carbon atoms in an amine group is not specifically limited, for example, may be 1 to 30. The amine group may include an alkyl amine group and/or an aryl amine group. Examples of the amine group may include a methylamine group, a dimethylamine group, a phenylamine group, a diphenylamine group, a naphthylamine group, a 9-methyl-anthracenylamine group, and/or the like, but embodiments of the present disclosure are not limited thereto.

In the present disclosure, the alkyl group among an alkylthio group, an alkylsulfoxy group, an alkylaryl group, an alkylamino group, an alkyl boron group, an alkyl silyl group, and an alkyl amine group may be the same as the examples of the alkyl group described above.

In the present disclosure, the aryl group among an aryloxy group, an arylthio group, an arylsulfoxy group, an arylamino group, an arylboron group, an arylsilyl group, an arylamine group may be the same as the examples of the aryl group described above.

In the present disclosure, the phosphine oxide group may be substituted with, for example, at least one of the alkyl groups or aryl groups described above.

In the present disclosure, the phosphine sulfide group may be substituted with, for example, at least one of the alkyl groups or aryl groups described above.

In the present disclosure, a direct linkage may refer to a single bond.

In the disclosure,

“ 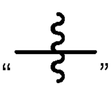 ”

and "



" each refer to a position to be connected.

Hereinafter, embodiments of the disclosure will be described with reference to the accompanying drawings.

FIG. 1 is a plan view illustrating a display apparatus (e.g., display device) DD according to one or more embodiments of the present disclosure. FIG. 2 is a cross-sectional view of the display apparatus DD according to one or more embodiments of the present disclosure. FIG. 2 is a cross-sectional view illustrating a part taken along the line I-I’ of the display apparatus DD of FIG. 1.

The display apparatus DD may include a display panel DP and an optical layer PP arranged on the display panel DP. The display panel DP may include light emitting devices ED-1, ED-2, and ED-3. The display apparatus DD may include a plurality of light emitting devices ED-1, ED-2, and ED-3. The optical layer PP may be arranged on the display panel DP to control reflected light in the display panel DP due to external light. The optical layer PP may include, for example, a polarization layer and/or a color filter layer. In one or more embodiments, the optical layer PP may not be provided in the display apparatus DD.

A base substrate BL may be arranged on the optical layer PP. The base substrate BL may be a member which provides a base surface on which the optical layer PP is arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided.

The display apparatus DD according to one or more embodiments may further include a filling layer. The filling layer may be arranged between a display device layer DP-ED and the base substrate BL. The filling layer may be an organic material layer. The filling layer may include at least one of an acrylic-based resin, a silicone-based resin, or an epoxy-based resin.

The display panel DP may include a base layer BS, a circuit layer DP-CL provided on the base layer BS, and a display device layer DP-ED. The display device layer DP-ED may include a pixel defining film PDL, the light emitting devices ED-1, ED-2, and ED-3 arranged between respective portions of the pixel defining film PDL, and an encapsulation layer TFE arranged on the light emitting devices ED-1, ED-2, and ED-3.

The base layer BS may be a member which provides a base surface on which the display device layer DP-ED is arranged. The base layer BS may be a glass substrate, a metal substrate, a plastic substrate, and/or the like. However, embodiments of the present disclosure are not limited thereto, and the base layer BS may be an inorganic layer, an organic layer, or a composite material layer.

In one or more embodiments, the circuit layer DP-CL may be arranged on the base layer BS, and the circuit layer DP-CL may include a plurality of transistors. Each of the transistors may include a control electrode, an input electrode, and an output electrode. For example, in one or more embodiments, the circuit layer DP-CL may include switching transistor(s) and driving transistor(s) for driving the light emitting devices ED-1, ED-2, and ED-3 of the display device layer DP-ED.

Each of the light emitting devices ED-1, ED-2, and ED-3 may have a structure of one of the light emitting devices ED of embodiments according to FIGS. 3, 4, 5A, 5B, and 6 to 8, which will be described in more detail later. Each of the light emitting devices ED-1, ED-2, and ED-3 includes a first electrode EL1, a hole transport region HTR, respective emission layers EML-R, EML-G, and EML-B, an electron transport region ETR, and a second electrode EL2.

FIG. 2 illustrates one or more embodiments in which the respective emission layers EML-R, EML-G, and EML-B of the light emitting devices ED-1, ED-2, and ED-3 are arranged in openings OH defined in the pixel defining film PDL, and the hole transport region HTR, the electron transport region ETR, and the second electrode EL2 are each provided as a common layer across the entire light emitting devices ED-1, ED-2, and ED-3. However, embodiments of the present disclosure are not limited thereto, for example, in one or more embodiments, the hole transport region HTR and the electron transport region ETR may each be provided by being patterned inside the openings OH defined in the pixel defining film PDL. For example, in one or more embodiments, the hole transport region HTR, the respective emission layers EML-R, EML-G, and EML-B, and the electron transport region ETR of the light emitting devices ED-1, ED-2, and ED-3 may be provided by being patterned in an inkjet printing method.

The encapsulation layer TFE may cover the light emitting devices ED-1, ED-2, and ED-3. The encapsulation layer TFE may seal the display device layer DP-ED. The encapsulation layer TFE may be a thin film encapsulation layer. The encapsulation layer TFE may be formed by laminating one layer or a plurality of layers. The encapsulation layer TFE may include at least one insulation layer. The encapsulation layer TFE according to one or more embodiments may include at least one inorganic film (hereinafter, an encapsulation-inorganic film). The encapsulation layer TFE according to one or more embodiments may include at least one organic film (hereinafter, an encapsulation-organic film) and at least one encapsulation-inorganic film.

The encapsulation-inorganic film protects the display device layer DP-ED from moisture/oxygen, and the encapsulation-organic film protects the display device layer DP-ED from foreign substances such as dust particles. The encapsulation-inorganic film may include silicon nitride, silicon oxynitride, silicon oxide, titanium oxide, aluminium oxide, and/or the like, but embodiments of the present disclosure are not particularly limited thereto. In one or more embodiments, the encapsulation-organic film may include an acrylic-based compound, an epoxy-based compound, and/or the like. In one or more embodiments, the encapsulation-organic film may include a photopolymerizable organic material, but embodiments of the present disclosure are not particularly limited thereto.

The encapsulation layer TFE may be arranged on the second electrode EL2 and may be arranged to fill the opening OH.

Referring to FIG. 1 and FIG. 2, the display apparatus DD may include a non-light emitting region NPXA and light emitting regions PXA-R, PXA-G, and PXA-B. The light emitting regions PXA-R, PXA-G, and PXA-B may be regions in

which light generated by the respective light emitting devices ED-1, ED-2, and ED-3 is emitted. The light emitting regions PXA-R, PXA-G, and PXA-B may be spaced and/or apart (e.g., spaced apart or separated) from one another on a plane (e.g., in plan view).

Each of the light emitting regions PXA-R, PXA-G, and PXA-B may be a region divided by the pixel defining film PDL. The non-light emitting area NPXA may be areas between adjacent light emitting areas PXA-R, PXA-G, and PXA-B, which correspond to the pixel defining film PDL. In one or more embodiments, the light emitting regions PXA-R, PXA-G, and PXA-B may respectively correspond to pixels. The pixel defining film PDL may divide the light emitting devices ED-1, ED-2, and ED-3. The respective emission layers EML-R, EML-G, and EML-B of the light emitting devices ED-1, ED-2, and ED-3 may be arranged in openings OH defined in the pixel defining film PDL and separated from one another.

The light emitting regions PXA-R, PXA-G, and PXA-B may be divided into a plurality of groups according to the color of light generated from the light emitting devices ED-1, ED-2, and ED-3. In the display apparatus DD of one or more embodiments illustrated in FIG. 1 and FIG. 2, three light emitting regions PXA-R, PXA-G, and PXA-B, which emit red light, green light, and blue light, respectively, are exemplarily illustrated. For example, the display apparatus DD of one or more embodiments may include a red light emitting region PXA-R, a green light emitting region PXA-G, and a blue light emitting region PXA-B that are separated from one another.

In the display apparatus DD according to one or more embodiments, the plurality of light emitting devices ED-1, ED-2, and ED-3 may be to emit light beams having wavelengths different from one another. For example, in one or more embodiments, the display apparatus DD may include a first light emitting element ED-1 that emits red light, a second light emitting element ED-2 that emits green light, and a third light emitting element ED-3 that emits blue light. For example, in one or more embodiments, the red light emitting region PXA-R, the green light emitting region PXA-G, and the blue light emitting region PXA-B of the display apparatus DD may correspond to the first light emitting element ED-1, the second light emitting element ED-2, and the third light emitting element ED-3, respectively.

However, embodiments of the present disclosure are not limited thereto, and the first to third light emitting devices ED-1, ED-2, and ED-3 may be to emit light beams in substantially the same wavelength range or at least one light emitting device may be to emit a light beam in a wavelength range different from the others. For example, in one or more embodiments, the first to third light emitting devices ED-1, ED-2, and ED-3 may all emit blue light.

The light emitting regions PXA-R, PXA-G, and PXA-B in the display apparatus DD according to one or more embodiments may be arranged in a stripe form. Referring to FIG. 1, a plurality of red light emitting regions PXA-R may be arranged with each other along a second direction axis DR2, a plurality of green light emitting regions PXA-G may be arranged with each other along the second direction axis DR2, and a plurality of blue light emitting regions PXA-B may be arranged with each other along the second directional axis DR2. In addition, the red light emitting region PXA-R, the green light emitting region PXA-G, and the blue light emitting region PXA-B may be alternately arranged in this order along a first direction axis DR1.

FIG. 1 and FIG. 2 illustrate that all the light emitting regions PXA-R, PXA-G, and PXA-B have similar areas, but embodiments of the present disclosure are not limited thereto. Thus, the light emitting regions PXA-R, PXA-G, and PXA-B may have different areas from one another according to the wavelength range of the emitted light. In this regard, the areas of the light emitting regions PXA-R, PXA-G, and PXA-B may refer to areas if (e.g., when) viewed on a plane defined by the first direction axis DR1 and the second direction axis DR2 (i.e., areas in plan view).

In one or more embodiments, an arrangement form of the light emitting regions PXA-R, PXA-G, and PXA-B is not limited to the configuration illustrated in FIG. 1, and the order in which the red light emitting region PXA-R, the green light emitting region PXA-G, and the blue light emitting region PXA-B are arranged may be provided in one or more suitable combinations according to the characteristics of display quality desired or required in the display apparatus DD. For example, in one or more embodiments, the arrangement form of the light emitting regions PXA-R, PXA-G, and PXA-B may be a pentile (PENTILE®) arrangement form (for example, an RGBG matrix, an RGBG structure, or an RGBG matrix structure) or a diamond (Diamond Pixel™) arrangement form (e.g., a display (e.g., an OLED display) containing red, blue, and green (RGB) light-emitting regions arranged in the shape of diamonds). PENTILE® is a duly registered trademark of Samsung Display Co., Ltd. Diamond Pixel™ is a trademark of Samsung Display Co., Ltd.

In one or more embodiments, the areas of the light emitting regions PXA-R, PXA-G, and PXA-B may be different from one another. For example, in one or more embodiments, the area of the green light emitting region PXA-G may be smaller than that of the blue light emitting region PXA-B, but embodiments of the present disclosure are not limited thereto.

Hereinafter, FIGS. 3, 4, and 6 to 8 are each a cross-sectional view schematically showing a light emitting element according to one or more embodiments. FIG. 5A and FIG. 5B are each a cross-sectional view enlarging a portion of a light emitting element according to one or more embodiments of the present disclosure.

A light emitting element ED according to one or more embodiments includes a first electrode EL1, a second electrode EL2 opposite to (e.g., facing) the first electrode EL1, and at least one functional layer arranged between the first electrode EL1 and the second electrode EL2. In one or more embodiments of the light emitting element ED, a hole transport region HTR may include a first hole transport layer HTL1 arranged on the first electrode EL1, and a second hole transport layer HTL2 arranged adjacent to an emission layer EML. In one or more embodiments, the first hole transport

layer HTL1 may be a layer having a lower refractive index than the second hole transport layer HTL2. The light emitting element ED of one or more embodiments may include a first hole transport material of one or more embodiments described herein in the first hole transport layer HTL1 and a p-dopant with which a portion of the first hole transport layer HTL1 is doped. The light emitting element ED of one or more embodiments may include a first hole transport material of one or more embodiments described herein in the first hole transport layer HTL1 and a second hole transport material in the second hole transport layer HTL2.

As shown in FIG. 3, the light emitting element ED may include a hole transport region HTR, an emission layer EML, and an electron transport region ETR, which are sequentially stacked, as the at least one functional layer. For example, the light emitting element ED of one or more embodiments includes a first electrode EL1, a hole transport region HTR, an emission layer EML, an electron transport region ETR, and a second electrode EL2.

FIG. 4 shows, compared with FIG. 3, a cross-sectional view of a light emitting element ED of one or more embodiments in which the hole transport region HTR includes a first hole transport layer HTL1 and a second hole transport layer HTL2, and the electron transport region ETR includes an electron transport layer ETL and an electron injection layer EIL. FIG. 6 shows, compared with FIG. 4, a cross-sectional view of a light emitting element ED of one or more embodiments, in which the hole transport region HTR further includes a third hole transport layer HTL3 arranged between the first electrode EL1 and the first hole transport layer HTL1. FIG. 7 shows, compared with FIG. 4, a cross-sectional view of a light emitting element ED of one or more embodiments, in which the electron transport region ETR further includes a hole blocking layer HBL arranged between the electron transport layer ETL and the emission layer EML, the hole transport region HTR further includes a third hole transport layer HTL3 arranged between the first electrode EL1 and the first hole transport layer HTL1, and an electron blocking layer EBL arranged between the emission layer EML and the second hole transport layer HTL2. FIG. 8 shows, compared with FIG. 6, a cross-sectional view of a light emitting element ED according to one or more embodiments, in which a capping layer CPL arranged on the second electrode EL2 is further included.

The first electrode EL1 has conductivity (e.g., is a conductor). The first electrode EL1 may be formed of a metal material, a metal alloy, and/or a conductive compound. The first electrode EL1 may be an anode or a cathode. However, embodiments of the present disclosure are not limited thereto. In one or more embodiments, the first electrode EL1 may be a pixel electrode. The first electrode EL1 may be a transmissive electrode, a transflective electrode, or a reflective electrode. The first electrode EL1 may include at least one selected from among silver (Ag), magnesium (Mg), copper (Cu), aluminium (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), and zinc (Zn), a compound of two or more selected therefrom, a mixture of two or more selected therefrom, or an oxide thereof.

If (e.g., when) the first electrode EL1 is a transmissive electrode, the first electrode EL1 may include a transparent metal oxide such as indium tin oxide (ITO), indium zinc oxide (IZO), zinc oxide (ZnO), and/or indium tin zinc oxide (ITZO). If (e.g., when) the first electrode EL1 is a transflective electrode or a reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, a compound thereof, or a mixture thereof (e.g., a mixture of Ag and Mg). In one or more embodiments, the first electrode EL1 may have a multilayer structure including a reflective film or a transflective film formed of one or more of the above-described materials, and a transparent conductive film formed of ITO, IZO, ZnO, ITZO, and/or the like. For example, in one or more embodiments, the first electrode EL1 may have a three-layer structure of ITO/Ag/ITO, but embodiments of the present disclosure are not limited thereto. In one or more embodiments, the first electrode EL1 may include one of the above-described metal materials, one or more combinations of at least two metal materials of the above-described metal materials, any oxide of the above-described metal materials, and/or the like. A thickness of the first electrode EL1 may be from about 700 Å to about 10,000 Å. For example, in one or more embodiments, the thickness of the first electrode EL1 may be from about 1,000 Å to about 3,000 Å.

The hole transport region HTR is provided on the first electrode EL1. The hole transport region HTR may include a first hole transport layer HTL1 and a second hole transport layer HTL2. The first hole transport layer HTL1 may be arranged on the first electrode EL1, and the second hole transport layer HTL2 may be arranged on the first hole transport layer HTL1. The first hole transport layer HTL1 having a relatively lower refractive index than the second hole transport layer HTL2 may be arranged adjacent to the first electrode EL1, and the second hole transport layer HTL2 may be arranged on an upper portion of the first hole transport layer HTL1. In the light emitting element ED of one or more embodiments, the hole transport region HTR may include a plurality of hole transport layers HTL1 and HTL2, which are arranged in the order of a low refractive hole transport layer/high refractive hole transport layer in a thickness direction.

In a wavelength range of about 460 nm to about 800 nm, the first hole transport layer HTL1 may have a refractive index of about 1.20 to about 1.90. In addition, in a wavelength range of about 460 nm to about 800 nm, the second hole transport layer HTL2 may have a refractive index of about 1.90 to about 2.50. In a wavelength range of about 460 nm to about 800 nm, a difference in refractive index between the first hole transport layer HTL1 and the second hole transport layer HTL2 may be greater than about 0.1. For example, in one or more embodiments, in a wavelength range of about 460 nm to about 800 nm, a difference in refractive index between the first hole transport layer HTL1 and the second hole transport layer HTL2 may be about 0.2 or greater.

Meanwhile, for convenience of description, in FIGS. 3, 4, and 6 to 8, the first hole transport layer HTL1 and the second hole transport layer HTL2 are shown as having the same thickness, but embodiments of the present disclosure are not limited thereto, and a thickness of the first hole transport layer and a thickness of the second hole transport layer may be different from each other. The thicknesses of the first hole transport layer HTL1 and the second hole transport layer HTL2 may be controlled or selected to be in an optimum or desired range according to a wavelength range of light emitted from the emission layer EML, display quality desired or required for the display apparatus DD (FIG. 1), and the type (kind) of a hole transport material used in each of the hole transport layers HTL1 and HTL2 of the hole transport region HTR.

The light emitting element ED of one or more embodiments includes the first hole transport layer HTL1 and the second hole transport layer HTL2, which are arranged in the order of a low refractive hole transport layer/high refractive hole transport layer, and thus may exhibit increased luminous efficiency. The light emitting element ED of one or more embodiments includes the first hole transport layer HTL1 and the second hole transport layer HTL2 having different refractive indices, thereby minimizing or reducing the extinction of light emitted from functional layers inside due to destructive interference, and exhibiting high light extraction efficiency through constructive interference between the hole transport layers HTL1 and HTL2 having different refractive indices.

The first hole transport layer HTL1 may be arranged on the first electrode EL1. The hole transport region HTR of one or more embodiments may include the first hole transport layer HTL1 arranged on the first electrode EL1, and the second hole transport layer HTL2 arranged on the first hole transport layer HTL1. In one or more embodiments, the first hole transport layer HTL1 may be directly arranged on the first electrode EL1. However, embodiments of the present disclosure are not limited thereto, for example, in one or more embodiments, an additional layer, such as a third hole transport layer HTL3, may be further arranged between the first electrode EL1 and the first hole transport layer HTL1. The second hole transport layer HTL2 may be directly arranged on the first hole transport layer HTL1. In addition, the second hole transport layer HTL2 may be directly arranged below the emission layer EML. However, embodiments of the present disclosure are not limited thereto, for example, in one or more embodiments, an additional layer, such as an electron blocking layer EBL, may be further arranged between the second hole transport layer HTL2 and the emission layer EML.

Referring to FIG. 4 and FIG. 5A, in the light emitting element ED of one or more embodiments, the first hole transport layer HTL1 includes a plurality of sub-hole transport layers SHTL1, SHTL2, and SHTL3. The sub-hole transport layers SHTL1, SHTL2, and SHTL3 may be layers that include a same hole transport material, but are differentiated by the doping of p-dopants.

The first hole transport layer HTL1 includes a first sub-hole transport layer SHTL1 arranged on the first electrode EL1, a second sub-hole transport layer SHTL2 arranged between the first sub-hole transport layer SHTL1 and the emission layer EML, and a third sub-hole transport layer SHTL3 arranged between the first sub-hole transport layer SHTL1 and the second sub-hole transport layer SHTL2.

The first hole transport layer HTL1 includes a first hole transport material, and each of the sub-hole transport layers SHTL1, SHTL2, and SHTL3 included in the first hole transport layer HTL1 all include the first hole transport material. The first hole transport material may be a material having a refractive index of about 1.7 to about 2.2 in a wavelength range of about 460 nm to about 800 nm. For example, in one or more embodiments, the first hole transport material may have a refractive index of about 1.7 to about 1.85 in a wavelength range of about 460 nm to about 800 nm. In one or more embodiments, the first hole transport material may have a refractive index of about 1.90 to about 2.2 in a wavelength range of about 460 nm to about 800 nm.

In one or more embodiments, the first hole transport material may be represented by Formula 1. The first hole transport material represented by Formula 1 may have a refractive index of about 1.7 to about 1.85 in a wavelength range of about 460 nm to about 800 nm.

**Formula 1**

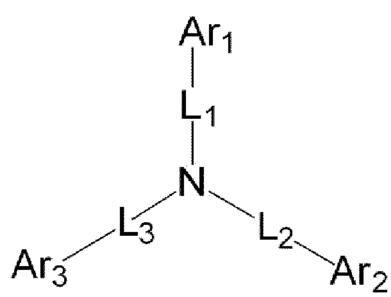

In Formula 1, $Ar_1$ to $Ar_3$ are each independently a substituted or unsubstituted aryl group having 6 to 30 ring-forming carbon atoms or a substituted or unsubstituted heteroaryl group having 2 to 30 ring-forming carbon atoms. For example, in one or more embodiments, $Ar_1$ to $Ar_3$ may each independently be a substituted or unsubstituted phenyl group,

an unsubstituted biphenyl group, a substituted or unsubstituted naphthyl group, or a substituted or unsubstituted fluorenyl group.

In Formula 1, $L_1$ to $L_3$ are each independently a direct linkage, a substituted or unsubstituted arylene group having 6 to 30 ring-forming carbon atoms, or a substituted or unsubstituted heteroarylene group having 2 to 30 ring-forming carbon atoms. For example, in one or more embodiments, $L_1$ to $L_3$ may each independently be a direct linkage, a substituted or unsubstituted phenylene group, or a substituted or unsubstituted divalent naphthyl group.

In Formula 1, at least one selected from among $L_1$ through $L_3$ is a phenylene group represented by Formula A-1 or Formula A-2, or a substituted or unsubstituted divalent naphthyl group, and/or at least one of $Ar_1$ or $Ar_3$ is substituted with a substituted or unsubstituted cycloalkyl group having 3 to 20 carbon atoms.

**Formula A-1**

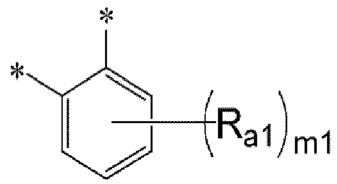

**Formula A-2**

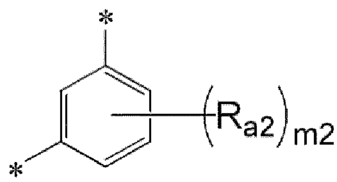

In Formulas A-1 and A-2, $R_{a1}$ and $R_{a2}$ are each independently hydrogen, deuterium, a halogen, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in one or more embodiments, $R_{a1}$ and $R_{a2}$ may each independently be hydrogen or deuterium.

In Formulas A-1 and A-2, m1 and m2 are each independently an integer of 0 to 4. In Formulas A-1 and A-2, if (e.g., when) m1 and m2 are each 0, the amine compound of one or more embodiments, represented by Formula 1, may not be substituted with each of $R_{a1}$ and $R_{a2}$. In Formulas A-1 and A-2, an embodiment in which m1 and m2 are each 4, and $R_{a1}$'s and $R_{a2}$'s are each hydrogen may be the same as an embodiment in which m1 and m2 are each 0 in Formulas A-1 and A-2. If (e.g., when) m1 and m2 are each an integer of 2 or greater, $R_{a1}$ and $R_{a2}$ each provided in plurality may each be the same, or at least one of $R_{a1}$ or $R_{a2}$ each provided in plurality may be different.

In one or more embodiments, in Formula 1, at least one selected from among $L_1$ through $L_3$ may be a phenylene group represented by Formula A-1 or Formula A-2, or a substituted or unsubstituted divalent naphthyl group, $Ar_1$ to $Ar_3$ may each independently be a substituted or unsubstituted phenyl group or a substituted or unsubstituted naphthyl group, and at least one selected from among $Ar_1$ through $Ar_3$ may be substituted with a substituted or unsubstituted cyclohexyl group. For example, in one or more embodiments, at least one selected from among $Ar_1$ through $Ar_3$ may be a phenyl group substituted with a cyclohexyl group, or a biphenyl group substituted with a cyclohexyl group, and the others may be substituted or unsubstituted phenyl groups or substituted or unsubstituted naphthyl groups.

In one or more embodiments, the first hole transport material represented by Formula 1 may be represented by Formula 1-1 or Formula 1-2.

**Formula 1-1**

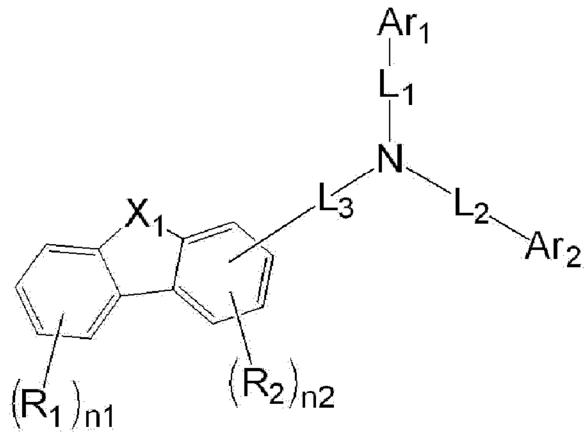

**Formula 1-2**

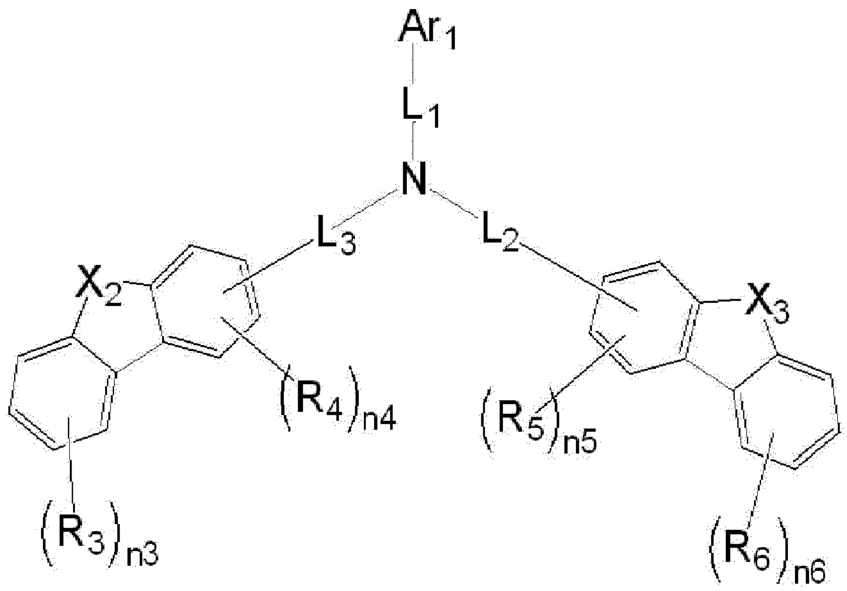

In Formula 1-1 and Formula 1-2, $X_1$ to $X_3$ are each independently $CR_7R_8$, $NR_9$, O, S, or Se. For example, in one or more embodiments, $X_1$ to $X_3$ may each independently be $CR_7R_8$.

In Formula 1-1 and Formula 1-2, $R_1$ to $R_9$ are each independently hydrogen, deuterium, a halogen, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In one or more embodiments, one or more selected from among $R_1$ to $R_9$ may be bonded to an adjacent group to form a ring. For example, in one or more embodiments, $R_1$ to $R_6$ may each independently be hydrogen or deuterium. In one or more embodiments, $R_7$ to $R_9$ may each independently be hydrogen, a substituted or unsubstituted methyl group, or a substituted or unsubstituted phenyl group. In one or more embodiments, $R_7$ and $R_8$ may be bonded to each other to form a ring. If (e.g., when) $R_7$ and $R_8$ are bonded to each other to form a ring, a fluorenyl group included in the first hole transport material represented by any one of Formula 1-1 and Formula 1-2 may have a spiro structure.

In Formulas 1-1 and 1-2, n1, n3, and n6 are each independently an integer of 0 to 4, and n2, n4, and n5 are each independently an integer of 0 to 3.

If (e.g., when) n1, n3, and n6 are each 0, the first hole transport material of one or more embodiments may not be substituted with each of $R_1$, $R_3$, and $R_6$. If (e.g., when) n1, n3, and n6 are each 4 and $R_1$'s, $R_3$'s, and $R_6$'s are each hydrogen, the embodiment may be the same as if (e.g., when) n1, n3, and n6 are each 0. If (e.g., when) n1, n3, and n6 are each an integer of 2 or greater, $R_1$, $R_3$, and $R_6$ each provided in plurality may each be the same, or at least one of $R_1$, $R_3$, or $R_6$ each

provided in plurality may be different.

If (e.g., when) n2, n4, and n5 are each 0, the first hole transport material of one or more embodiments may not be substituted with each of $R_2$, $R_4$, and $R_5$. If (e.g., when) n2, n4, and n5 are each 3 and $R_2$'s, $R_4$'s, and $R_5$'s are each hydrogen, the embodiments may be the same as if (e.g., when) n2, n4, and n5 are each 0. If (e.g., when) n2, n4, and n5 are each an integer of 2 or greater, $R_2$, $R_4$, and $R_5$ each provided in plurality may each be the same, or at least one of $R_2$, $R_4$, or $R_5$ each provided in plurality may be different.

In Formulas 1-1 and 1-2, the same descriptions as in Formula 1 apply to $Ar_1$, $Ar_2$, and $L_1$ to $L_3$. In other words, $Ar_1$, $Ar_2$, and $L_1$ to $L_3$ in Formula 1-1 and Formula 1-2 are each the same as described in Formula 1.

In one or more embodiments, the first hole transport material represented by Formula 1 may be represented by any one selected from among Formulas 1-4 to 1-6.

Formula 1-4

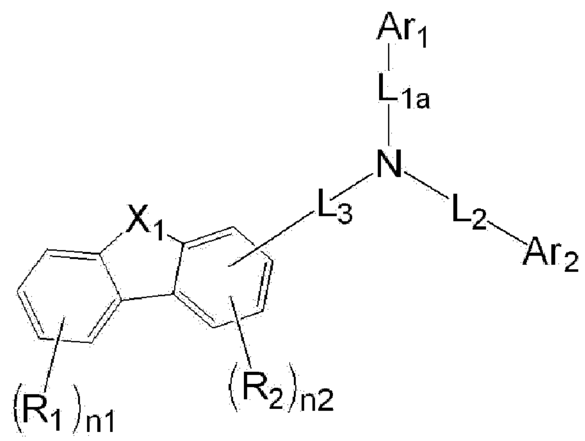

Formula 1-5

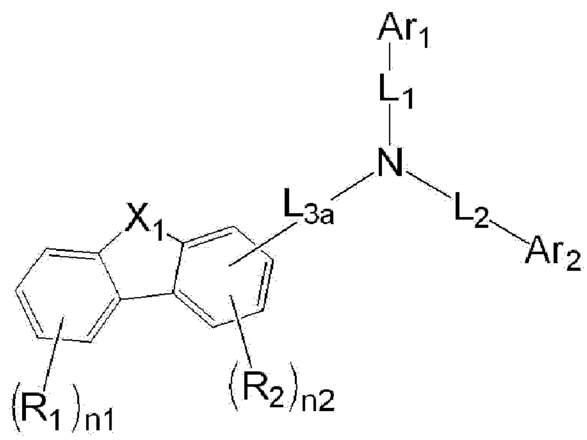

Formula 1-6

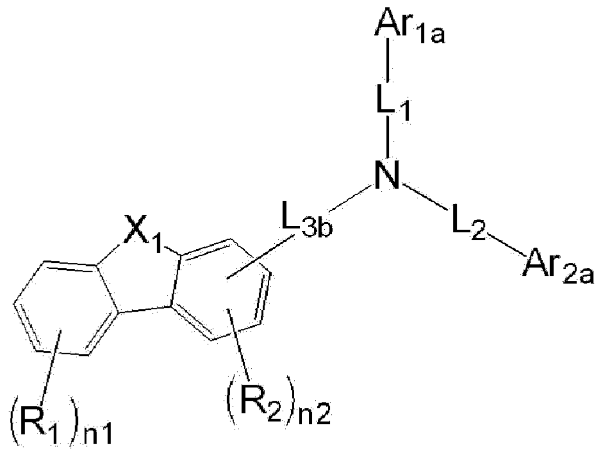

In Formulas 1-4 to 1-6, $X_1$ is $CR_7R_8$, $NR_9$, O, S, or Se. For example, in one or more embodiments, $X_1$ may be $CR_7R_8$.

In Formulas 1-4 to 1-6, $R_1$, $R_2$, and $R_7$ to $R_9$ are each independently hydrogen, deuterium, a halogen, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. In one or more embodiments, one or more selected from among $R_1$, $R_2$, and $R_7$ to $R_9$ may be bonded to an adjacent group to form a ring. For example, in one or more embodiments, $R_1$ and $R_2$ may each independently be hydrogen or deuterium. In one or more embodiments, $R_7$ to $R_9$ may each independently be hydrogen, a substituted or unsubstituted methyl group, or a substituted or unsubstituted phenyl group. In one or more embodiments, $R_7$ and $R_8$ may be bonded to each other to form a ring. If (e.g., when) $R_7$ and $R_8$ are bonded to each other to form a ring, a fluorenyl group included in the first hole transport material represented by any one of Formulas 1-4 to 1-6 may have a spiro structure.

In Formula 1-4 and Formula 1-5, $L_{1a}$ and $L_{3a}$ are each independently represented by Formula A-1.

In Formula 1-6, $L_{3b}$ is a substituted or unsubstituted arylene group having 6 to 30 ring-forming carbon atoms or a substituted or unsubstituted heteroarylene group having 2 to 30 ring-forming carbon atoms. For example, in one or more embodiments, $L_{3b}$ may be a substituted or unsubstituted phenylene group.

In Formula 1-6, $Ar_{1a}$ and $Ar_{2a}$ are each independently a substituted or unsubstituted aryl group having 6 to 30 ring-forming carbon atoms or a substituted or unsubstituted heteroaryl group having 2 to 30 ring-forming carbon atoms. For example, in one or more embodiments, $Ar_{1a}$ and $Ar_{2a}$ may each independently be a substituted or unsubstituted phenyl group, an unsubstituted biphenyl group, a substituted or unsubstituted naphthyl group, or a substituted or unsubstituted fluorenyl group.

In Formula 1-6, at least one of $Ar_{1a}$ or $Ar_{2a}$ is substituted with a substituted or unsubstituted cyclohexyl group, a substituted or unsubstituted bicycloheptyl group, or a substituted or unsubstituted adamantyl group. For example, in one or more embodiments, either $Ar_{1a}$ or $Ar_{2a}$ may be substituted with a substituted or unsubstituted cyclohexyl group. In one or more embodiments, $Ar_{1a}$ and $Ar_{2a}$ may each be substituted with a substituted or unsubstituted cyclohexyl group. In one or more embodiments, at least one of $Ar_{1a}$ or $Ar_{2a}$ may be a phenyl group substituted with a cyclohexyl group, or a biphenyl group substituted with a cyclohexyl group.

In Formulas 1-4 to 1-6, n1 is an integer of 0 to 4. In Formulas 1-4 to 1-6, if (e.g., when) n1 is 0, the amine compound of one or more embodiments may not be substituted with $R_1$. In Formulas 1-4 to 1-6, if (e.g., when) n1 is 4 and $R_1$'s are each hydrogen, the embodiment may be the same as if (e.g., when) n1 is 0 in Formulas 1-4 to 1-6. If (e.g., when) n1 is an integer of 2 or greater, $R_1$ provided in plurality may all be the same, or at least one selected from among the plurality of $R_1$'s may be different.

In Formulas 1-4 to 1-6, n2 is an integer of 0 to 3. In Formulas 1-4 to 1-6, if (e.g., when) n2 is 0, the amine compound of one or more embodiments may not be substituted with $R_2$. In Formulas 1-4 to 1-6, if (e.g., when) n2 is 3 and $R_2$'s are each hydrogen, the embodiment may be the same as if (e.g., when) n2 is 0 in Formulas 1-4 and 1-6. If (e.g., when) n2 is an integer of 2 or greater, $R_2$ provided in plurality may all be the same, or at least one selected from among the plurality of $R_2$'s may be different.

In Formulas 1-4 to 1-6, the same descriptions as in Formula 1 apply to $Ar_1$, $Ar_2$, and $L_1$ to $L_3$. In other words, $Ar_1$, $Ar_2$, and $L_1$ to $L_3$ in Formulas 1-4 to 1-6 are each the same as described in Formula 1.

In one or more embodiments, the first hole transport material represented by Formula 1 may be any one selected from among compounds in Compound Group 1. The first hole transport layer HTL1 of the light emitting element ED according to one or more embodiments may include at least one selected from among the compounds in Compound Group 1 as the first hole transport material.

## Compound Group 1

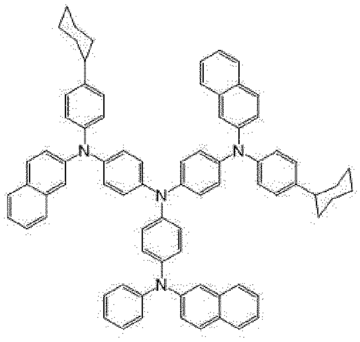
A1

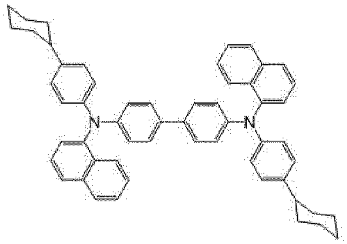
A2

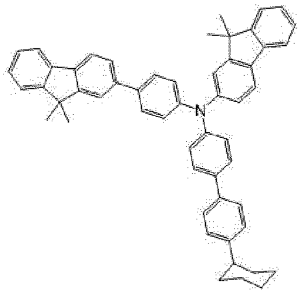
A3

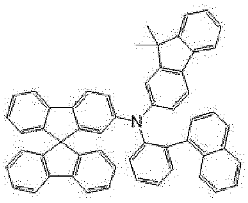
A4

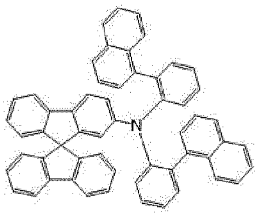
A5

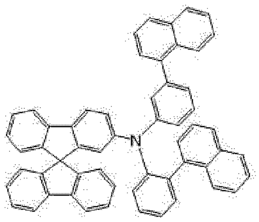
A6

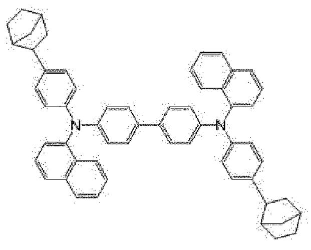
A7

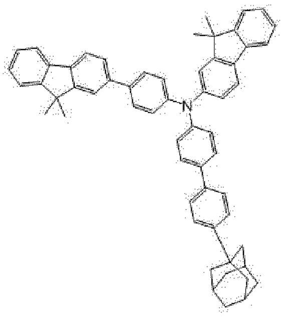
A8

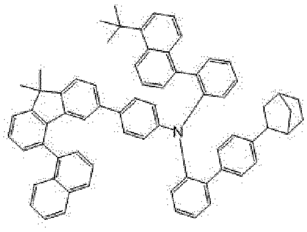
A9

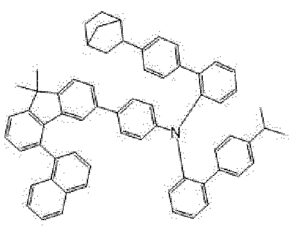
A10

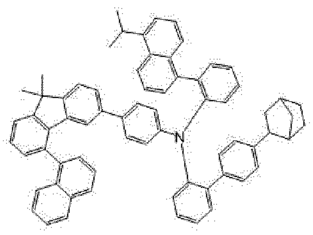
A11

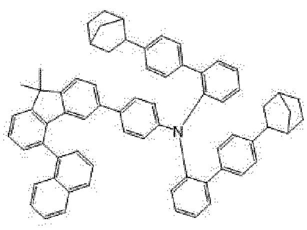
A12

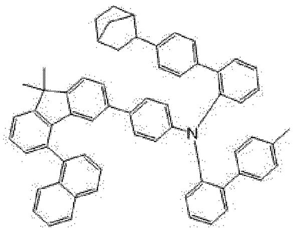

A13

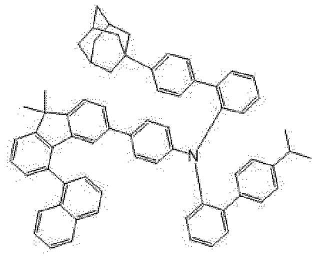

A14

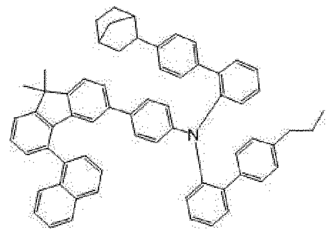

A15

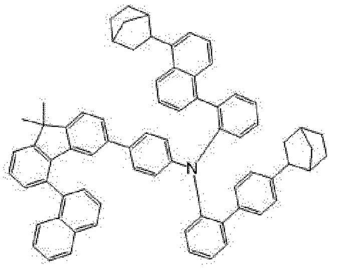

A16

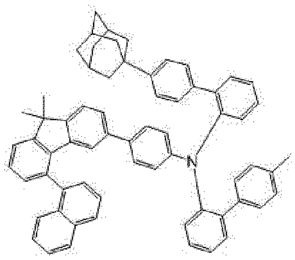

A17

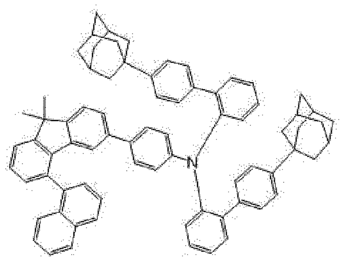

A18

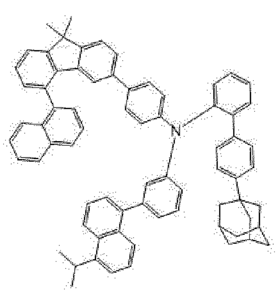

A19

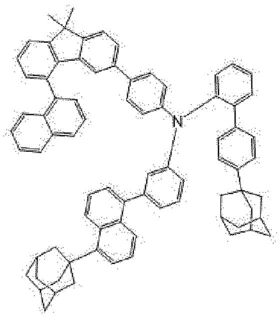

A20

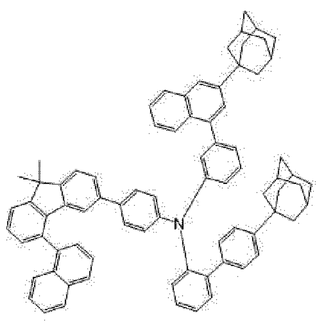

A21

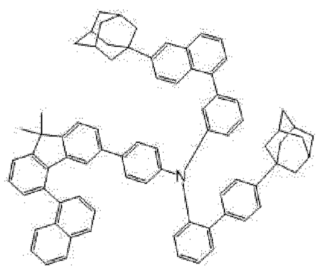

A22

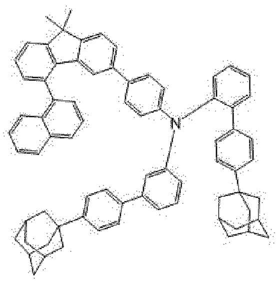

A23

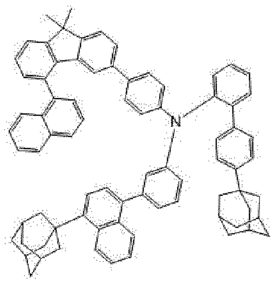

A24

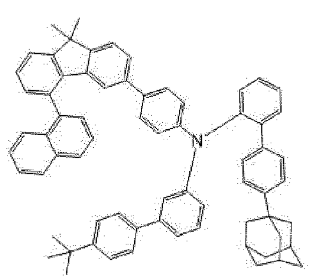
A25

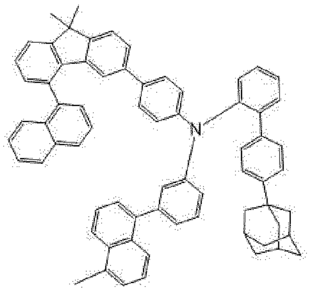
A26

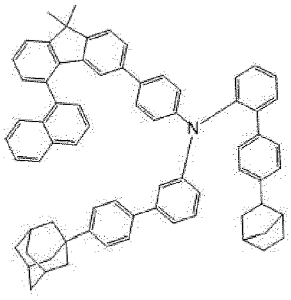
A27

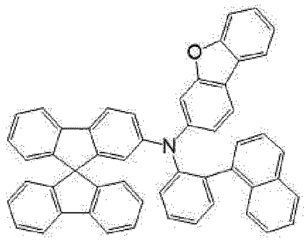
A28

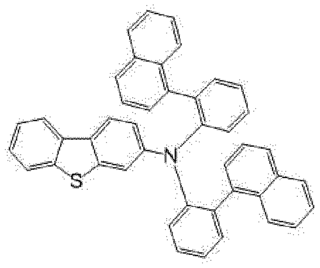
A29

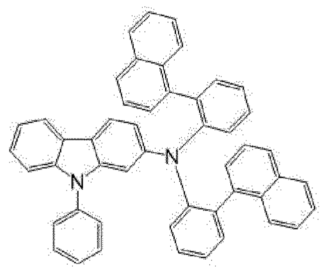
A30

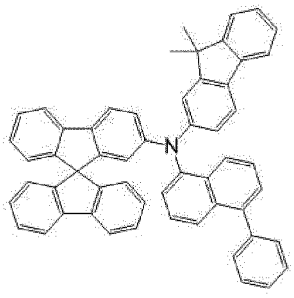
A31

In one or more embodiments, the first hole transport material may be represented by Formula 2. The first hole transport material represented by Formula 2 may have a refractive index of about 1.9 to about 2.2 in a wavelength range of about 460 nm to about 800 nm.

**Formula 2**

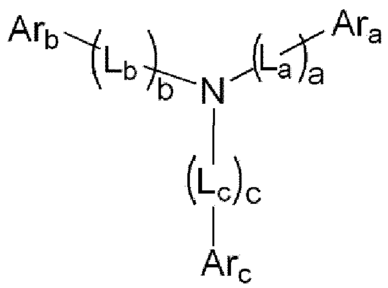

In Formula 2, $Ar_a$ to $Ar_c$ are each independently a substituted or unsubstituted aryl group having 6 to 30 ring-forming carbon atoms or a substituted or unsubstituted heteroaryl group having 2 to 30 ring-forming carbon atoms.

In Formula 2, $L_a$ to $L_c$ are each independently a direct linkage, a substituted or unsubstituted arylene group having

6 to 30 ring-forming carbon atoms, or a substituted or unsubstituted heteroarylene group having 2 to 30 ring-forming carbon atoms.

In Formula 2, a to c are each independently an integer of 0 to 3. In one or more embodiments, if (e.g., when) a to c are each an integer of 2 or greater, a plurality of $L_a$'s to $L_c$'s may each independently be a substituted or unsubstituted arylene group having 6 to 30 ring-forming carbon atoms or a substituted or unsubstituted heteroarylene group having 2 to 30 ring-forming carbon atoms.

In one or more embodiments, the first hole transport material represented by Formula 2 may be any one of compounds in Compound Group 2. The first hole transport layer HTL1 of the light emitting element ED according to one or more embodiments may include at least one selected from among the compounds in Compound Group 2 as the first hole transport material.

## Compound Group 2

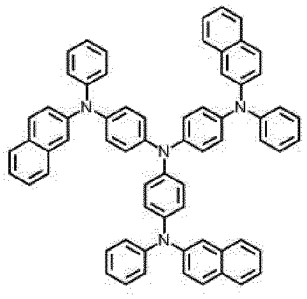
B1

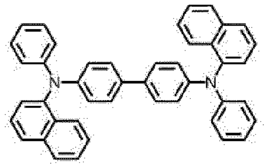
B2

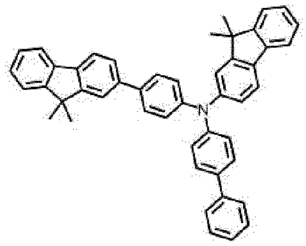
B3

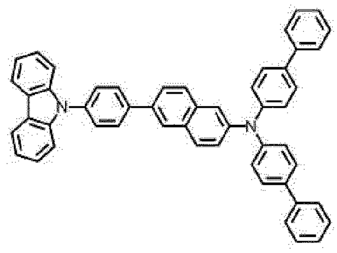
B4

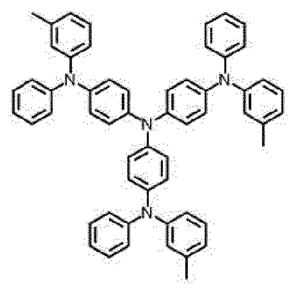
B5

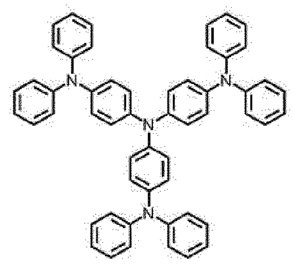
B6

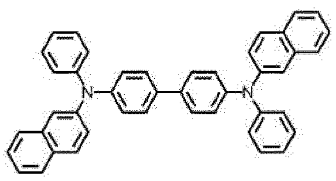
B7

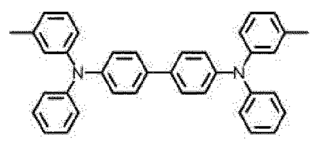
B8

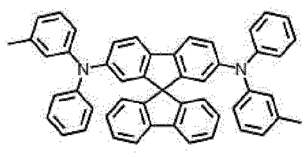
B9

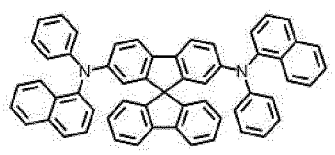
B10

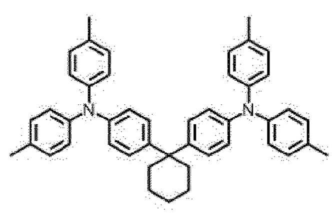
B11

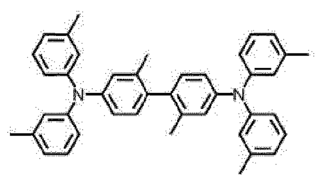
B12

In the light emitting element ED of one or more embodiments, the first hole transport layer HTL1 may include a first hole transport material, and the first hole transport material may include a plurality of different materials. In one or more embodiments, the first hole transport material included in the first hole transport layer HTL1 may include a (1-1)-th hole transport material (i.e., first-first hole transport material), and a (1-2)-th hole transport material (i.e., first-second hole transport material) different from the (1-1)-th hole transport material. The (1-1)-th hole transport material may be represented by Formula 1 described above. The (1-1)-th hole transport material may have a refractive index of about 1.7 to about 1.85 in a wavelength range of about 460 nm to about 800 nm. The (1-2)-th hole transport material may be represented by Formula 2 described above. The (1-2)-th hole transport material may have a refractive index of about 1.9 to about 2.2 in a wavelength range of about 460 nm to about 800 nm.

In the first hole transport layer HTL1, if (e.g., when) the first hole transport material includes the (1-1)-th hole

transport material and the (1-2)-th hole transport material, the (1-1)-th hole transport material may be present at a content (e.g., amount) level of about 10 wt% or greater with respect to a total weight of 100 wt% of the first hole transport material. For example, in one or more embodiments, the (1-1)-th hole transport material may be present at a content (e.g., amount) level of about 10 wt% to about 95 wt% with respect to the total weight of 100 wt% of the first hole transport material. When the content (e.g., amount) of the (1-1)-th hole transport material satisfies the ratio described above, the difference in refractive index between the first hole transport layer HTL1 and the first electrode EL1 is minimized or reduced, and the hole transport characteristics are improved, thereby enhancing luminescence efficiency and element service life.

Referring back to FIG. 5A, the first sub-hole transport layer SHTL1, the second sub-hole transport layer SHTL2, and the third sub-hole transport layer SHTL3 may each be a layer that include the same hole transport material, but are differentiated by the doping of p-dopants. The first sub-hole transport layer SHTL1 and the second sub-hole transport layer SHTL2 are each a layer which is doped with a p-dopant, and the third sub-hole transport layer SHTL3 is a layer which is not doped with a p-dopant.

The p-dopant with which each of the first sub-hole transport layer SHTL1 and the second sub-hole transport layer SHTL2 is doped may include at least one of a halogenated metal compound (e.g., a metal halide), a quinone derivative, a metal oxide, or a cyano group-containing compound. For example, in one or more embodiments, the p-dopant may include one or more selected from among halogenated metal compounds (e.g., metal halides), such as CuI and/or RbI, quinone derivatives, such as tetracyanoquinodimethane (TCNQ) and/or 2,3,5,6-tetrafluoro-7,7,8,8-tetracyanoquinodimethane (F4-TCNQ), metal oxides, such as tungsten oxide, vanadium oxide, molybdenum oxide, and/or rhenium oxide, cyano group-containing compounds, such as dipyrazino[2,3-f: 2',3'-h] quinoxaline-2,3,6,7,10,11-hexacarbonitrile (HATCN) and/or 7-dicyanomethylene-1,3,4,5,6,8,9,10-octafluoro-7H-pyren-2-ylidene)-malononitrile (NDP-9), and/or the like.

The first sub-hole transport layer SHTL1 includes the first hole transport material described above and a first p-dopant with which the first hole transport material is doped. The second sub-hole transport layer SHTL2 includes the first hole transport material and a second p-dopant with which the first hole transport material is doped. The third sub-hole transport layer SHTL3 includes the first hole transport material. The third sub-hole transport layer SHTL3 includes the first hole transport material, and does not include (e.g., may exclude) a separate p-dopant, for example, excludes any p-dopant.

In each of the first sub-hole transport layer SHTL1 and the second sub-hole transport layer SHTL2, a doping ratio of the p-dopant may be about 10 wt% or less with respect to a total content (e.g., amount) of 100 wt% of the first hole transport material respectively contained in the first sub-hole transport layer SHTL1 and the second sub-hole transport layer SHTL2. For example, the first sub-hole transport layer SHTL1 includes the first hole transport material and the first p-dopant with which the first hole transport material is doped, and the first p-dopant may be at a content (e.g., amount) level of about 10 wt% or less with respect to a total content (e.g., amount) of 100 wt% of the first sub-hole transport layer SHTL1. The second sub-hole transport layer SHTL2 includes the first hole transport material and the second p-dopant with which the first hole transport material is doped, and the second p-dopant may be at a content (e.g., amount) level of about 10 wt% or less with respect to a total content (e.g., amount) of 100 wt% of the second sub-hole transport layer SHTL2.

The first p-dopant included in the first sub-hole transport layer SHTL1 and the second p-dopant included in the second sub-hole transport layer SHTL2 may be identical to each other. For example, each of the first p-dopant and the second p-dopant may include the same material selected from among the halogenated metal compounds, quinone derivatives, metal oxides, and cyano group-containing compounds described above.

The first p-dopant and the second p-dopant may each have a lowest unoccupied molecular orbital (LUMO) energy level with an absolute value of about 4.5 eV to about 6.0 eV.

The first hole transport material may have a lower absolute value of highest occupied molecular orbital (HOMO) energy level than the first p-dopant and the second p-dopant. For example, the absolute value of HOMO energy level of the first hole transport material may be lower than that of each of the first p-dopant and the second p-dopant.

The absolute value of HOMO energy level of the first hole transport material is H1 and the absolute value of LUMO energy level of each of the first p-dopant and the second p-dopant is P1.

A case in which H1 is equal to or greater than P1 satisfies Equation 1.

**Equation 1**

$$H1 - P1 \leq 0.5\ \text{eV}$$

For example, if (e.g., when) the absolute value of HOMO energy level of the first hole transport material is greater than the absolute value of LUMO energy level of each of the first p-dopant and the second p-dopant, then the difference may be less than about 0.5 eV.

A case in which H1 is smaller than P1 satisfies Equation 2.

**Equation 2**

$$P1 - H1 < 1.0\ eV$$

For example, if (e.g., when) the absolute value of HOMO energy level of the first hole transport material is smaller than the absolute value of LUMO energy level of each of the first p-dopant and the second p-dopant, then the difference may be less than about 1.0 eV.

Referring to FIG. 5B, the first hole transport layer HTL1 of one or more embodiments may further include a fourth sub-hole transport layer SHTL4. The fourth sub-hole transport layer SHTL4 may be arranged between the second sub-hole transport layer SHTL2 and the emission layer EML. The fourth sub-hole transport layer SHTL4 may be a layer that is not doped with a p-dopant. The fourth sub-hole transport layer SHTL4 includes the first hole transport material. The fourth sub-hole transport layer SHTL4 includes the first hole transport material and may not include (e.g., may exclude) a separate p-dopant, for example, may exclude any p-dopant.

Referring to FIGS. 4, 5A, and 5B together, in one or more embodiments, the hole transport region HTR may include a second hole transport layer HTL2 arranged adjacent to the emission layer EML. The second hole transport layer HTL2 may be a layer having a relatively higher refractive index than the first hole transport layer HTL1. The second hole transport layer HTL2 may include a second hole transport material. The second hole transport material may be a material different from the first hole transport material.

The second hole transport material may be represented by Formula 2 described above. In one or more embodiments, the second hole transport material represented by Formula 2 may be one of the compounds from Compound Group 2 described above. The second hole transport layer HTL2 of the light emitting element ED according to one or more embodiments may include at least one selected from among the compounds in Compound Group 2 described above as the second hole transport material.

In the first hole transport layer HTL1, respective thicknesses d1 and d2 of the first sub-hole transport layer SHTL1 and the second sub-hole transport layer SHTL2 may each be smaller than a thickness d3 of the third sub-hole transport layer SHTL3. In one or more embodiments, the thickness d1 of the first sub-hole transport layer SHTL1 and the thickness d2 of the second sub-hole transport layer SHTL2 may each be, for example, about 30 Å to about 200 Å. The thickness d3 of the third sub-hole transport layer SHTL3 may be, for example, about 100 Å to about 1000 Å.

The second sub-hole transport layer SHTL2 may be arranged to be spaced and/or apart (e.g., spaced apart or separated) from the emission layer EML by a set or predetermined distance with respect to the third direction DR3, which is a thickness direction. A distance d4 between the second sub-hole transport layer SHTL2 and the emission layer EML may be defined as a minimum distance from an upper surface of the second sub-hole transport layer SHTL2 to a lower surface of the emission layer EML. In one or more embodiments, the distance d4 between the second sub-hole transport layer SHTL2 and the emission layer EML may be, for example, about 100 Å to about 300 Å. In one or more embodiments, if (e.g., when) the second hole transport layer HTL2 is directly arranged on the third sub-hole transport layer SHTL3 of the first hole transport layer HTL1 as shown in FIG. 5A, the distance d4 between the second sub-hole transport layer SHTL2 and the emission layer EML may correspond to a thickness of the second hole transport layer HTL2. If (e.g., when) the fourth sub-hole transport layer SHTL4 is placed between the third sub-hole transport layer SHTL3 of the first hole transport layer HTL1 and the second hole transport layer HTL2 as shown in FIG. 5B, the distance d4 between the second sub-hole transport layer SHTL2 and the emission layer EML may correspond to a combined thickness of the second hole transport layer HTL2 and the fourth sub-hole transport layer SHTL4.

The first hole transport layer HTL1 of one or more embodiments includes the first hole transport material and includes a p-dopant with which a portion of the first hole transport layer HTL1 is doped, thereby preventing or reducing degradation of the first hole transport material, and accordingly, a light emitting element including the first hole transport layer HTL1 may have enhanced element service life.

Organic materials used in top emission light emitting elements, such as the light emitting element ED of one or more embodiments, have relatively stronger hole transport characteristics than electron transport characteristics, causing an electron-hole recombination zone to be located on an interface between the emission layer EML and the hole transport region HTR. In this regard, the hole transport material included in the hole transport region HTR may be degraded by some electrons injected from the emission layer EML into the hole transport region HTR, resulting in reduced element service life. In particular, hole transport materials having low refractive indices exhibit relatively low material stability, and thus, if (e.g., when) materials having low refractive indices are included in the hole transport region HTR, the hole transport materials are significantly degraded by electrons injected from the emission layer EML, leading to a significant decrease in element service life.

In the case of the light emitting element ED of one or more embodiments, the first sub-hole transport layer SHTL1 adjacent to the first electrode EL1 in the first hole transport layer HTL1, and the second sub-hole transport layer SHTL2 adjacent to the emission layer EML are each doped with p-dopants to enhance the conductivity of the hole transport region HTR and to allow electrons of hole transport materials, which turn the hole transport materials into an anion state, due to

electrons injected from the emission layer EML to transfer to the p-dopants, resulting in reduced (e.g., few) hole transport materials in the anion state. Accordingly, the degradation of the hole transport material in the first hole transport layer HTL1 may be prevented or reduced, thereby increasing element service life of a light emitting element including the first hole transport layer HTL1.

Referring to FIGS. 6 to 8, in the light emitting element ED of one or more embodiments, the hole transport region HTR may further include a third hole transport layer HTL3. The third hole transport layer HTL3 may be arranged between the first electrode EL1 and the first hole transport layer HTL1.

The third hole transport layer HTL3 may include a third hole transport material. The third hole transport material may be the same as or different from the first hole transport material. The third hole transport material may be represented by Formula 2 described above. In one or more embodiments, the third hole transport material represented by Formula 2 may be one of the compounds from Compound Group 2 described above. The third hole transport layer HTL3 of the light emitting element ED according to one or more embodiments may include at least one selected from among the compounds in Compound Group 2 described above as the third hole transport material.

In the light emitting element ED of one or more embodiments, the hole transport region HTR may include at least one of a hole injection layer, a buffer layer or an auxiliary emission layer, or an electron blocking layer EBL, in addition to the first to third hole transport layers HTL1, HTL2, and HTL3, as shown in FIGS. 6 to 8, but embodiments of the present disclosure are not limited thereto.

The hole transport region HTR may be formed using one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the hole transport region HTR may have a structure formed of first hole transport layer HTL1/second hole transport layer HTL2 sequentially stacked from the first electrode EL1, e.g., in the stated order. In one or more embodiments, the hole transport region HTR may have a structure formed of third hole transport layer HTL3/first hole transport layer HTL1/second hole transport layer HTL2 sequentially stacked from the first electrode EL1, e.g., in the stated order, or a structure formed of third hole transport layer HTL3/first hole transport layer HTL1/second hole transport layer HTL2/electron blocking layer EBL sequentially stacked from the first electrode EL1, e.g., in the stated order, but embodiments of the present disclosure are not limited thereto. The hole transport region HTR may have, for example, a thickness of about 1000 Å to about 15000 Å.

In addition, the light emitting element ED of one or more embodiments may further include one or more materials of the hole transport region described below, in addition to the first hole transport material to the third hole transport material of one or more embodiments described above in the hole transport region HTR.

In one or more embodiments, the hole transport region HTR may include one or more selected from among a phthalocyanine compound such as copper phthalocyanine, $N^1,N^{1'}$-([1,1'-biphenyl]-4,4'-diyl)bis($N^1$-phenyl-$N^4,N^4$-di-m-tolylbenzene-1,4-diamine) (DNTPD), 4,4',4"-[tris(3-methylphenyl)phenylamino] triphenylamine (m-MTDATA), 4,4'4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalen-l-yl)-N,N'-diphenyl-benzidine (NPB), triphenylamine-containing polyetherketone (TPAPEK), 4-isopropyl-4'-methyldiphenyliodonium tetrakis(pentafluorophenyl)borate, dipyrazino[2,3-f: 2',3'-h]quinoxaline-2,3,6,7,10,11-hexacarbonitrile (HATCN), and/or the like.

In one or more embodiments, the hole transport region HTR may include one or more selected from among carbazole-based derivatives such as N-phenyl carbazole and polyvinyl carbazole, fluorene-based derivatives, N,N'-bis(3-methylphenyl)-N,N'-diphenyl-[1,1-biphenyl]-4,4'-diamine (TPD), triphenylamine-based derivatives such as 4,4',4"-tris(N-carbazolyl)triphenylamine (TCTA), N,N'-di(1-naphthalen-1-yl)-N,N'-diphenyl-benzidine (NPB), 4,4'-cyclohexylidene bis [N,N-bis(4-methylphenyl]benzenamine] (TAPC), 4,4'-bis[N,N'-(3-tolyl)amino]-3,3'-dimethylbiphenyl (HMTPD), and 1,3-bis(N-carbazolyl)benzene (mCP), and/or the like.

In one or more embodiments, the hole transport region HTR may include one or more selected from among 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol- 9-yl)benzene (mDCP), and/or the like.

The hole transport region HTR may include one or more of the compounds of the hole transport region described above in at least one of the hole injection layer, the first to third hole transport layer HTL1, HTL2, and HTL3, or the electron blocking layer.

The hole transport region HTR may have a thickness of about 1000 Å to about 10000 Å, for example, about 1000 Å to about 5000 Å. If (e.g., when) the hole transport region HTR includes a hole injection layer, the hole injection layer may have a thickness of, for example, about 30 Å to about 1000 Å. If (e.g., when) the hole transport region HTR includes an electron blocking layer EBL, the electron blocking layer EBL may have a thickness of, for example, about 10 Å to about 1000 Å.

As described above, the hole transport region HTR may further include at least one of a hole injection layer, a

buffer layer, or an electron blocking layer EBL, in addition to the first to third hole transport layer HTL1, HTL2, and HTL3. The buffer layer may compensate a resonance distance according to wavelengths of light emitted from the emission layer EML, and may thus increase light emitting efficiency. Materials which may be included in the hole transport region HTR may be used as materials included in the buffer layer. The electron blocking layer EBL is a layer that serves to prevent or reduce electrons from being injected from the electron transport region ETR to the hole transport region HTR.

The emission layer EML may be provided on the hole transport region HTR. The emission layer EML may have a thickness of, for example, about 100 Å to about 1000 Å, or about 100 Å to about 300 Å. The emission layer EML may have a single layer formed of a single material, a single layer formed of a plurality of different materials, or a multi-layered structure having a plurality of layers formed of a plurality of different materials.

In one or more embodiments of the light emitting element ED, the emission layer EML may be to emit blue light. The light emitting element ED of one or more embodiments may exhibit long-life characteristics in a blue light-emitting region, such that the hole transport region HTR includes the structure and materials described above. However, embodiments of the present disclosure are not limited thereto, for example, in one or more embodiments, the emission layer EML may be to emit green light or red light.

In the light emitting element ED of one or more embodiments, the emission layer EML may include at least one of an anthracene derivative, a pyrene derivative, a fluoranthene derivative, a chrysene derivative, a dihydrobenzanthracene derivative, or a triphenylene derivative, as an emissive material. For example, in one or more embodiments, the emission layer EML may include an anthracene derivative or a pyrene derivative.

In each light emitting element ED of embodiments illustrated in FIGS. 3, 4, 5A, 5B, and 6 to 8, the emission layer EML may further include a suitable host and dopant besides the above-described emissive material. For example, in one or more embodiments, the emission layer EML may include a compound represented by Formula E-1. The compound represented by Formula E-1 may be used as a fluorescent host material.

## Formula E-1

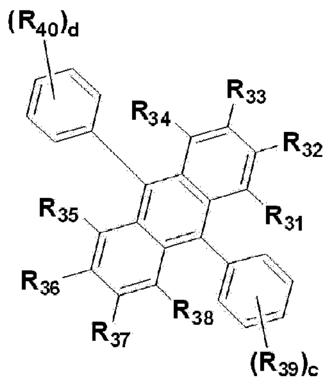

In Formula E-1, $R_{31}$ to $R_{40}$ may each independently be hydrogen, deuterium, a halogen, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In one or more embodiments, one or more selected from among $R_{31}$ to $R_{40}$ may be each independently bonded to an adjacent group to form a saturated hydrocarbon ring, an unsaturated hydrocarbon ring, a saturated heterocycle, or an unsaturated heterocycle.

In Formula E-1, c and d may each independently be an integer of 0 to 5.

The compound represented by Formula E-1 may be any one selected from among Compound E1 to Compound E19:

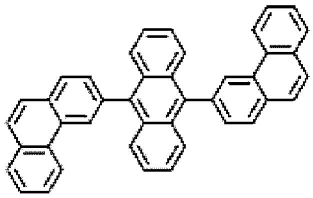

E1

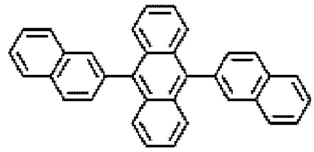

E2

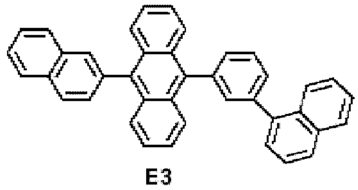

E3

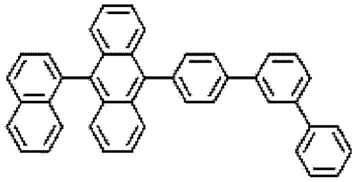

E4

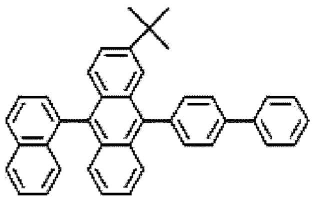

E5

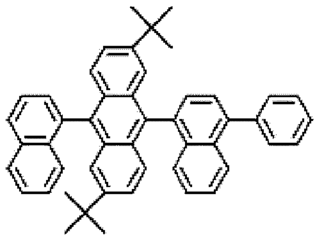

E6

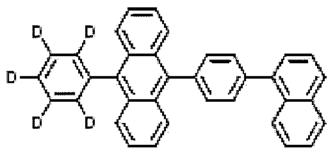

E7

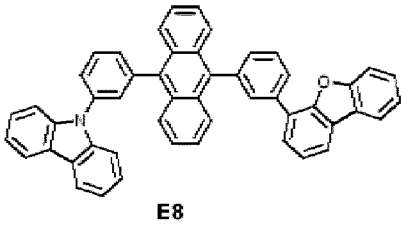

E8

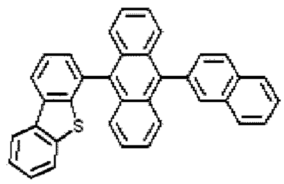

E9

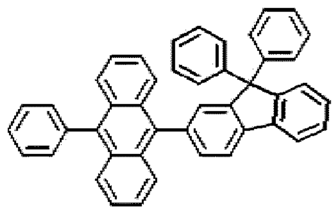

E10

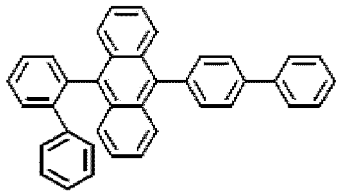

E11

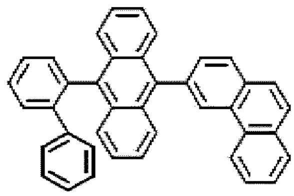

E12

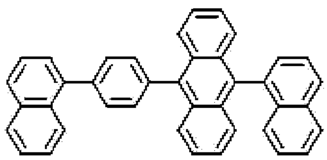

E13

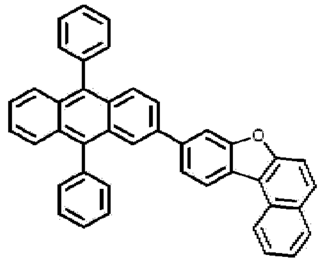

E14

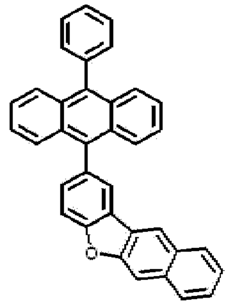

E15

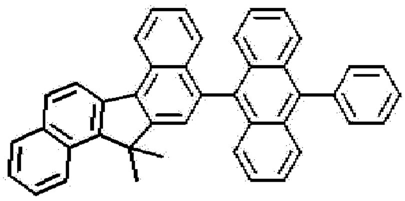

E16

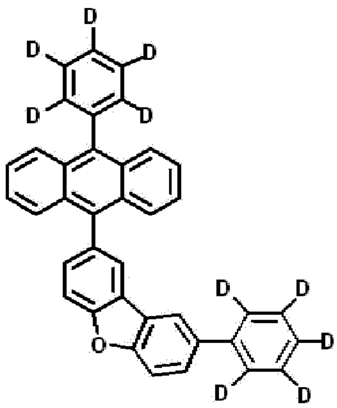

E17

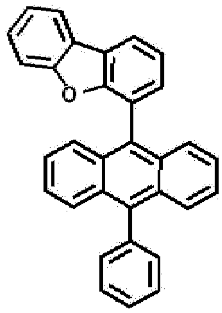

E18

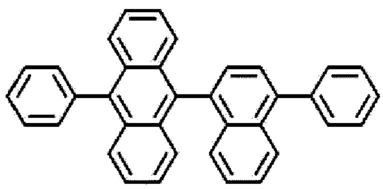

E19

In one or more embodiments, the emission layer EML may include a compound represented by Formula E-2a or Formula E-2b. The compound represented by Formula E-2a or Formula E-2b may be used as a phosphorescent host material.

## Formula E-2a

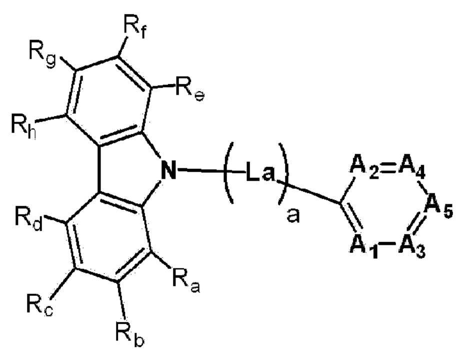

In Formula E-2a, a may be an integer of 0 to 10, and $L_a$ may be a direct linkage, a substituted or unsubstituted

arylene group having 6 to 30 ring-forming carbon atoms, or a substituted or unsubstituted heteroarylene group having 2 to 30 ring-forming carbon atoms. In one or more embodiments, if (e.g., when) a is an integer of 2 or greater, a plurality of $L_a$'s may each independently be a substituted or unsubstituted arylene group having 6 to 30 ring-forming carbon atoms or a substituted or unsubstituted heteroarylene group having 2 to 30 ring-forming carbon atoms.

In addition, in Formula E-2a, $A_1$ to $A_5$ may each independently be N or $CR_i$. $R_a$ to $R_i$ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form a ring. In one or more embodiments, one or more selected from among $R_a$ to $R_i$ may be each independently bonded to an adjacent group to form a hydrocarbon ring or a heterocycle containing N, O, S, and/or the like, as a ring-forming atom.

In one or more embodiments, in Formula E-2a, two or three selected from among $A_1$ to $A_5$ may be N, and the rest may be $CR_i$.

## Formula E-2b

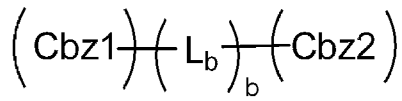

In Formula E-2b, Cbz1 and Cbz2 may each independently be an unsubstituted carbazole group or a carbazole group substituted with an aryl group having 6 to 30 ring-forming carbon atoms. $L_b$ may be a direct linkage, a substituted or unsubstituted arylene group having 6 to 30 ring-forming carbon atoms, or a substituted or unsubstituted heteroarylene group having 2 to 30 ring-forming carbon atoms. Meanwhile, b is an integer of 0 to 10, and if (e.g., when) b is an integer of 2 or more, a plurality of $L_b$'s may each independently be a substituted or unsubstituted arylene group having 6 to 30 ring-forming carbon atoms or a substituted or unsubstituted heteroarylene group having 2 to 30 ring-forming carbon atoms.

The compound represented by Formula E-2a or Formula E-2b may be any one selected from among compounds of Compound Group E-2. However, the compounds listed in Compound Group E-2 are mere examples, and the compound represented by Formula E-2a or Formula E-2b is not limited to those represented in Compound Group E-2.

## Compound Group E-2

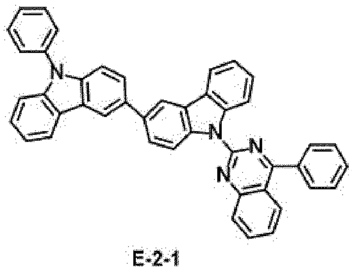
E-2-1

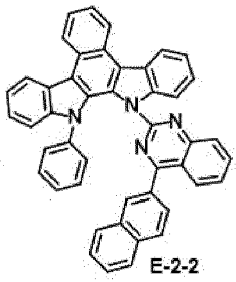
E-2-2

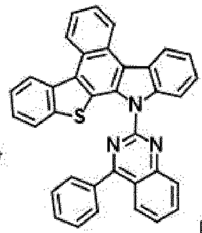
E-2-3

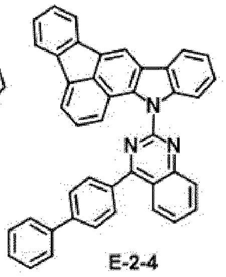
E-2-4

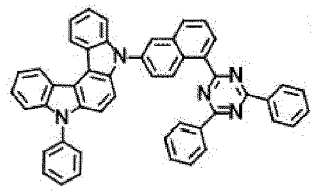
E-2-5

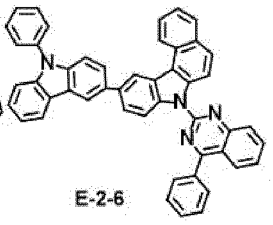
E-2-6

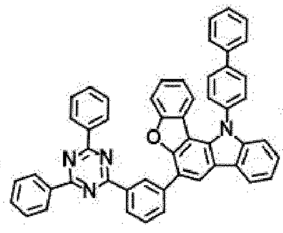
E-2-7

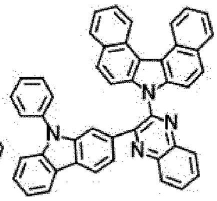
E-2-8

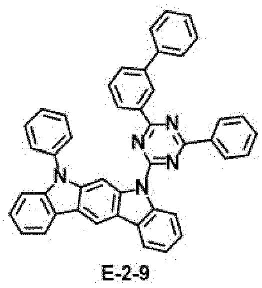
E-2-9

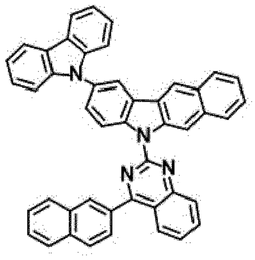
E-2-10

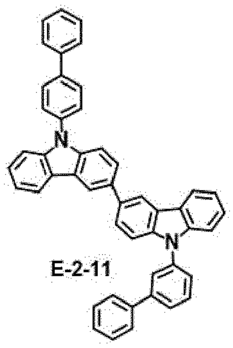
E-2-11

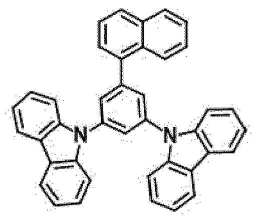
E-2-12

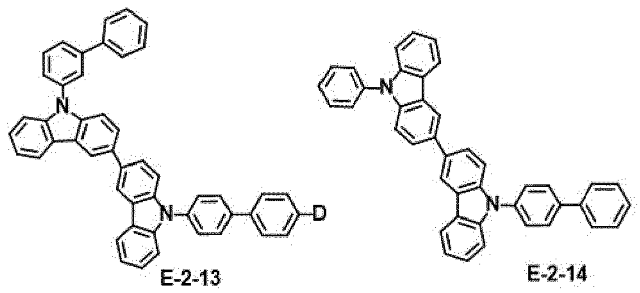
E-2-13

E-2-14

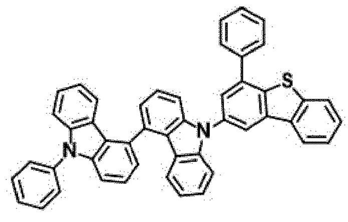
E-2-15

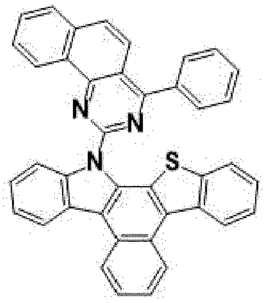

E-2-16

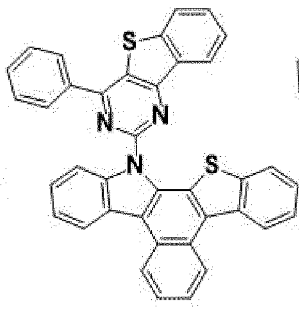

E-2-17

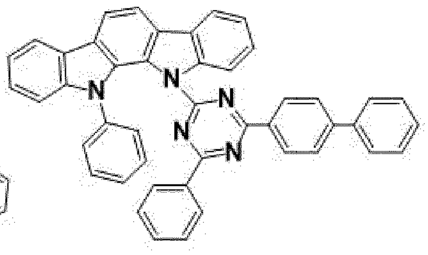

E-2-18

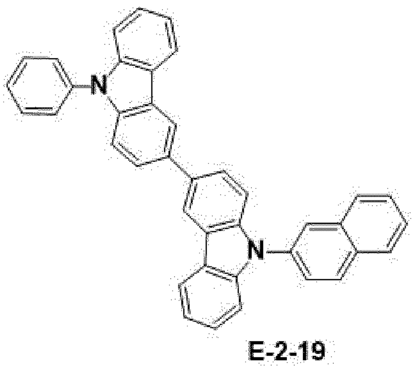

E-2-19

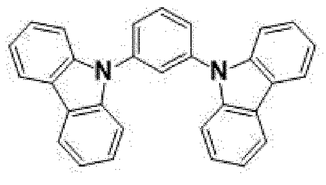

E-2-20

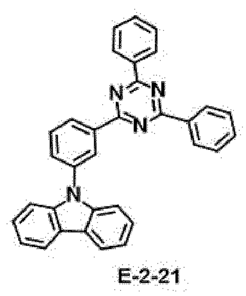

E-2-21

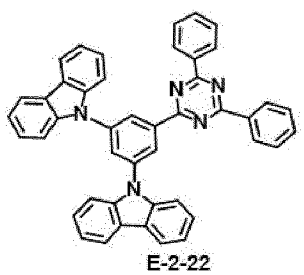

E-2-22

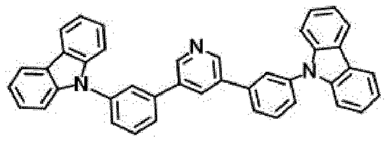

E-2-23

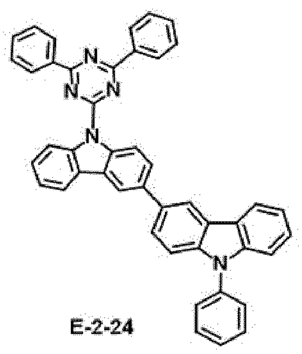

E-2-24

In one or more embodiments, the emission layer EML may further include a general material suitable in the art as a host material. For example, the emission layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4''-tris(carbazol-9-yl)-triphenylamine (TCTA), or 1,3,5-tris(1-phenyl-1H-benzo[d]imidazol-2-yl)benzene (TPBi). However, embodiments of the

present disclosure are not limited thereto, for example, tris(8-hydroxyquinolinato)aluminium ($Alq_3$), 9,10-di(naphthalen-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane ($DPSiO_3$), octaphenylcyclotetrasiloxane ($DPSiO_4$), and/or the like, may be used as a host material.

In one or more embodiments, the emission layer EML may include a compound represented by Formula M-a. The compound represented by Formula M-a may be used as a phosphorescent dopant material.

## Formula M-a

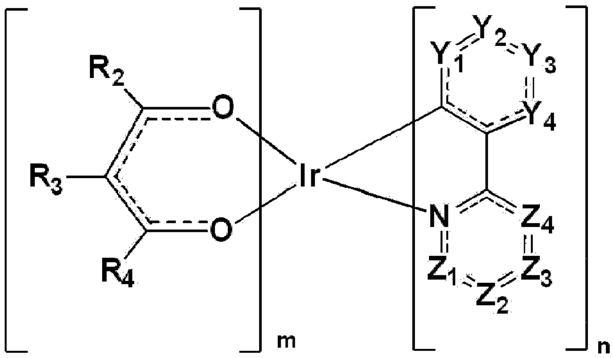

In Formula M-a, $Y_1$ to $Y_4$ and $Z_1$ to $Z_4$ may each independently be $CR_1$ or N, $R_1$ to $R_4$ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be independently bonded to an adjacent group to form a ring. In Formula M-a, m is 0 or 1, and n is 2 or 3. In Formula M-a, if (e.g., when) m is 0, n is 3, and if (e.g., when) m is 1, n is 2.

The compound represented by Formula M-a may be used as a phosphorescent dopant.

The compound represented by Formula M-a may be any one selected from among Compound M-a1 to Compound M-a25. However, Compounds M-a1 to M-a25 are mere examples, and the compound represented by Formula M-a is not limited to those represented by Compounds M-a1 to M-a25.

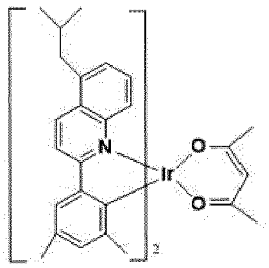

M-a1

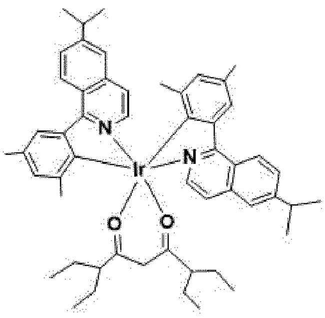

M-a2

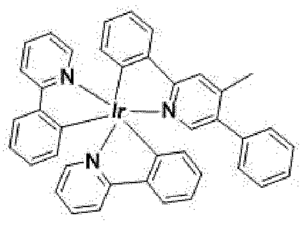

M-a3

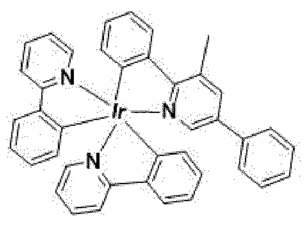

M-a4

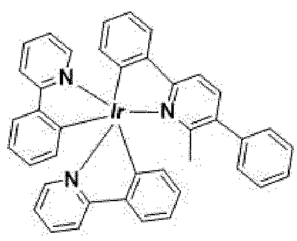

M-a5

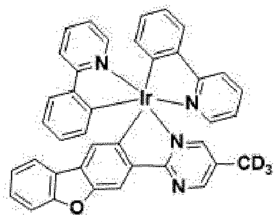

M-a6

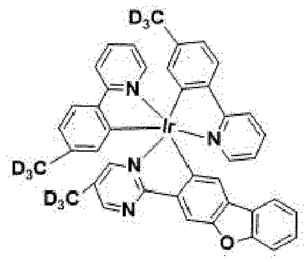

M-a7

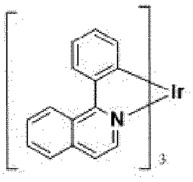

M-a8

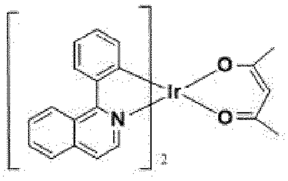

M-a9

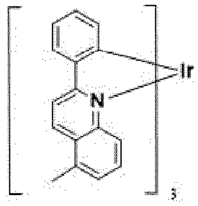

M-a10

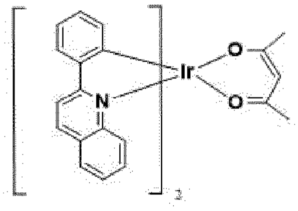

M-a11

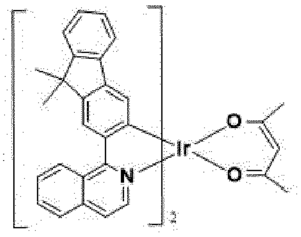

M-a12

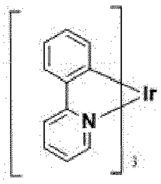

M-a13

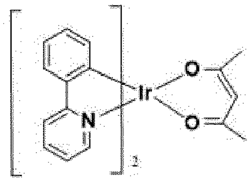

M-a14

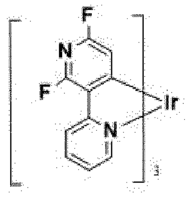

M-a15

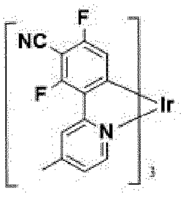

M-a16

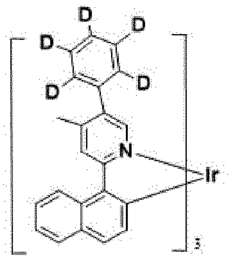

M-a17

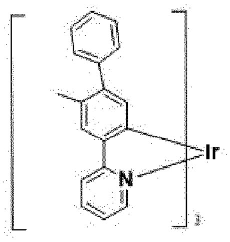

M-a18

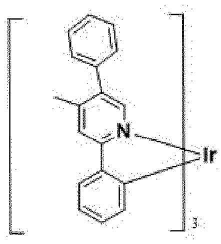

M-a19

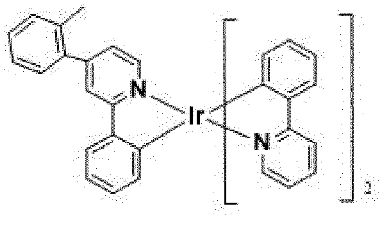

M-a20

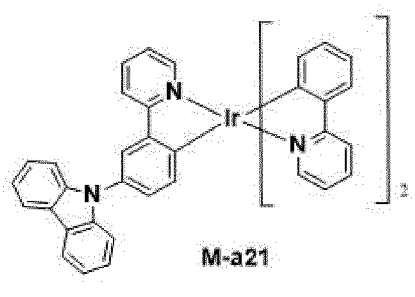

M-a21

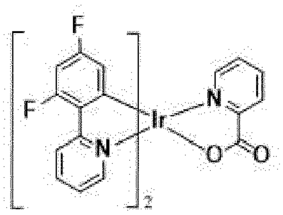

M-a22

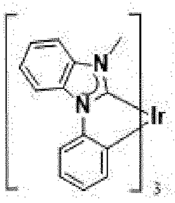

M-a23

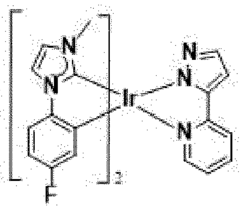

M-a24

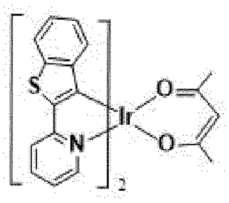

M-a25

In one or more embodiments, the emission layer EML may include a compound represented by any one selected from among Formula F-a to Formula F-c. The compounds represented by Formula F-a to Formula F-c may be used as a fluorescence dopant material.

## Formula F-a

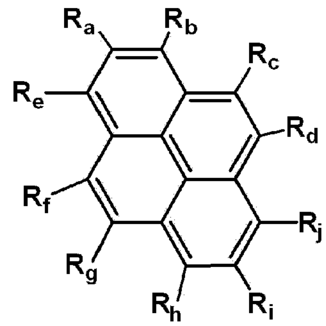

In Formula F-a, two selected from among $R_a$ to $R_j$ may each independently be substituted with *-$NAr_1Ar_2$. The others, which are not substituted with *-$NAr_1Ar_2$, among $R_a$ to $R_j$ may each independently be hydrogen, deuterium, a halogen, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-$NAr_1Ar_2$, $Ar_1$ and $Ar_2$ may each independently be a substituted or unsubstituted aryl group having 6 to 30 ring-forming carbon atoms or a substituted or unsubstituted heteroaryl group having 2 to 30 ring-forming carbon atoms. For example, in one or more embodiments, at least one of $Ar_1$ or $Ar_2$ may be a heteroaryl group containing O or S as a ring-forming atom.

## Formula F-b

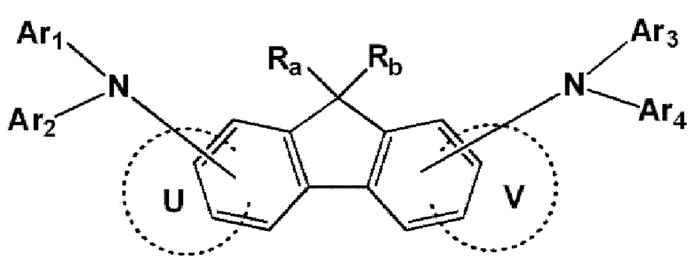

In Formula F-b, $R_a$ and $R_b$ may each independently be hydrogen, deuterium, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be independently bonded to an adjacent group to form a ring. $Ar_1$ to $Ar_4$ may each independently be a substituted or unsubstituted aryl group having 6 to 30 ring-forming carbon atoms or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms or a substituted or unsubstituted heterocycle having 2 to 30 ring-forming carbon atoms. At least one selected from among $Ar_1$ to $Ar_4$ may be a heteroaryl group containing O or S as a ring-forming atom.

In Formula F-b, the number of rings represented by U and V may each independently be 0 or 1. For example, in Formula F-b, it refers to that if (e.g., when) the number of U or V is 1, one ring constitutes a part of a fused ring at a portion indicated by U or V, and if (e.g., when) the number of U or V is 0, a ring indicated by U or V does not exist. For example, if (e.g., when) the number of U is 0 and the number of V is 1, or if (e.g., when) the number of U is 1 and the number of V is 0, the fused ring having a fluorene core in Formula F-b may be a cyclic compound having four rings. In one or more embodiments, if (e.g., when) each number of U and V is 0, the fused ring in Formula F-b may be a cyclic compound having three rings. In one or more embodiments, if (e.g., when) each number of U and V is 1, the fused ring having a fluorene core in Formula F-b may be a cyclic compound having five rings.

**Formula F-c**

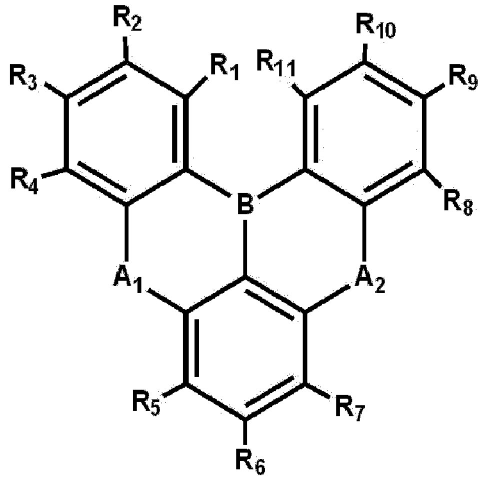

In Formula F-c, $A_1$ and $A_2$ may each independently be O, S, Se, or $NR_m$, and $R_m$ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. $R_1$ to $R_{11}$ may each independently be hydrogen, deuterium, a halogen, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be independently bonded to an adjacent group to form a ring.

In Formula F-c, $A_1$ and $A_2$ may each independently be bonded to substituents of an adjacent ring to form a fused ring. For example, if (e.g., when) $A_1$ and $A_2$ may each independently be $NR_m$, $A_1$ may be bonded to $R_4$ or $R_5$ to form a ring. In addition, $A_2$ may be bonded to $R_7$ or $R_8$ to form a ring.

In one or more embodiments, the emission layer EML may further include, as a suitable dopant material, one or more selected from among a styryl derivative (e.g., 1,4-bis[2-(3-N-ethylcarbazolyl)vinyl]benzene (BCzVB), 4-(di-p-tolylamino)-4'-[(dip-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi)), perylene and a derivative thereof (e.g., 2,5,8,11-tetra-t-butylperylene (TBP)), pyrene and a derivative thereof (e.g., 1,1-dipyrene, 1,4-dipyrenylbenzene, 1,4-bis(N,N-diphenylamino)pyrene), and/or the like.

In one or more embodiments, the emission layer EML may further include a suitable phosphorescence dopant material. For example, a metal complex containing iridium (Ir), platinum (Pt), osmium (Os), gold (Au), titanium (Ti), zirconium (Zr), hafnium (Hf), europium (Eu), terbium (Tb), or thulium (Tm) may be used as a phosphorescent dopant. For example, in one or more embodiments, iridium(III) bis(4,6-difluorophenylpyridinato-N,C2) (FIrpic), bis(2,4-difluorophenylpyridinato)-tetrakis(1-pyrazolyl)borate iridium(III) (Fir6), or platinum octaethyl porphyrin (PtOEP) may be used as a phosphorescent dopant. However, embodiments of the present disclosure are not limited thereto.

In one or more embodiments, the emission layer EML may include a quantum dot material. The quantum dot may include a core. The core of the quantum dot may be selected from among a Group II-VI compound, a Group III-VI compound, a Group I-III-IV compound, a Group III-V compound, a Group III-II-V compound, a Group IV-VI compound, a Group IV element, a Group IV compound, and/or a (e.g., any suitable) combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a (e.g., any suitable) mixture thereof, a ternary compound selected from the group consisting of CdSeS, CdSeTe, CdSTe, ZnSeS, ZnSeTe,

ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a (e.g., any suitable) mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a (e.g., any suitable) mixture thereof.

The Group III-VI compound may include a binary compound such as $In_2S_3$ and/or $In_2Se_3$, a ternary compound such as $InGaS_3$ and/or $InGaSe_3$, or any combination thereof.

The Group I-III-VI compound may be selected from among a ternary compound selected from the group consisting of AgInS, $AgInS_2$, CuInS, $CuInS_2$, $AgGaS_2$, $CuGaS_2$ $CuGaO_2$, $AgGaO_2$, $AgAlO_2$, and a (e.g., any suitable) mixture thereof, and/or a quaternary compound such as $AgInGaS_2$ and/or $CuInGaS_2$.

The Group III-V compound may be selected from the group consisting of a binary compound selected from the group consisting of GaN, GaP, GaAs, GaSb, AlN, AlP, AlAs, AlSb, InN, InP, InAs, InSb, and a (e.g., any suitable) mixture thereof, a ternary compound selected from the group consisting of GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and a (e.g., any suitable) mixture thereof, and a quaternary compound selected from the group consisting of GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a (e.g., any suitable) mixture thereof. In one or more embodiments, the Group III-V compound may further include a Group II metal. For example, InZnP, and/or the like, may be selected as a Group III-II-V compound.

The Group IV-VI compound may be selected from the group consisting of a binary compound selected from the group consisting of SnS, SnSe, SnTe, PbS, PbSe, PbTe, and a (e.g., any suitable) mixture thereof, a ternary compound selected from the group consisting of SnSeS, SnSeTe, SnSTe, PbSeS, PbSeTe, PbSTe, SnPbS, SnPbSe, SnPbTe, and a (e.g., any suitable) mixture thereof, and a quaternary compound selected from the group consisting of SnPbSSe, SnPbSeTe, SnPbSTe, and a (e.g., any suitable) mixture thereof. The Group IV element may be selected from the group consisting of Si, Ge, and a (e.g., any suitable) mixture thereof. The Group IV compound may be a binary compound selected from the group consisting of SiC, SiGe, and a (e.g., any suitable) mixture thereof.

Each element included in a polynary compound such as the binary compound, the ternary compound, or the quaternary compound may be present in a particle with a substantially uniform or non-uniform concentration distribution. For example, the formulae refer to the types (kinds) of elements included in the compounds, and elemental ratios in the compound may be different. For example, $AgInGaS_2$ may refer to $AgIn_xGa_{1-x}S_2$ (where x is a real number of 0 to 1).

In one or more embodiments, the quantum dot may have a single structure or a double structure of core-shell in which the concentration of each element included in the quantum dot is substantially uniform. For example, a material included in the core may be different from a material included in the shell.

The shell of the quantum dot may serve as a protection layer to prevent or reduce the chemical deformation of the core to maintain semiconductor properties, and/or a charging layer to impart electrophoresis properties to the quantum dot. The shell may be a single layer or multiple layers. In one or more embodiments, an interface between the core and the shell may have a concentration gradient in which the concentration of an element present in the shell becomes lower towards the center.

In one or more embodiments, the quantum dot may have the above-described core/shell structure including a core containing nanocrystals and a shell around (e.g., surrounding) the core. An example of the shell of the quantum dots may include a metal or non-metal oxide, a semiconductor compound, or a (e.g., any suitable) combination thereof.

For example, the metal or non-metal oxide suitable as a shell may be a binary compound such as $SiO_2$, $Al_2O_3$, $TiO_2$, ZnO, MnO, $Mn_2O_3$, $Mn_3O_4$, CuO, FeO, $Fe_2O_3$, $Fe_3O_4$, CoO, $Co_3O_4$, or NiO, or a ternary compound such as $MgAl_2O_4$, $CoFe_2O_4$, $NiFe_2O_4$, or $CoMn_2O_4$, but embodiments of the present disclosure are not limited thereto.

Also, examples of the semiconductor compound suitable as a shell may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like, but embodiments of the present disclosure are not limited thereto.

Each element included in a polynary compound such as the binary compound or the ternary compound may be present in a particle with a substantially uniform or non-uniform concentration distribution. For example, the formulae refer to the types (kinds) of elements included in the compounds, and elemental ratios in the compound may be different.

The quantum dot may have a full width at half maximum (FWHM) of emission spectrum of about 45 nm or less, about 40 nm or less, or about 30 nm or less, and color purity or color reproducibility may be improved in the above range. In addition, light emitted through such quantum dots is emitted in all directions, and thus a wide viewing angle may be improved.

In addition, although the form of the quantum dot is not particularly limited as long as it is a form commonly used in the art, for example, the quantum dot in the form of spherical nanoparticles, pyramidal nanoparticles, multi-arm nanoparticles, cubic nanoparticles, nanotubes, nanowires, nanofibers, nanoplate particles, and/or the like, may be used.

As the size of the quantum dot is adjusted or the elemental ratio in the quantum dot compound is adjusted, it may control the energy band gap of the quantum dot, and thus light in one or more suitable wavelength ranges may be obtained in a quantum dot emission layer. Therefore, when the quantum dot above (using different sizes of quantum dots or different

elemental ratios in the quantum dot compound) is used, the light emitting device, which emits light in one or more suitable wavelengths, may be implemented. For example, the adjustment of the size of the quantum dot or the elemental ratio in the quantum dot compound may be selected to enable the quantum dots to emit red, green, and/or blue light. In one or more embodiments, the quantum dots may be configured to emit white light by combining one or more suitable colors of light.

In each of the light emitting elements ED of embodiments illustrated in FIGS. 3, 4, 5A, 5B, and 6 to 8, the electron transport region ETR is provided on the emission layer EML. The electron transport region ETR may include at least one of a hole blocking layer HBL, an electron transport layer ETL, or an electron injection layer EIL, but embodiments of the present disclosure are not limited thereto.

The electron transport region ETR may have a single layer formed of a single material, a single layer formed of a plurality of different materials, or a multilayer structure including a plurality of layers formed of a plurality of different materials.

For example, in one or more embodiments, the electron transport region ETR may have a single layer structure of an electron injection layer EIL or an electron transport layer ETL, and may have a single layer structure formed of an electron injection material and/or an electron transport material. In one or more embodiments, the electron transport region ETR may have a single layer structure formed of a plurality of different materials, or may have a structure in which an electron transport layer ETL/electron injection layer EIL, or a hole blocking layer HBL/electron transport layer ETL/electron injection layer EIL, are stacked in order (e.g., in the stated order) from the emission layer EML, but embodiments of the present disclosure are not limited thereto. The electron transport region ETR may have a thickness, for example, from about 1,000 Å to about 1,500 Å.

The electron transport region ETR may be formed using one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the electron transport region ETR may include a compound represented by Formula ET-2:

**Formula ET-2**

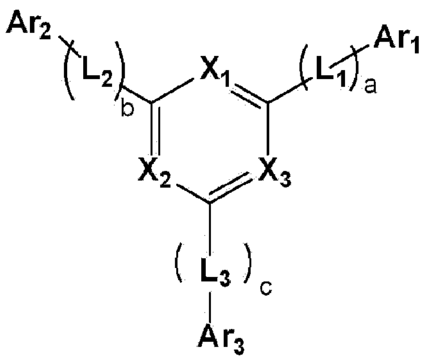

In Formula ET-2, at least one selected from among $X_1$ to $X_3$ may be N, and the rest are $CR_a$. $R_a$ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. $Ar_1$ to $Ar_3$ may each independently be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 to 10. In Formula ET-2, $L_1$ to $L_3$ may each independently be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if (e.g., when) a to c are each independently an integer of 2 or greater, $L_1$'s to $L_3$'s may each independently be a substituted or unsubstituted arylene group having 6 to 30 ring-forming carbon atoms or a substituted or unsubstituted heteroarylene group having 2 to 30 ring-forming carbon atoms.

In one or more embodiments, the electron transport region ETR may include an anthracene-based compound. However, embodiments of the present disclosure are not limited thereto, and the electron transport region ETR may include, for example, tris(8-hydroxyquinolinato)aluminium ($Alq_3$), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(biphenyl-4-yl)-4-phenyl-5-tert-butylphenyl-1,2,4-triazole (TAZ),

4-(naphthalen-1-yl)-3,5-diphenyl-4H-1,2,4-triazole (NTAZ), 2-(biphenyl-4-yl)-5-(4-tert-butylphenyl)-1,3,4-oxadiazole (tBu-PBD), bis(2-methyl-8-quinolinolato-N1,O8)-(1,1'-biphenyl-4-olato)aluminium (BAlq), beryllium bis(benzoquinolin-10-olate) ($Bebq_2$), 9,10-di(naphthalen-2-yl)anthracene (ADN), 1,3-bis[3,5-di(pyridin-3-yl)phenyl]benzene (BmPyPhB), and/or a (e.g., any suitable) mixture thereof.

In one or more embodiments, the electron transport region ETR may include at least one among (e.g., at least one selected from among) Compound ET1 to Compound ET36:

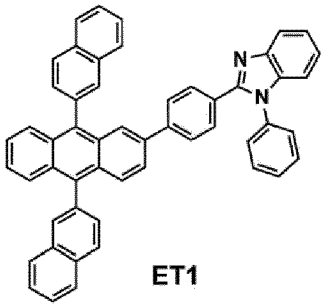
ET1

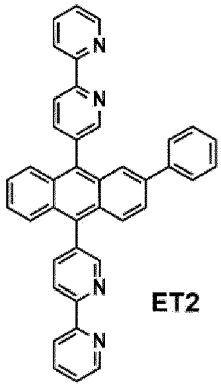
ET2

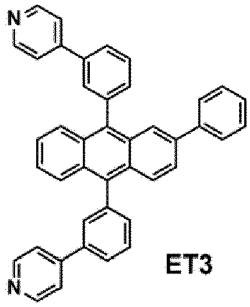
ET3

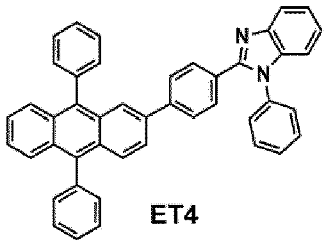
ET4

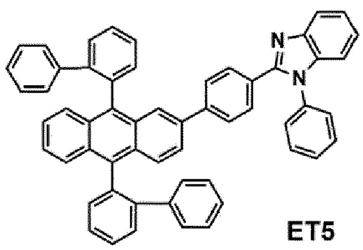
ET5

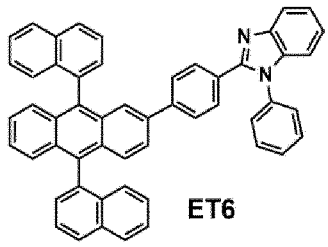
ET6

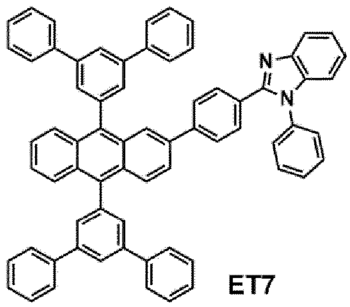
ET7

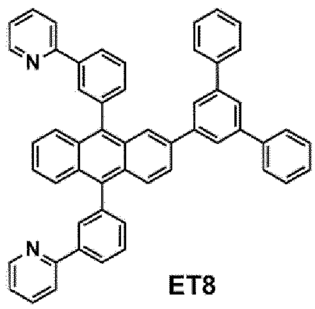
ET8

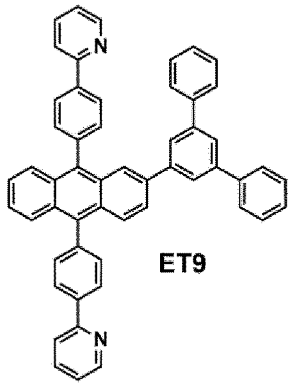
ET9

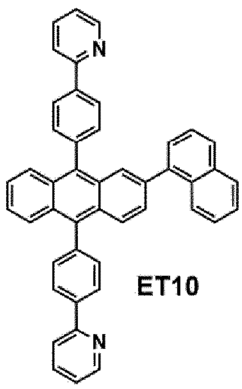
ET10

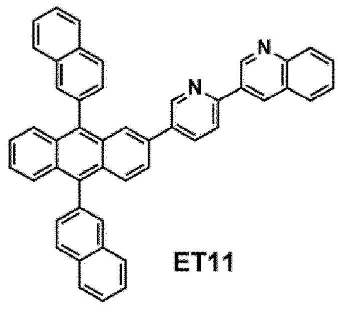
ET11

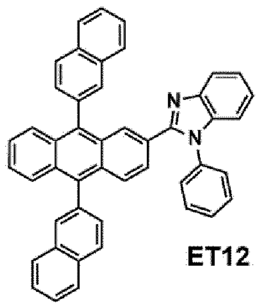
ET12

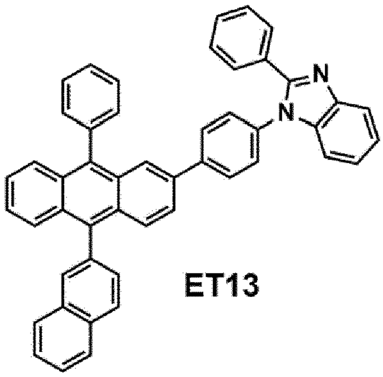
ET13

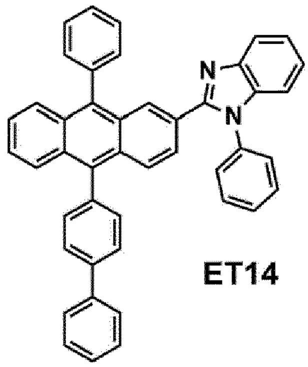
ET14

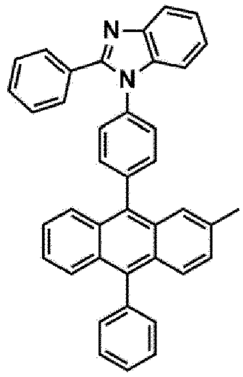
ET15

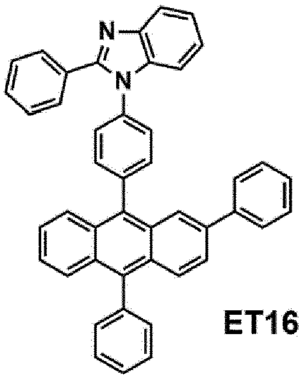
ET16

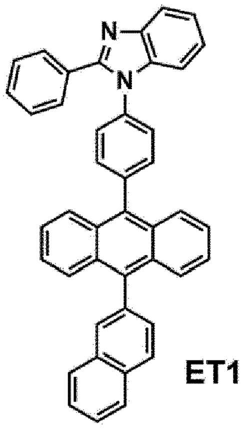
ET17

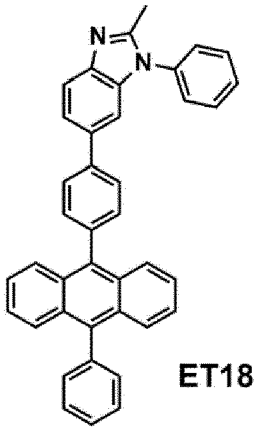
ET18

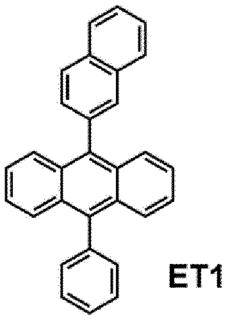
ET19

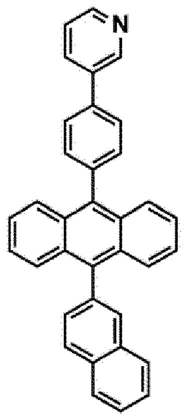
ET20

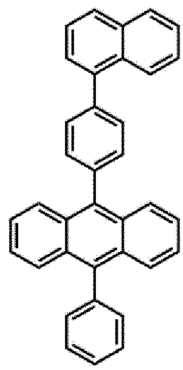
ET21

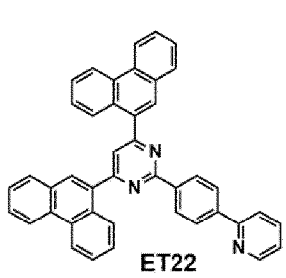
ET22

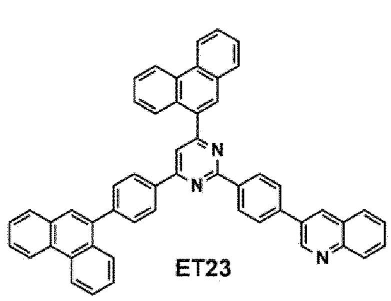
ET23

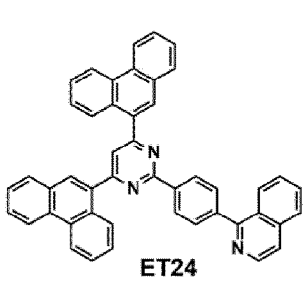
ET24

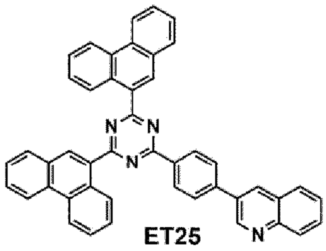
ET25

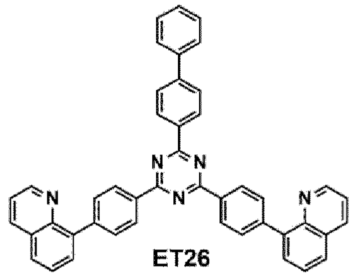
ET26

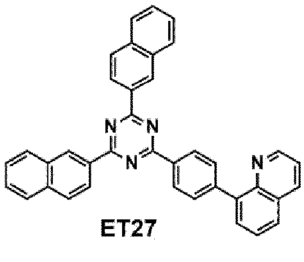
ET27

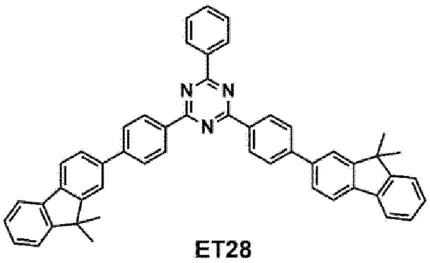
ET28

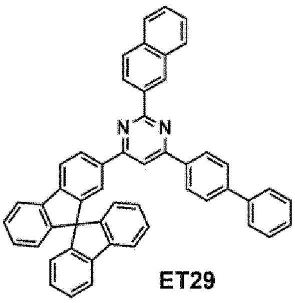
ET29

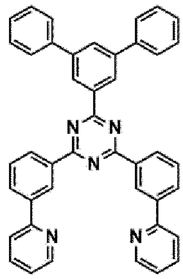
ET30

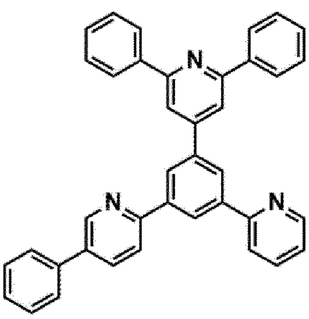
ET31

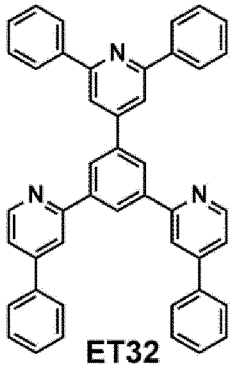
ET32

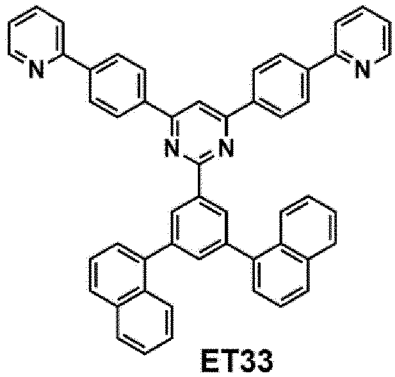
ET33

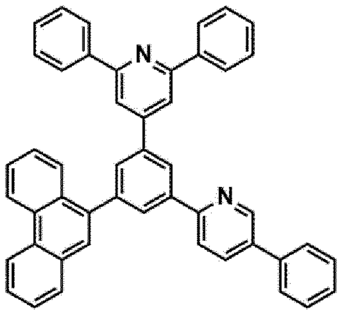
ET34

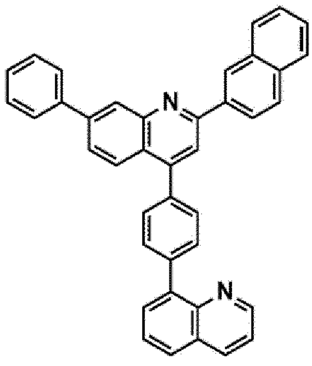
ET35

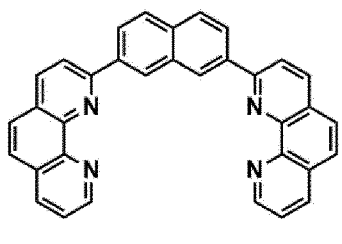
ET36

In one or more embodiments, the electron transport region ETR may include a metal halide such as LiF, NaCl, CsF, RbCl, RbI, CuI, and/or KI, a lanthanide metal such as Yb, or a co-deposited material of the metal halide and the lanthanide metal. For example, in one or more embodiments, the electron transport region ETR may include KI:Yb, RbI:Yb, LiF:Yb, and/or the like, as a co-deposited material. In one or more embodiments, the electron transport region ETR may be formed using a metal oxide such as $Li_2O$ and/or BaO, or 8-hydroxyl-lithium quinolate (Liq), and/or the like, but embodiments of the present disclosure is not limited thereto. The electron transport region ETR may also be formed of a mixture material of an electron transport material and an insulating organometallic salt. The organometallic salt may be a material having an energy band gap of about 4 eV or more. For example, the insulating organometallic salt may include,

for example, one or more of a metal acetate, a metal benzoate, a metal acetoacetate, a metal acetylacetonate, or a metal stearate.

In one or more embodiments, the electron transport region ETR may further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to one or more of the above-described materials, but embodiments of the present disclosure are not limited thereto.

In one or more embodiments, the electron transport region ETR may include one or more of the above-described compounds of the electron transport region in at least one of an electron injection layer EIL, an electron transport layer ETL, or a hole blocking layer HBL.

If (e.g., when) the electron transport region ETR includes an electron transport layer ETL, the electron transport layer ETL may have a thickness of about 100 Å to about 1,000 Å, for example, about 150 Å to about 500 Å. If (e.g., when) the thickness of the electron transport layer ETL satisfies the aforementioned range, satisfactory electron transport characteristics may be obtained without a substantial increase in driving voltage. If (e.g., when) the electron transport region ETR includes an electron injection layer EIL, the electron injection layer EIL may have a thickness of about 1 Å to about 100 Å, for example, about 3 Å to about 90 Å. If (e.g., when) the thickness of the electron injection layer EIL satisfies the above-described range, satisfactory electron injection characteristics may be obtained without a substantial increase in driving voltage.

The second electrode EL2 is provided on the electron transport region ETR. In one or more embodiments, the second electrode EL2 may be a common electrode. The second electrode EL2 may be a cathode or an anode, but embodiments of the present disclosure are not limited thereto. For example, if (e.g., when) the first electrode EL1 is an anode, the second electrode EL2 may be a cathode, and if (e.g., when) the first electrode EL1 is a cathode, the second electrode EL2 may be an anode.

The second electrode EL2 may be a transmissive electrode, a transflective electrode, or a reflective electrode. If (e.g., when) the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), and/or the like.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound thereof, or a mixture thereof (e.g., AgMg, AgYb, or MgYb). In one or more embodiments, the second electrode EL2 may have a multilayer structure including a reflective film or a transflective film formed of one or more of the above-described materials, and a transparent conductive film formed of ITO, IZO, ZnO, ITZO, and/or the like. For example, in one or more embodiments, the second electrode EL2 may include one of the above-described metal materials, a (e.g., any suitable) combination of at least two metal materials of the above-described metal materials, an oxide of the above-described metal materials, and/or the like.

In one or more embodiments, the second electrode EL2 may be connected with an auxiliary electrode. If (e.g., when) the second electrode EL2 is connected with the auxiliary electrode, the resistance of the second electrode EL2 may be decreased.

In one or more embodiments, a capping layer CPL may further be arranged on the second electrode EL2 of the light emitting element ED of one or more embodiments. The capping layer CPL may include a multilayer or a single layer.

In one or more embodiments, the capping layer CPL may be an organic layer or an inorganic layer. For example, if (e.g., when) the capping layer CPL contains an inorganic material, the inorganic material may include an alkali metal compound (e.g., LiF), an alkaline earth metal compound (e.g., $MgF_2$), SiON, $SiN_x$, $SiO_y$, and/or the like.

For example, in one or more embodiments, if (e.g., when) the capping layer CPL includes an organic material, the organic material may include $\alpha$-NPD, NPB, TPD, m-MTDATA, $Alq_3$, CuPc, N4,N4,N4',N4'-tetra(biphenyl-4-yl)biphenyl-4,4'-diamine (TPD15), 4,4',4"-tris(carbazol-9-yl)triphenylamine (TCTA), and/or the like, or an epoxy resin, or acrylate such as methacrylate. However, embodiments of the present disclosure are not limited thereto, for example, in one or more embodiments, the capping layer CPL may include at least one selected from among Compounds P1 to P5:

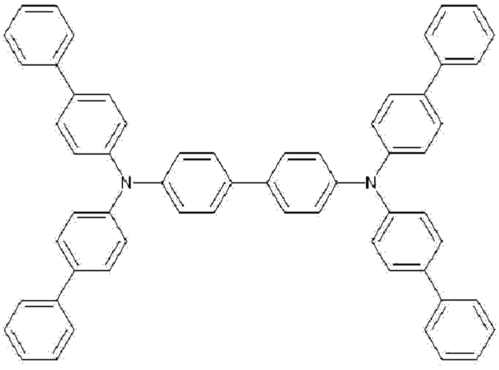

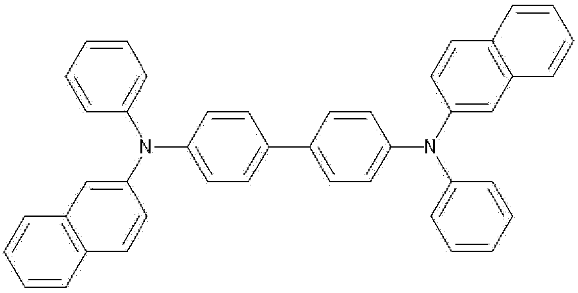

P1 P2

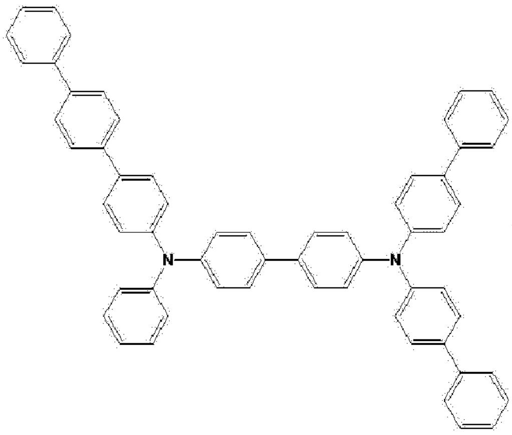

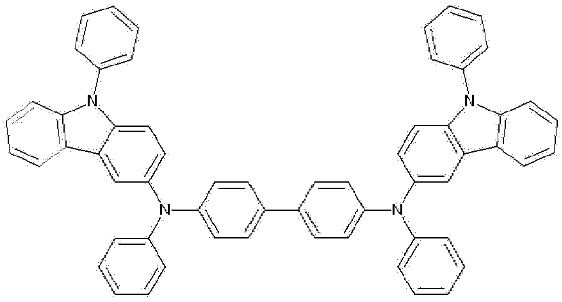

P3 P4

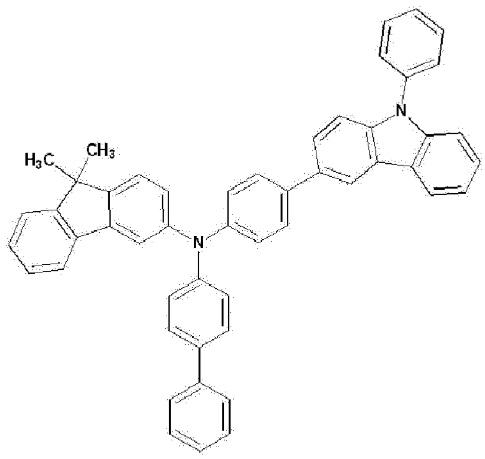

P5

In one or more embodiments, the refractive index of the capping layer CPL may be about 1.6 or more. For example, in one or more embodiments, the refractive index of the capping layer CPL may be about 1.6 or more with respect to light in a wavelength range of about 550 nm to about 660 nm.

Each of FIGS. 9 to 12 is a cross-sectional view of a display apparatus according to one or more embodiments of the disclosure. Hereinafter, in describing the display apparatuses of embodiments with reference to FIGS. 9 to 12, the duplicated features which have been described in FIGS. 1 to 4, 5A, 5B, and 6 to 8 will not be described again for conciseness, instead only their differences will be mainly described.

Referring to FIG. 9, the display apparatus DD-a according to one or more embodiments may include a display

panel DP including a display device layer DP-ED, a light control layer CCL arranged on the display panel DP, and a color filter layer CFL. In one or more embodiments as illustrated in FIG. 9, the display panel DP may include a base layer BS, a circuit layer DP-CL provided on the base layer BS, and the display device layer DP-ED, and the display device layer DP-ED may include a light emitting element ED.

The light emitting element ED includes a first electrode EL1, a hole transport region HTR arranged on the first electrode EL1, an emission layer EML arranged on the hole transport region HTR, an electron transport region ETR arranged on the emission layer EML, and a second electrode EL2 arranged on the electron transport region ETR. In one or more embodiments, the structures of the light emitting elements of FIGS. 3, 4, 5A, 5B, and 6 to 8 as described above may be equally applied to the structure of the light emitting element ED illustrated in FIG. 9.

The hole transport region HTR of the light emitting element ED included in the display device DD-a according to one or more embodiments includes the first hole transport layer including the first hole transport material, and a portion of the first hole transport layer includes a structure doped with the p-dopant.

Referring to FIG. 9, the emission layer EML may be arranged in an opening OH defined in a pixel defining film PDL. For example, the emission layer EML which is divided by the pixel defining film PDL and provided corresponding to each of light emitting regions PXA-R, PXA-G, and PXA-B may be to emit light in substantially the same wavelength range. In the display apparatus DD-a of one or more embodiments, the emission layer EML may be to emit blue light. In one or more embodiments, the emission layer EML may be provided as a common layer across the entire light emitting regions PXA-R, PXA-G, and PXA-B.

The light control layer CCL may be arranged on the display panel DP. The light control layer CCL may include a light conversion body. The light conversion body may be a quantum dot, a phosphor, and/or the like. The light conversion body may be to emit provided light by converting the wavelength thereof. For example, the light control layer CCL may a layer containing a quantum dot or a layer containing a phosphor.

The light control layer CCL may include a plurality of light control parts CCP1, CCP2, and CCP3. The light control parts CCP1, CCP2, and CCP3 may be spaced and/or apart (e.g., spaced apart or separated) from one another.

Referring to FIG. 9, divided patterns BMP may be arranged between the light control parts CCP1, CCP2, and CCP3 which are spaced and/or apart (e.g., spaced apart or separated) from one another, but embodiments of the present disclosure are not limited thereto. FIG. 9 illustrates that the divided patterns BMP do not overlap the light control parts CCP1, CCP2, and CCP3, but, in one or more embodiments, at least a portion of the edges of the light control parts CCP1, CCP2, and CCP3 may overlap the divided patterns BMP.

The light control layer CCL may include a first light control part CCP1 containing a first quantum dot QD1 which converts first color light provided from the light emitting element ED into second color light, a second light control part CCP2 containing a second quantum dot QD2 which converts the first color light into third color light, and a third light control part CCP3 which transmits the first color light.

In one or more embodiments, the first light control part CCP1 may provide red light that is the second color light, and the second light control part CCP2 may provide green light that is the third color light. The third light control part CCP3 may provide blue light by transmitting the blue light that is the first color light provided from the light emitting element ED. For example, in one or more embodiments, the first quantum dot QD1 may be a red quantum dot to emit red light, and the second quantum dot QD2 may be a green quantum dot to emit green light. The same as described above on quantum dots may be applied with respect to the quantum dots QD1 and QD2.

In one or more embodiments, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) any quantum dot but include the scatterer SP.

The scatterer SP may be inorganic particles. For example, the scatterer SP may include at least one of $TiO_2$, ZnO, $Al_2O_3$, $SiO_2$, or hollow sphere silica. In one or more embodiments, the scatterer SP may include any one selected from among $TiO_2$, ZnO, $Al_2O_3$, $SiO_2$, and hollow sphere silica, or may be a mixture of at least two materials selected from among $TiO_2$, ZnO, $Al_2O_3$, $SiO_2$, and hollow sphere silica.

The first light control part CCP1, the second light control part CCP2, and the third light control part CCP3 may respectively include base resins BR1, BR2, and BR3 in which the quantum dots QD1 and QD2 and the scatterer SP are dispersed accordingly. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed accordingly, and may be formed of one or more suitable resin compositions, which may be generally referred to as a binder. For example, the base resins BR1, BR2, and BR3 may each independently be an acrylic-based resin, a urethane-based resin, a silicone-based resin, an epoxy-based resin, and/or the like. The base resins BR1, BR2, and BR3 may each be transparent resins. In one or more embodiments, the first base resin BR1, the second base resin BR2, and the

third base resin BR3 may be the same as or different from one another.

In one or more embodiments, the light control layer CCL may include a barrier layer BFL1. The barrier layer BFL1 may serve to prevent or reduce the penetration of moisture and/or oxygen (hereinafter, referred to as 'moisture/oxygen'). The barrier layer BFL1 may block the light control parts CCP1, CCP2, and CCP3 from being exposed to moisture/oxygen. In one or more embodiments, the barrier layer BFL1 may cover the light control parts CCP1, CCP2, and CCP3. In one or more embodiments, a barrier layer BFL2 may be provided between the light control parts CCP1, CCP2, and CCP3 and the color filter layer CFL.

The barrier layers BFL1 and BFL2 may each include at least one inorganic layer. For example, in one or more embodiments, the barrier layers BFL1 and BFL2 may each include an inorganic material. For example, the barrier layers BFL1 and BFL2 may each independently include a silicon nitride, an aluminium nitride, a zirconium nitride, a titanium nitride, a hafnium nitride, a tantalum nitride, a silicon oxide, an aluminium oxide, a titanium oxide, a tin oxide, a cerium oxide, a silicon oxynitride, a metal thin film which secures a transmittance, and/or the like. In one or more embodiments, the barrier layers BFL1 and BFL2 may each independently further include an organic film. The barrier layers BFL1 and BFL2 may be formed of a single layer or a plurality of layers.

In the display apparatus DD-a of one or more embodiments, the color filter layer CFL may be arranged on the light control layer CCL. For example, in one or more embodiments, the color filter layer CFL may be directly arranged on the light control layer CCL. In these embodiments, the barrier layer BFL2 may not be provided.

The color filter layer CFL may include color filters CF1, CF2, and CF3. The color filter layer CFL may include a first filter CF1 configured to transmit the second color light, a second filter CF2 configured to transmit the third color light, and a third filter CF3 configured to transmit the first color light. For example, in one or more embodiments, the first filter CF1 may be a red filter, the second filter CF2 may be a green filter, and the third filter CF3 may be a blue filter. The filters CF1, CF2, and CF3 each may include a polymeric photosensitive resin and a pigment and/or a dye. The first filter CF1 may include a red pigment and/or a red dye, the second filter CF2 may include a green pigment and/or a green dye, and the third filter CF3 may include a blue pigment and/or a blue dye.

In one or more embodiments, the third filter CF3 may not include (e.g., may exclude) any pigment or dye. The third filter CF3 may include a polymeric photosensitive resin and may not include (e.g., may exclude) any pigment or dye. The third filter CF3 may be transparent. The third filter CF3 may be formed of a transparent photosensitive resin.

Furthermore, in one or more embodiments, the first filter CF1 and the second filter CF2 may each be a yellow filter. The first filter CF1 and the second filter CF2 may not be separated but be provided as one filter.

In one or more embodiments, the color filter layer CFL may further include a light shielding part. The light shielding part may be a black matrix. The light shielding part may include an organic light shielding material or an inorganic light shielding material containing a black pigment and/or a black dye. The light shielding part may prevent or reduce light leakage, and may separate boundaries between adjacent filters CF1, CF2, and CF3.

The first to third filters CF1, CF2, and CF3 may be arranged corresponding to the red light emitting region PXA-R, the green light emitting region PXA-G, and the blue light emitting region PXA-B, respectively.

In one or more embodiments, a base substrate BL may be arranged on the color filter layer CFL. The base substrate BL may be a member which provides a base surface on which the color filter layer CFL, the light control layer CCL, and/or the like are arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided.

FIG. 10 is a cross-sectional view illustrating a portion of a display apparatus according to one or more embodiments. In a display apparatus DD-TD of one or more embodiments, the light emitting element ED-BT may include a plurality of light emitting structures OL-B1, OL-B2, and OL-B3. The light emitting element ED-BT may include a first electrode EL1 and a second electrode EL2 which face each other, and the plurality of light emitting structures OL-B1, OL-B2, and OL-B3 sequentially stacked in a thickness direction between the first electrode EL1 and the second electrode EL2. The light emitting structures OL-B1, OL-B2, and OL-B3 each may include an emission layer EML (FIG. 9) and a hole transport region HTR and an electron transport region ETR arranged with the emission layer EML (FIG. 9) located therebetween.

For example, the light emitting element ED-BT included in the display apparatus DD-TD of one or more embodiments may be a light emitting device having a tandem structure and including a plurality of emission layers.

In one or more embodiments illustrated in FIG. 10, all light beams respectively emitted from the light emitting structures OL-B1, OL-B2, and OL-B3 may be blue light. However, embodiments of the disclosure are not limited thereto, and the light beams respectively emitted from the light emitting structures OL-B1, OL-B2, and OL-B3 may have wavelength ranges different from one another. For example, in one or more embodiments, the light emitting element ED-BT including the plurality of light emitting structures OL-B1, OL-B2, and OL-B3 which emit light beams having wavelength ranges different from one another may be to emit white light (e.g., combined white light).

Charge generation layers CGL1 and CGL2 may be respectively arranged between two of the neighboring light

emitting structures OL-B1, OL-B2, and OL-B3. The charge generation layers CGL1 and CGL2 may each include a p-type (kind) charge (e.g., P-charge) generation layer and/or an n-type (kind) charge (e.g., N-charge) generation layer. At least one selected from among the light emitting structures OL-B1, OL-B2, and OL-B3 included in the display apparatus DD-TD of one or more embodiments may include the first hole transport layer including the first hole transport material, and a portion of the first hole transport layer may include a structure doped with the p-dopant. For example, at least one selected from among a plurality of hole transport regions included in the light emitting element ED-BT may include the first hole transport layer including the first hole transport material, and a portion of the first hole transport layer may include a structure doped with the p-dopant.

Referring to FIG. 11, a display apparatus DD-b according to one or more embodiments may include light emitting elements ED-1, ED-2, and ED-3 in each of which two emission layers are stacked. Compared with the display apparatus DD of one or more embodiments illustrated in FIG. 2, the display apparatus DD-b illustrated in FIG. 11 has a difference in that the first to third light emitting elements ED-1, ED-2, and ED-3 each include two emission layers stacked in a thickness direction. In each of the first to third light emitting elements ED-1, ED-2, and ED-3, the two emission layers may be to emit light in substantially the same wavelength region.

The first light emitting element ED-1 may include a first red emission layer EML-R1 and a second red emission layer EML-R2. The second light emitting element ED-2 may include a first green emission layer EML-G1 and a second green emission layer EML-G2. In addition, the third light emitting element ED-3 may include a first blue emission layer EML-B1 and a second blue emission layer EML-B2. An emission auxiliary part OG may be arranged between the first red emission layer EML-R1 and the second red emission layer EML-R2, between the first green emission layer EML-G1 and the second green emission layer EML-G2, and between the first blue emission layer EML-B1 and the second blue emission layer EML-B2.

The emission auxiliary part OG may include a single layer or a multilayer. The emission auxiliary part OG may include a charge generation layer. For example, the emission auxiliary part OG may include an electron transport region, a charge generation layer, and a hole transport region that are sequentially stacked (e.g., in the stated order). The emission auxiliary part OG may be provided as a common layer in the whole of the first to third light emitting elements ED-1, ED-2, and ED-3. However, embodiments of the present disclosure are not limited thereto, for example, in one or more embodiments, the emission auxiliary part OG may be provided by being patterned within the openings OH defined in the pixel defining film PDL.

The first red emission layer EML-R1, the first green emission layer EML-G1, and the first blue emission layer EML-B1 may be arranged between the emission auxiliary part OG and the electron transport region ETR. The second red emission layer EML-R2, the second green emission layer EML-G2, and the second blue emission layer EML-B2 may be arranged between the hole transport region HTR and the emission auxiliary part OG.

For example, in one or more embodiments, the first light emitting element ED-1 may include a first electrode EL1, a hole transport region HTR, a second red emission layer EML-R2, an emission auxiliary part OG, a first red emission layer EML-R1, an electron transport region ETR, and a second electrode EL2 that are sequentially stacked (e.g., in the stated order). The second light emitting element ED-2 may include a first electrode EL1, a hole transport region HTR, a second green emission layer EML-G2, an emission auxiliary part OG, a first green emission layer EML-G1, an electron transport region ETR, and a second electrode EL2 that are sequentially stacked (e.g., in the stated order). The third light emitting element ED-3 may include a first electrode EL1, a hole transport region HTR, a second blue emission layer EML-B2, an emission auxiliary part OG, a first blue emission layer EML-B1, an electron transport region ETR, and a second electrode EL2 that are sequentially stacked (e.g., in the stated order).

In one or more embodiments, an optical auxiliary layer PL may be arranged on the display device layer DP-ED. The optical auxiliary layer PL may include a polarizing layer. The optical auxiliary layer PL may be arranged on the display panel DP and control reflected light in the display panel DP due to external light. Unlike the configuration illustrated, the optical auxiliary layer PL in the display apparatus DD-b according to one or more embodiments may not be provided.

At least one hole transport region HTR included in a display apparatus DD-b of one or more embodiments shown in FIG. 11 includes the first hole transport layer including the first hole transport material, and a portion of the first hole transport layer includes a structure doped with the p-dopant. For example, in one or more embodiments, the hole transport region HTR of the light emitting element ED-3 may include the first hole transport layer including the first hole transport material, and a portion of the first hole transport layer may include a structure doped with the p-dopant.

Unlike FIG. 10 and FIG. 11, FIG. 12 illustrates that a display apparatus DD-c includes four light emitting structures OL-B1, OL-B2, OL-B3, and OL-C1. A light emitting element ED-CT may include a first electrode EL1 and a second electrode EL2 which face each other, and first to fourth light emitting structures OL-B1, OL-B2, OL-B3, and OL-C1 that are stacked in a thickness direction between the first electrode EL1 and the second electrode EL2. Charge generation layers CGL1, CGL2, and CGL3 may each be separately arranged between the first to fourth light emitting structures OL-B1, OL-B2, OL-B3, and OL-C1. In one or more embodiments, among the four light emitting structures, the first to third light emitting structures OL-B1, OL-B2, and OL-B3 may be to emit blue light, and the fourth light emitting structure OL-C1 may be to emit green light. However, embodiments of the present disclosure are not limited thereto, and the first to fourth light emitting

structures OL-B1, OL-B2, OL-B3, and OL-C1 may be to emit light beams in different wavelength regions.

The charge generation layers CGL1, CGL2, and CGL3 arranged between adjacent light emitting structures OL-B1, OL-B2, OL-B3, and OL-C1 may each independently include a p-type (kind) charge (e.g., P-charge) generation layer and/or an n-type (kind) charge (e.g., N-charge) generation layer.

At least one selected from among the light emitting structures OL-B1, OL-B2, OL-B3, and OL-C1 included in the display apparatus (e.g., display device) DD-c according to one or more embodiments may include the first hole transport layer including the first hole transport material, and a portion of the first hole transport layer may include a structure doped with the p-dopant. For example, in one or more embodiments, at least one selected from among the first to third light emitting structures OL-B1, OL-B2, and OL-B3 may include the first hole transport layer including the first hole transport material, and a portion of the first hole transport layer may include a structure doped with the p-dopant.

The light emitting element ED described above according to one or more embodiments of the disclosure includes the first hole transport layer including the first hole transport material, and a portion of the first hole transport layer includes a structure doped with the p-dopant, and may thus exhibit excellent or suitable light emitting efficiency and improved lifespan. For example, the first hole transport layer adjacent to the first electrode of the light emitting element of one or more embodiments may include the first hole transport material, and a portion of the first hole transport layer may include a structure doped with the p-dopant; as a result, the light emitting element may exhibit long lifespan.

In one or more embodiments, an electronic device may include a display apparatus including a plurality of light emitting elements, and a control part which controls the display apparatus. The electronic device of one or more embodiments may be a device that is activated according to an electrical signal. The electronic device may include display apparatuses of one or more suitable embodiments. For example, the electronic device may include not only large-sized electronic apparatuses such as a television set, a monitor, and/or an outdoor billboard but also include small- and medium-sized electronic apparatuses/devices such as a personal computer, a laptop computer, a personal digital terminal, a display apparatus for a vehicle, a game console, a portable electronic device, and/or a camera.

FIG. 13 is a view illustrating a vehicle AM in which first to fourth display apparatuses DD-1, DD-2, DD-3, and DD-4 are arranged. At least one selected from among the first to fourth display apparatuses DD-1, DD-2, DD-3, and DD-4 may include the same configuration as one of the display apparatuses (e.g., display devices) DD, DD-TD, DD-a, DD-b, and DD-c as described with reference to FIGS. 1, and 2, and 9 to 12.

FIG. 13 illustrates a vehicle AM, but this is an example, and the first to fourth display apparatuses DD-1, DD-2, DD-3, and DD-4 may be arranged in other transportation apparatuses such as bicycles, motorcycles, trains, ships, and/or airplanes. In one or more embodiments, at least one selected from among the first to fourth display apparatuses DD-1, DD-2, DD-3, and DD-4 including the same configuration as one of the display apparatuses (e.g., display devices) DD, DD-TD, DD-a, DD-b, and DD-c of one or more embodiments may be employed in a personal computer, a laptop computer, a personal digital terminal, a game console, a portable electronic device, a television, a monitor, an outdoor billboard, and/or the like. These are merely provided as examples, and thus may be employed in other electronic devices unless departing from the disclosure.

At least one selected from among the first to fourth display apparatuses DD-1, DD-2, DD-3, and DD-4 may include the light emitting element ED of one or more embodiments described with reference to FIGS. 3, 4, 5A, 5B, and 6 to 8. The light emitting element ED of one or more embodiments includes the first hole transport layer including the first hole transport material, and a portion of the first hole transport layer includes a structure doped with the p-dopant. In one or more embodiments, at least one selected from among the first to fourth display apparatuses DD-1, DD-2, DD-3, and DD-4 includes a light emitting element ED including a hole transport region structure and material of one or more embodiments of the present disclosure, so that a display lifespan can be improved.

Referring to FIG. 13, the vehicle AM may include a steering wheel HA and a gear GR for driving the vehicle AM. In addition, the vehicle AM may include a front window GL arranged so as to face a driver.

The first display apparatus DD-1 may be arranged in a first region overlapping the steering wheel HA. For example, the first display apparatus DD-1 may be a digital cluster which displays first information of the vehicle AM. The first information may include a first scale which indicates a driving speed of the vehicle AM, a second scale which indicates an engine speed (that is, revolutions per minute (RPM)), an image which indicates a fuel state, and/or the like. The first scale and the second scale may be indicated as a digital image.

The second display apparatus DD-2 may be arranged in a second region opposite to (e.g., facing) a driver seat and overlapping the front window GL. The driver seat may be a seat in which the steering wheel HA faces. For example, the second display apparatus DD-2 may be a head up display (HUD) which displays second information of the vehicle AM. The second display apparatus DD-2 may be optically transparent. The second information may include digital numbers which indicate a driving speed, and may further include information such as the current time. In one or more embodiments, the second information of the second display apparatus DD-2 may be projected to the front window GL to be displayed.

The third display apparatus DD-3 may be arranged in a third region adjacent to the gear GR. For example, the third display apparatus DD-3 may be arranged between the driver seat and a passenger seat and may be a center information display (CID) for the vehicle for displaying third information. The passenger seat may be a seat spaced and/or

apart (e.g., spaced apart or separated) from the driver seat with the gear GR arranged therebetween. The third information may include information about traffic (e.g., navigation information), playing music or radio or a video (or an image), temperatures inside the vehicle AM, and/or the like.

The fourth display apparatus DD-4 may be spaced and/or apart (e.g., spaced apart or separated) from the steering wheel HA and the gear GR, and may be arranged in a fourth region adjacent to a side of the vehicle AM. For example, the fourth display apparatus DD-4 may be a digital side-view mirror which displays fourth information. The fourth display apparatus DD-4 may display an image outside the vehicle AM taken by a camera module CM arranged outside the vehicle AM. The fourth information may include an image outside the vehicle AM.

The above-described first to fourth information may be examples, and the first to fourth display apparatuses DD-1, DD-2, DD-3, and DD-4 may further display information about the inside and outside of the vehicle AM. The first to fourth information may include different information. However, embodiments of the present disclosure are not limited thereto, and a part of the first to fourth information may include the same information as one another.

Hereinafter, with reference to Examples and Comparative Examples, a light emitting element according to one or more embodiments of the present disclosure will be specifically described. In addition, Examples are shown only for the understanding of the disclosure, and the scope of the present disclosure is not limited thereto.

## Examples

### 1. Manufacturing and Evaluation of Light Emitting Elements

A light emitting element of one or more embodiments including a hole transport region including a first hole transport material and a first hole transport layer doped with a p-dopant in some regions was manufactured through the following method. In Examples 1 to 7, as the hole transport material, the following materials selected from among the compounds presented in Compound Group 1 and Compound Group 2 described above were used. Comparative Examples 1 to 5 correspond to light emitting elements having the same or similar element structure as Examples 1 to 7, but not including a p-dopant with which the first hole transport layer is doped.

### Hole transport material

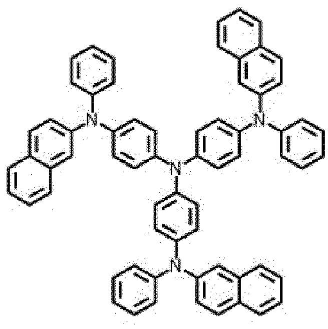

B1

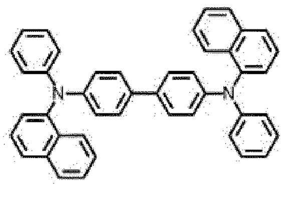

B2

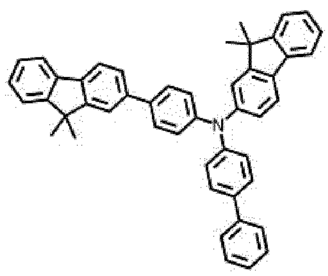

B3

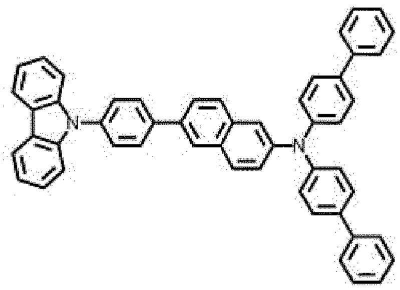

B4

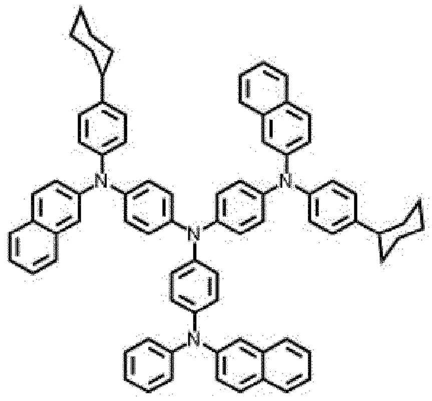

A1

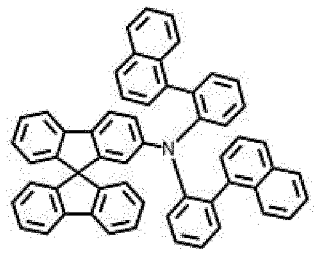

A5

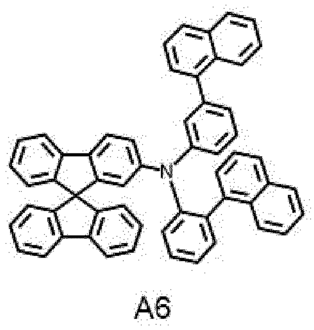

A6

**Example 1 Manufacturing of light emitting element**

As for a light emitting element of Example 1, as an anode, a glass substrate having an ITO electrode (Corning, 15 $\Omega/cm^2$, 1200 Å) formed thereon was cut to a size of about 50 mm x 50 mm x 0.5 mm, subjected to ultrasonic cleaning with isopropyl alcohol and then pure water for 5 minutes respectively and to ultraviolet irradiation for 30 minutes, and then exposed to ozone for cleaning, and then the cleaned ITO glass substrate was mounted on a vacuum deposition apparatus.

An upper portion of the anode was deposited with compound B1 to form a preliminary first hole transport layer having a thickness of 141 nm, and then the anode of the preliminary first hole transport layer was doped with 2 wt% of 2-(7-dicyanomethylene-1,3,4,5,6,8,9,10-octafluoro-7H-pyren-2-ylidene)-malononitrile (NDP-9), a p-dopant, to form a first sub-hole transport layer having a thickness of 60 Å from an upper surface of the anode, and a portion spaced 1100 Å from the first sub-hole transport layer was doped with 2 wt% of NDP-9, a p-dopant, to form a second sub-hole transport layer having a thickness of 50 Å. Accordingly, a structure was formed in which the 60 Å thick first sub-hole transport layer doped with a p-dopant, the 1100 Å thick third sub-hole transport layer not doped with a p-dopant, and the 50 Å thick second sub-hole transport layer doped with a p-dopant were sequentially stacked from the upper surface of the anode. In addition, a 200 Å thick fourth sub-hole transport layer not doped with a p-dopant was formed on the second sub-hole transport layer.

Thereafter, a 30 nm thick emission layer was formed through the codeposition of compound E2 and compound BD1 at a weight ratio of 97:3, an upper portion of the emission layer was deposited with compound ETM1 to form a 10 nm thick auxiliary emission layer, and then an upper portion of the auxiliary emission layer was deposited with compound ETM2 to form a 20 nm thick electron transport layer. Then, an upper portion of the electron transport layer was deposited with 1 nm of LiF to form an electron injection layer. On the electron injection layer, a 1000 Å thick second electrode was formed using aluminium (Al). Each layer was formed through vacuum deposition.

**Example 2 Manufacturing of light emitting element**

Compared to the light emitting element of Example 1, a light emitting element was manufactured using substantially the same method as in Example 1, except that compound A1 was used instead of compound B1 when forming a preliminary first hole transport layer.

**Example 3 Manufacturing of light emitting element**

Compared to the light emitting element of Example 1, a light emitting element was manufactured using substantially the same method as in Example 1, except that compound A5 was used instead of compound B1 when forming a preliminary first hole transport layer.

**Example 4 Manufacturing of light emitting element**

As for a light emitting element of Example 4, as an anode, a glass substrate having an ITO electrode (Corning, 15 $\Omega/cm^2$, 1200 Å) formed thereon was cut to a size of about 50 mm x 50 mm x 0.5 mm, subjected to ultrasonic cleaning with isopropyl alcohol and then pure water for 5 minutes respectively and to ultraviolet irradiation for 30 minutes, and then exposed to ozone for cleaning, and then the cleaned ITO glass substrate was mounted on a vacuum deposition apparatus.

An upper portion of the anode was deposited with compound B1 to form a 70 nm thick third hole transport layer, and then an upper portion of the third hole transport layer was deposited with compound A1 to form a 71 nm thick preliminary first hole transport layer. Thereafter, the preliminary first hole transport layer was doped with 2 wt% of NDP-9, a p-dopant, to form a 60 Å thick first sub-hole transport layer, and a portion spaced 400 Å from the first sub-hole transport layer was doped with 2 wt% of NDP-9, a p-dopant, to form a 50 Å thick second sub-hole transport layer. Accordingly, a structure was formed in which the 60 Å thick first sub-hole transport layer doped with a p-dopant, the 400 Å thick third sub-hole transport layer not doped with a p-dopant, and the 50 Å thick second sub-hole transport layer doped with a p-dopant were sequentially stacked from the upper surface of the third hole transport layer. In addition, a 200 Å thick fourth sub-hole transport layer not doped with a p-dopant was formed on the second sub-hole transport layer.

Thereafter, a 30 nm thick emission layer was formed through the codeposition of compound E2 and compound BD1 at a weight ratio of 97:3, an upper portion of the emission layer was deposited with compound ETM1 to form a 10 nm thick auxiliary emission layer, and then an upper portion of the auxiliary emission layer was deposited with compound ETM2 to form a 20 nm thick electron transport layer. Then, an upper portion of the electron transport layer was deposited with 1 nm of LiF to form an electron injection layer. On the electron injection layer, a 1000 Å thick second electrode was formed using aluminium (Al). Each layer was formed through vacuum deposition.

**Example 5 Manufacturing of light emitting element**

Compared to the light emitting element of Example 4, a light emitting element was manufactured using substantially the same method as in Example 4, except that compound A5 was used instead of compound A1 when forming a preliminary first hole transport layer.

**Example 6 Manufacturing of light emitting element**

Compared to the light emitting element of Example 1, a light emitting element was manufactured using substantially the same method as in Example 1, except that a mixture of compound B3 and compound A5 in a weight ratio of 1:1 was used instead of compound B1.

**Example 7 Manufacturing of light emitting element**

Compared to the light emitting element of Example 1, a light emitting element was manufactured using substantially the same method as in Example 1, except that a mixture of compound B3 and compound A6 in a weight ratio of 1:1 was used instead of compound B1.

**Comparative Example 1 Manufacturing of light emitting element**

As for a light emitting element of Comparative Example 1, as an anode, a glass substrate having an ITO electrode (Corning, 15 $\Omega/cm^2$, 1200 Å) formed thereon was cut to a size of about 50 mm x 50 mm x 0.5 mm, subjected to ultrasonic cleaning with isopropyl alcohol and then pure water for 5 minutes respectively and to ultraviolet irradiation for 30 minutes, and then exposed to ozone for cleaning, and then the cleaned ITO glass substrate was mounted on a vacuum deposition apparatus.

An upper portion of the anode was deposited with compound B1 to form a 141 nm thick first hole transport layer.

Thereafter, a 30 nm thick emission layer was formed through the codeposition of compound E2 and compound BD1 at a weight ratio of 97:3, an upper portion of the emission layer was deposited with compound ETM1 to form a 10 nm thick auxiliary emission layer, and then an upper portion of the auxiliary emission layer was deposited with compound ETM2 to form a 20 nm thick electron transport layer. Then, an upper portion of the electron transport layer was deposited

with 1 nm of LiF to form an electron injection layer. On the electron injection layer, a 1000 Å thick second electrode was formed using aluminium (Al). Each layer was formed through vacuum deposition.

**Comparative Example 2 Manufacturing of light emitting element**

Compared to the light emitting element of Comparative Example 1, a light emitting element was manufactured using substantially the same method as in Example 1, except that compound B2 was used instead of compound B1 when forming a first hole transport layer.

**Comparative Example 3 Manufacturing of light emitting element**

Compared to the light emitting element of Comparative Example 1, a light emitting element was manufactured using substantially the same method as in Example 1, except that compound B3 was used instead of compound B1 when forming a first hole transport layer.

**Comparative Example 4 Manufacturing of light emitting element**

Compared to the light emitting element of Comparative Example 1, a light emitting element was manufactured using substantially the same method as in Example 1, except that compound A1 was used instead of compound B1 when forming a first hole transport layer.

**Comparative Example 5 Manufacturing of light emitting element**

Compared to the light emitting element of Comparative Example 1, a light emitting element was manufactured using substantially the same method as in Example 1, except that compound A5 was used instead of compound B1 when forming a first hole transport layer.

The compounds used in the manufacturing of the light emitting elements of Examples and Comparative Examples are disclosed below. The following materials were used for the manufacturing of the elements after sublimation-purifying commercially available products.

## Compound structure

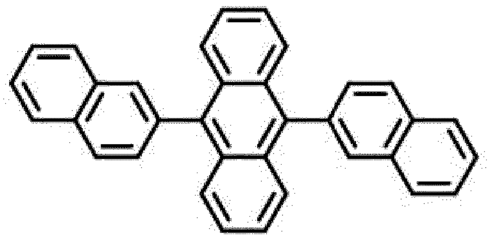

E2

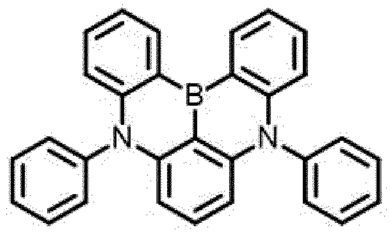

BD1

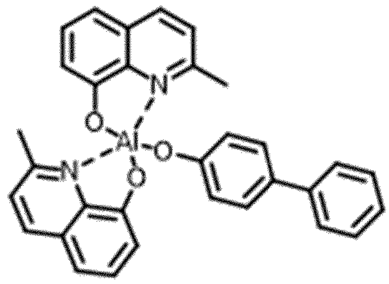

ETM1

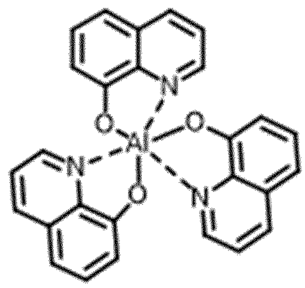

ETM2

**Property evaluation of hole transport materials**

Table 1 shows evaluation on properties of hole transport materials, compounds A1 to A6 and compounds B1 to B3. In Table 1, refractive index, HOMO energy level, and LUMO energy level of each of the hole transport materials used in Examples and Comparative Examples were measured. The refractive index was measured using an ellipsometer after fabricating a thin film having a thickness of 1000 Å, which contained a corresponding compound of Table 1. The refractive index values are values measured using a light source with a wavelength of 460 nm. The HOMO and LUMO energy levels were measured using Smart Manager software of SP2 electrochemical workstation equipment from ZIVE LAB.

Table 1

| Compound | Refractive index | HOMO (eV) | LUMO (eV) |
|---|---|---|---|
| Compound A1 | 1.82 | - 5.0 | - 1.2 |
| Compound A2 | 1.76 | - 5.3 | - 2.2 |
| Compound A3 | 1.84 | - 5.0 | - 1.2 |
| Compound A4 | 1.83 | - 5.0 | - 1.2 |
| Compound A5 | 1.81 | - 5.1 | - 1.2 |
| Compound A6 | 1.80 | - 5.1 | - 1.1 |
| Compound B1 | 1.92 | - 5.1 | -2.0 |
| Compound B2 | 1.91 | - 5.3 | - 2.2 |
| Compound B3 | 1.99 | - 5.0 | - 1.2 |

**Property evaluation of light emitting elements**

Element efficiency and element service life of each of the light emitting elements manufactured according to the element manufacturing example described above were evaluated. Table 2 shows results of evaluation on each of the light emitting elements for Examples 1 to 7 and Comparative Examples 1 to 5. Meanwhile, luminous efficacy (Cd/A) at 1000 $cd/m^2$ and lifespan of each of the light emitting elements were measured using Keithley MU 236 and luminance meters SR3AR and PR650, and the lifespan was measured as the time taken for the luminance to reach 97% of the initial luminance. The element service life (i.e., lifespan) is listed as a relative comparison value with respect to the element service life of 100% in Comparative Example 1. In Table 2, progressive driving voltage was measured as the difference between the driving voltage at the beginning of the life evaluation and the driving voltage measured after 200 hours of the life evaluation. For example, the progressive driving voltage may be calculated through Equation A.

## Equation A

$$\text{Progressive driving voltage} = V_1 - V_2$$

In Equation A, $V_2$ indicates an initial driving voltage value measured at the beginning of the life evaluation, and $V_1$ indicates a driving voltage value measured after 200 hours of the life evaluation.

Table 2

| | Driving voltage (V) | Efficiency (Cd/A) | Lifespan ($T_{97}$) | Progressive driving |
|---|---|---|---|---|
| Example 1 | 4.6 | 5.9 | 127% | +0.03 |
| Example 2 | 5.3 | 6.7 | 105% | +0.31 |
| Example 3 | 5.1 | 6.7 | 112% | +0.20 |
| Example 4 | 4.6 | 6.9 | 120% | +0.05 |
| Example 5 | 4.6 | 7.0 | 137% | +0.05 |
| Example 6 | 4.8 | 6.1 | 125% | +0.11 |
| Example 7 | 4.8 | 6.1 | 121% | +0.12 |

(continued)

| | Driving voltage (V) | Efficiency (Cd/A) | Lifespan ($T_{97}$) | Progressive driving |
|---|---|---|---|---|
| Comparative Example 1 | 4.7 | 5.9 | 100% | +0.05 |
| Comparative Example 2 | 4.6 | 5.7 | 113% | +0.07 |
| Comparative Example 3 | 4.8 | 5.7 | 122% | +0.07 |
| Comparative Example 4 | 5.3 | 6.7 | 62% | +0.51 |
| Comparative Example 5 | 5.1 | 6.8 | 79% | +0.35 |

Referring to the results of Table 2, it is determined that the light emitting elements of Examples each having a structure in which the first hole transport layer is doped with the p-dopant according to one or more embodiments of the disclosure each have greater element service life than the light emitting elements of Comparative Examples. In particular, if (e.g., when) comparing the light emitting elements of Example 1 and Comparative Example 1, which have the same hole transport material and stack structure but differ in whether the first hole transport layer is doped with a p-dopant, it is determined that the element service life is increased by 27% in Example 1. Similarly, the light emitting element of Example 2 exhibits greater element service life than the light emitting element of Comparative Example 4, where the two differ in whether the first hole transport layer is doped with a p-dopant, and the light emitting element of Example 3 exhibits greater element service life than the light emitting element of Comparative Example 5, where the two differ in whether the first hole transport layer is doped with a p-dopant. The light emitting element of one or more embodiments exhibits prevention of the degradation of the hole transport material by doping a portion of the first hole transport layer with a p-dopant, and thus may exhibit excellent or suitable element service life characteristics.

The light emitting element of one or more embodiments may exhibit improved element characteristics of long service life. For example, the light-emitting elements of one or more embodiments, as demonstrated in Examples 1 to 7, exhibit improved characteristics of long service life. For instance, in Example 1, a light-emitting element was manufactured using a glass substrate with an ITO electrode, where the first hole transport layer was doped with 2 wt% of NDP-9, a p-dopant. This resulted in a 27% increase in service life compared to Comparative Example 1, which had the same hole transport material and stack structure but lacked the p-dopant in the first hole transport layer. Similarly, in Example 2, the light-emitting element used compound A1 instead of compound B1 for the preliminary first hole transport layer, showing greater service life than Comparative Example 4. Example 3, which used compound A5 instead of compound B1, also demonstrated improved service life compared to Comparative Example 5. These examples highlight the effectiveness of doping the first hole transport layer with a p-dopant in preventing degradation of the hole transport material.

A display device/apparatus of one or more embodiments may include the light emitting element of one or more embodiments, thereby exhibiting excellent or suitable service life. This integration of incorporating the light-emitting elements into the display device/apparatus ensures that the display device benefits from the enhanced longevity and performance of the light-emitting elements, as evidenced by the comparative improvements shown in the examples.

An electronic device of one or more embodiments may include the display device/apparatus described above. This electronic device can be any device that utilizes a display, such as a smartphone, tablet, television, or wearable device. By incorporating the display device with the improved light-emitting elements, the electronic device can achieve superior display performance and extended operational life, providing users with a more reliable and durable product.

As used herein, the HOMO energy level and LUMO energy level of a compound are each a negative value with respect to the vacuum level.

In the present disclosure, the term "light emitting element" may be used interchangeably with the term "light emitting device." The term "display device" may be used interchangeably with the term "display apparatus."

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within $\pm$ 30%, 20%, 10%, or 5% of the stated value.

In the context of the present application and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum

numerical limitation recited herein is intended to include all lower numerical limitations subsumed therein and any minimum numerical limitation recited in this specification is intended to include all higher numerical limitations subsumed therein.

The light emitting element, the display apparatus/device, the electronic device/apparatus, a device of manufacturing the same, and/or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

In the present disclosure, each suitable feature of the various embodiments of the disclosure may be combined or combined with one another, partially or entirely, and may be technically interlocked and operated in various suitable ways, and each embodiment may be implemented independently of one another or in conjunction with one another in any suitable manner unless otherwise stated or implied.

Although the disclosure has been described with reference to one or more embodiments of the disclosure, it will be understood that the present disclosure should not be limited to these example embodiments but one or more suitable changes and modifications may be made by those skilled in the art without departing from the scope of the disclosure.

Accordingly, the technical scope of the present disclosure is not intended to be limited to the content set forth in the detailed description of the disclosure, but is intended to be defined by the appended claims and equivalents thereof.

## Claims

**1.** A light emitting element (ED) comprising:

a first electrode (EL1);
a hole transport region (HTR) on the first electrode (EL1);
an emission layer (EML) on the hole transport region (HTR);
an electron transport region (ETR) on the emission layer (EML); and
a second electrode (EL2) on the electron transport region (ETR),
wherein the hole transport region (HTR) comprises a first hole transport layer (HTL1) between the first electrode (EL1) and the emission layer (EML), the first hole transport layer (HTL1) comprising a first hole transport material, and
wherein the first hole transport layer (HTL1) comprises:

a first sub-hole transport layer (SHTL1) on the first electrode (EL1) and comprising the first hole transport material and a first p-dopant with which the first hole transport material is doped;
a second sub-hole transport layer (SHTL2) between the emission layer (EML) and the first sub-hole transport layer (SHTL1), the second sub-hole transport layer (SHTL2) comprising the first hole transport material and a second p-dopant with which the first hole transport material is doped; and
a third sub-hole transport layer (SHTL3) between the first sub-hole transport layer (SHTL1) and the second sub-hole transport layer (SHTL2), the third sub-hole transport layer (SHTL3) comprising the first hole transport material and not comprising a p-dopant.

**2.** The light emitting element (LD) of claim 1, wherein each of the first p-dopant and the second p-dopant has a lowest unoccupied molecular orbital (LUMO) energy level with an absolute value of about 4.5 eV to about 6.0 eV.

**3.** The light emitting element (LD) of claim 1 or claim 2, wherein an absolute value of highest occupied molecular orbital (HOMO) energy level of the first hole transport material is lower than an absolute value of HOMO energy level of each of the first p-dopant and the second p-dopant.

4. The light emitting element (LD) of any one of claims 1 to 3, wherein an absolute value of highest occupied molecular orbital (HOMO) energy level of the first hole transport material is H1, and an absolute value of lowest unoccupied molecular orbital (LUMO) energy level of each of the first p-dopant and the second p-dopant is P1, and wherein a case in which H1 is equal to or greater than P1 satisfies Equation 1, and a case in which P1 is greater than H1 satisfies Equation 2:

Equation 1

$$H1 - P1 \leq 0.5 \text{ eV}$$

Equation 2

$$P1 - H1 < 1.0 \text{ eV}.$$

5. The light emitting element (LD) of any one of claims 1 to 4, wherein the first p-dopant and the second p-dopant are identical to each other.

6. The light emitting element (LD) of any one of claims 1 to 5, wherein the first hole transport layer (HTL1) further comprises a fourth sub-hole transport layer (SHTL4) between the second sub-hole transport layer (SHTL2) and the emission layer (EML), the fourth sub-hole transport layer (SHTL4) comprising the first hole transport material and not comprising a p-dopant.

7. The light emitting element (LD) of any one of claims 1 to 6, wherein the first hole transport material comprises a first-first hole transport material and a first-second hole transport material different from the first-first hole transport material.

8. The light emitting element (LD) of any one of claims 1 to 7, wherein the hole transport region (HTR) further comprises a second hole transport layer (HTL2) between the first hole transport layer (HTL1) and the emission layer (EML), the second hole transport layer (HTL2) comprising a second hole transport material different from the first hole transport material.

9. The light emitting element (LD) of any one of claims 1 to 8, wherein the hole transport region (HTR) further comprises a third hole transport layer (HTL3) between the first electrode (EL1) and the first hole transport layer (HTL1), the third hole transport layer (HTL3) comprising a third hole transport material.

10. The light emitting element (LD) of any one of claims 1 to 9, wherein the first hole transport material is represented by Formula 1 or Formula 2:

Formula 1

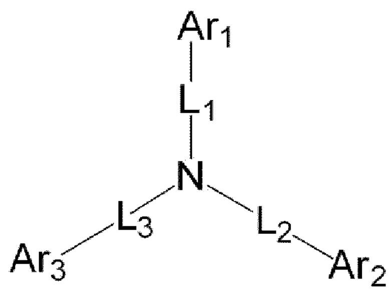

Formula 2

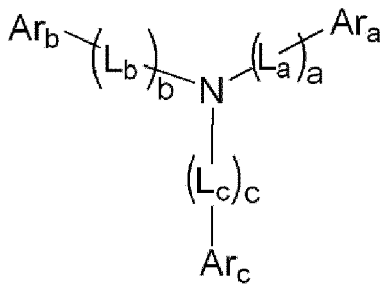

,

wherein in Formula 1 and Formula 2,

$Ar_1$ to $Ar_3$ are each independently a substituted or unsubstituted aryl group having 6 to 30 ring-forming carbon atoms or a substituted or unsubstituted heteroaryl group having 2 to 30 ring-forming carbon atoms,
$Ar_a$ to $Ar_c$ are each independently a substituted or unsubstituted amine group, a substituted or unsubstituted aryl group having 6 to 30 ring-forming carbon atoms, or a substituted or unsubstituted heteroaryl group having 2 to 30 ring-forming carbon atoms,
$L_1$ to $L_3$ and $L_a$ to $L_c$ are each independently a direct linkage, a substituted or unsubstituted arylene group having 6 to 30 ring-forming carbon atoms, or a substituted or unsubstituted heteroarylene group having 2 to 30 ring-forming carbon atoms,
a to c are each independently an integer of 0 to 3, and
in Formula 1, at least one selected from among $L_1$ through $L_3$ is a phenylene group represented by Formula A-1 or Formula A-2 or a substituted or unsubstituted divalent naphthyl group, and/or at least one of $Ar_1$ or $Ar_3$ is substituted with a substituted or unsubstituted cycloalkyl group having 3 to 20 carbon atoms,

Formula A-1

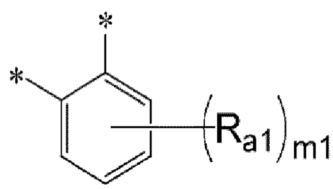

Formula A-2

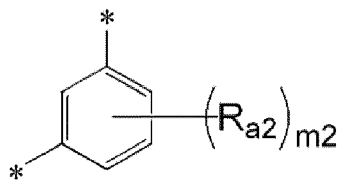

,

and wherein in Formula A-1 and Formula A-2,

$R_{a1}$ and $R_{a2}$ are each independently hydrogen, deuterium, a halogen, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and
m1 and m2 are each independently an integer of 0 to 4.

**11.** The light emitting element (ED) of any one of claims 1 to 10, wherein the first sub-hole transport layer (SHTL1) and the second sub-hole transport layer (SHTL2) each have a thickness of about 30 Å to about 200 Å.

**12.** The light emitting element (ED) of any one of claims 1 to 11, wherein the second sub-hole transport layer (SHTL2) is spaced from the emission layer (EML) in a thickness direction, and
the second sub-hole transport layer (SHTL2) and the emission layer (EML) are separated with a distance of about 100 Å to about 300 Å.

**13.** The light emitting element (ED) of any one of claims 1 to 12, wherein the first p-dopant is present at an amount level of about 10 wt% or less with respect to a total amount of 100 wt% of the first sub-hole transport layer (SHTL1), and the second p-dopant is present at an amount level of about 10 wt% or less with respect to a total amount of 100 wt% of the second sub-hole transport layer (SHTL2).

**14.** The light emitting element (LD) of any one of claims 1 to 13, wherein the first hole transport material comprises at least one selected from among compounds in Compound Group 1 and Compound Group 2:

Compound Group 1

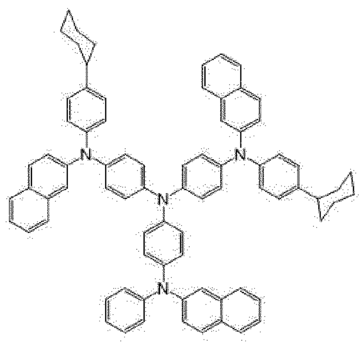

A1

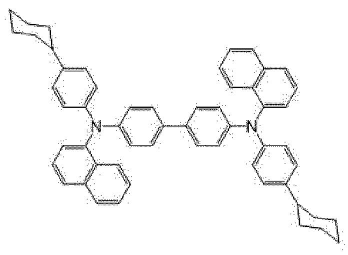

A2

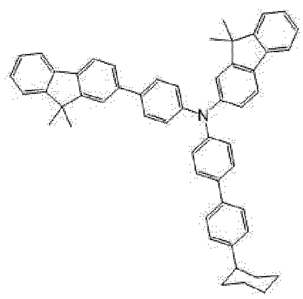

A3

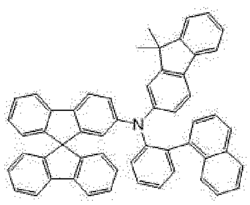

A4

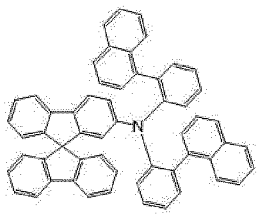

A5

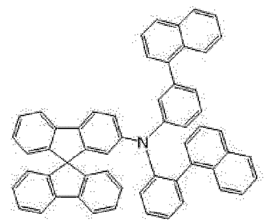

A6

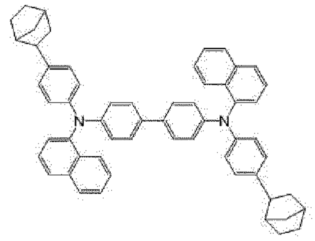

A7

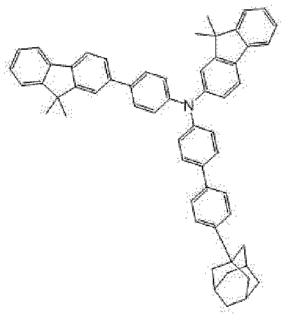

A8

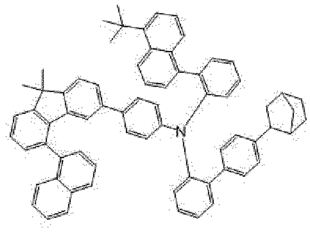

A9

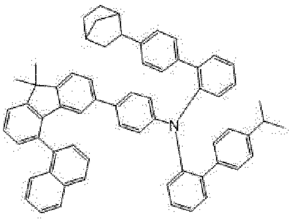

A10

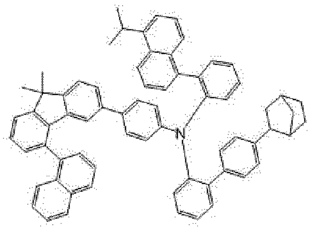

A11

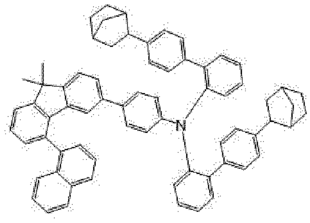

A12

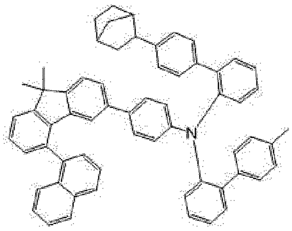

A13

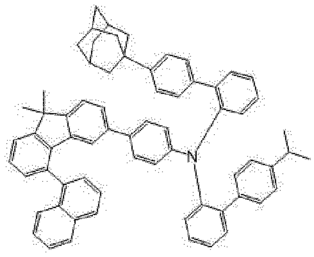

A14

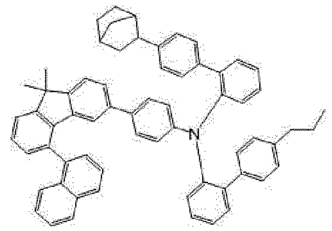

A15

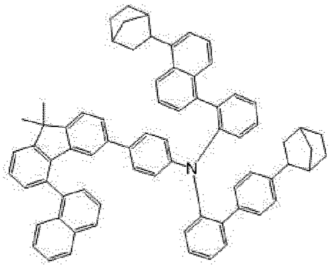

A16

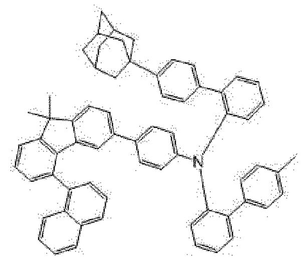

A17

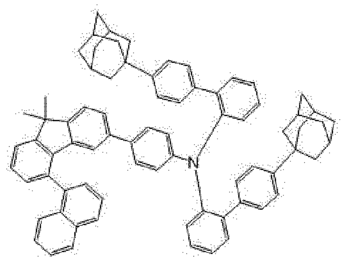

A18

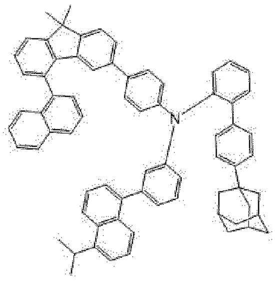

A19

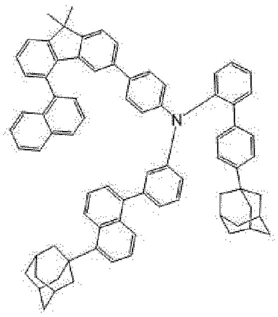

A20

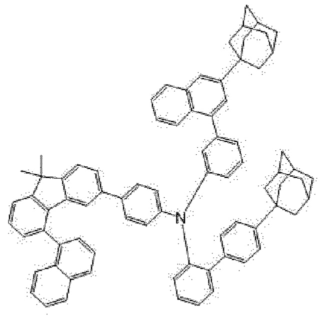

A21

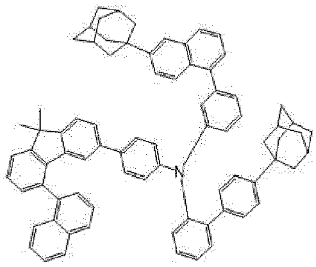

A22

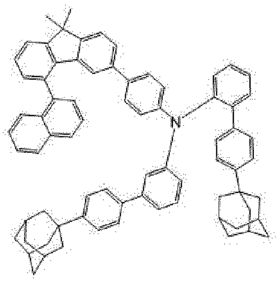

A23

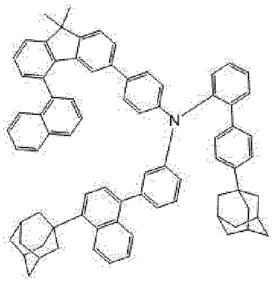

A24

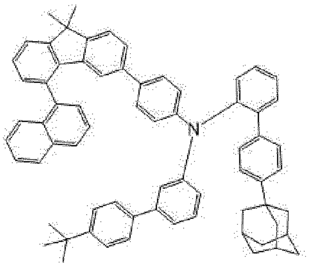

A25

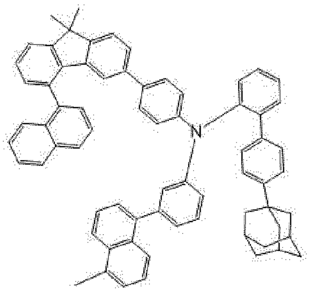

A26

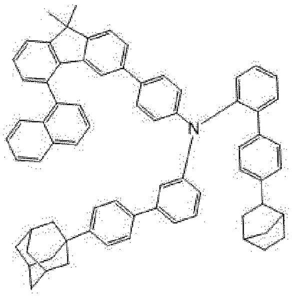

A27

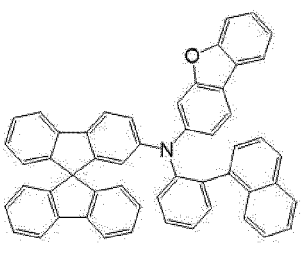

A28

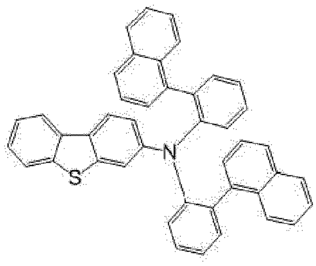

A29

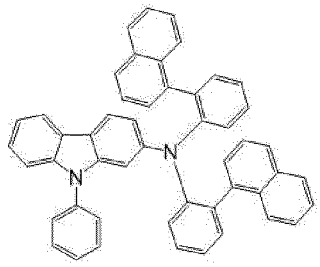

A30

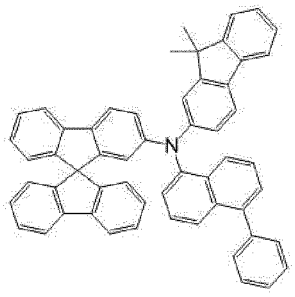

A31

Compound Group 2

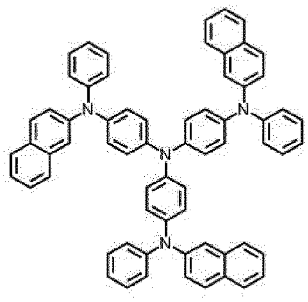

B1

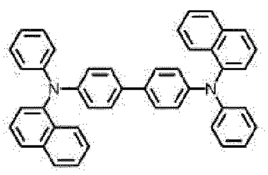

B2

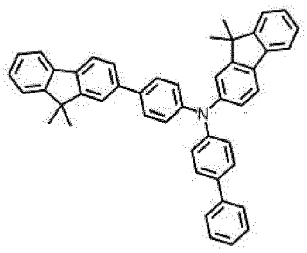

B3

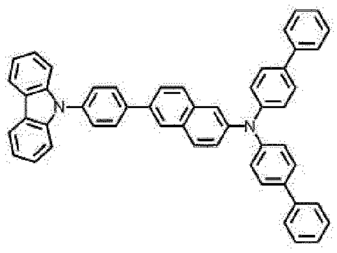

B4

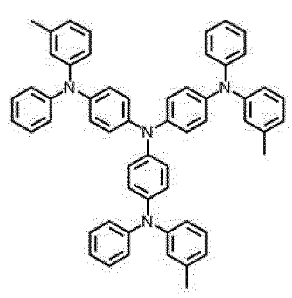

B5

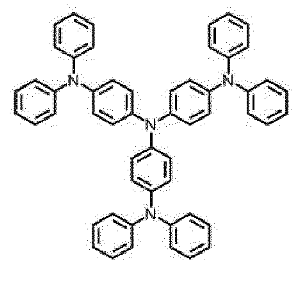

B6

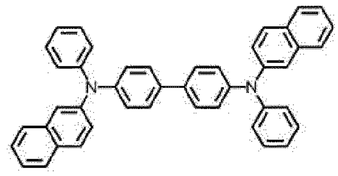

B7

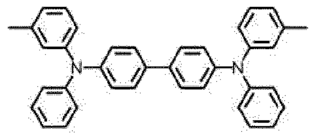

B8

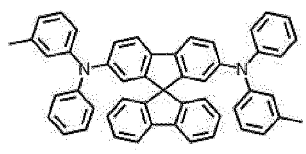

B9

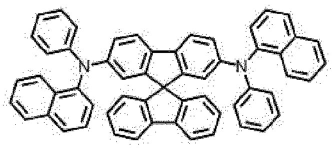

B10

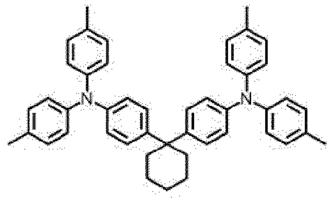

B11

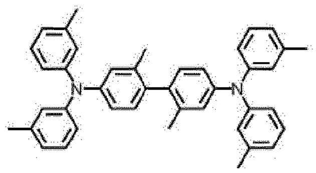

B12

**15.** An electronic device comprising:

a base layer (BS) comprising a plurality of light emitting regions (PXA-R, PXA-G, PXA-B) and a non-light emitting region (NPXA) adjacent to the plurality of light emitting regions (PXA-R, PXA-G, PXA-B);
a circuit layer (DP-CL) on the base layer (BS); and
a display element layer (DP-ED) on the circuit layer (DP-CL) and comprising a plurality of light emitting elements (ED-1, ED-2, ED-3) respectively corresponding to each of the plurality of light emitting regions (PXA-R, PXA-G, PXA-B),
wherein at least some selected from among the plurality of light emitting elements (ED-1, ED-2, ED-3) each comprises:

a first electrode (EL1);
a hole transport region (HTR) on the first electrode (EL1);
an emission layer (EML-R, EML-G, EML-B) on the hole transport region (HTR);
an electron transport region (ETR) on the emission layer (EML-R, EML-G, EML-B); and
a second electrode (EL2) on the electron transport region (ETR),
the hole transport region (HTR) comprises a first hole transport layer (HTL1) between the first electrode (EL1) and the emission layer (EML-R, EML-G, EML-B), the first hole transport layer (HTL1) comprising a first hole transport material, and
the first hole transport layer (HTL1) comprises:

a first sub-hole transport layer (SHTL1) on the first electrode (EL1) and comprising the first hole transport material and a first p-dopant with which the first hole transport material is doped;
a second sub-hole transport layer (SHTL2) between the emission layer (EML-R, EML-G, EML-B) and the first sub-hole transport layer (SHTL1), the second sub-hole transport layer (SHTL2) comprising the first hole transport material and a second p-dopant with which the first hole transport material is doped; and
a third sub-hole transport layer (SHTL3) between the first sub-hole transport layer (SHTL1) and the second sub-hole transport layer (SHTL2), the third sub-hole transport layer (SHTL3) comprising the first hole transport material and not comprising a p-dopant.

FIG. 1

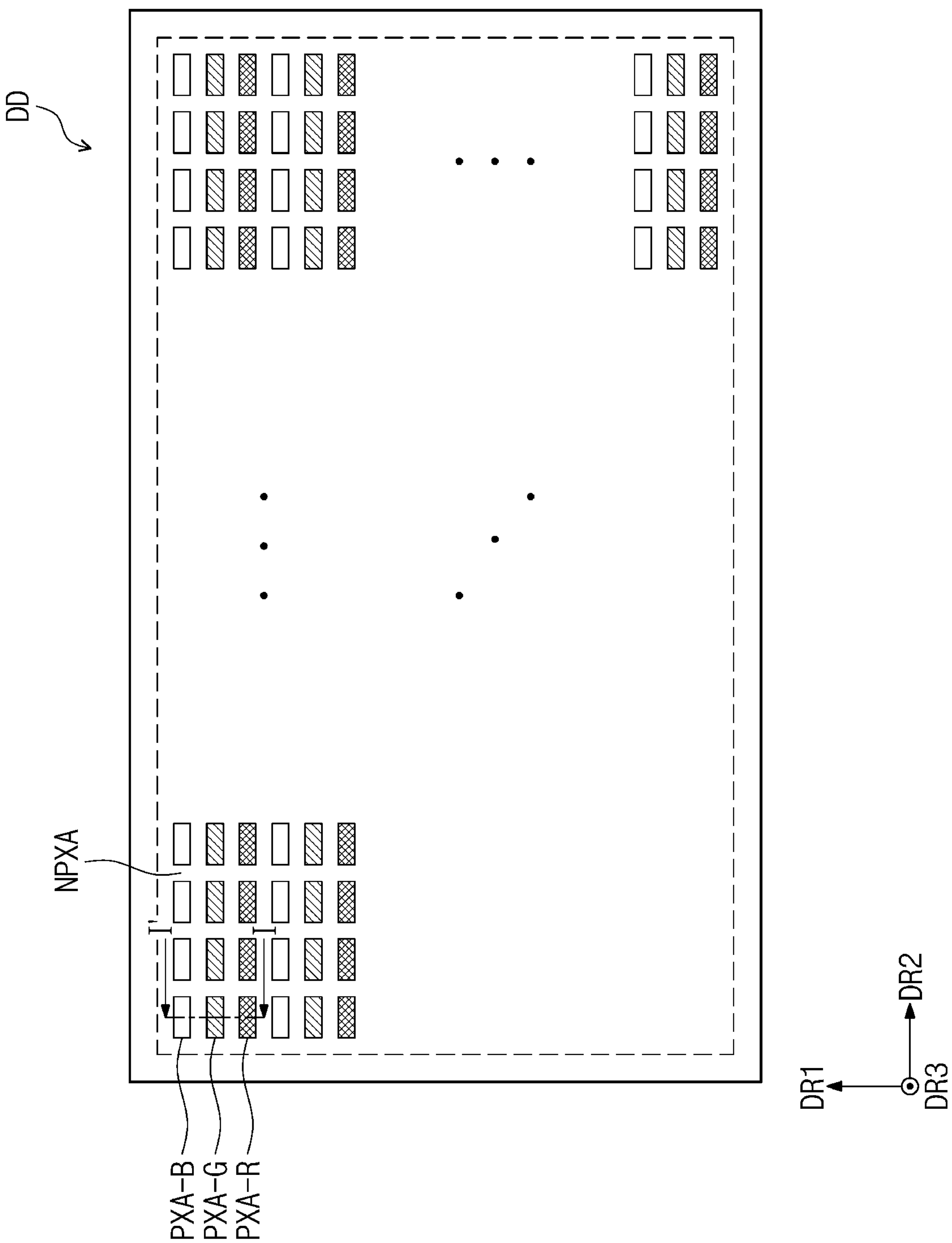

FIG. 2

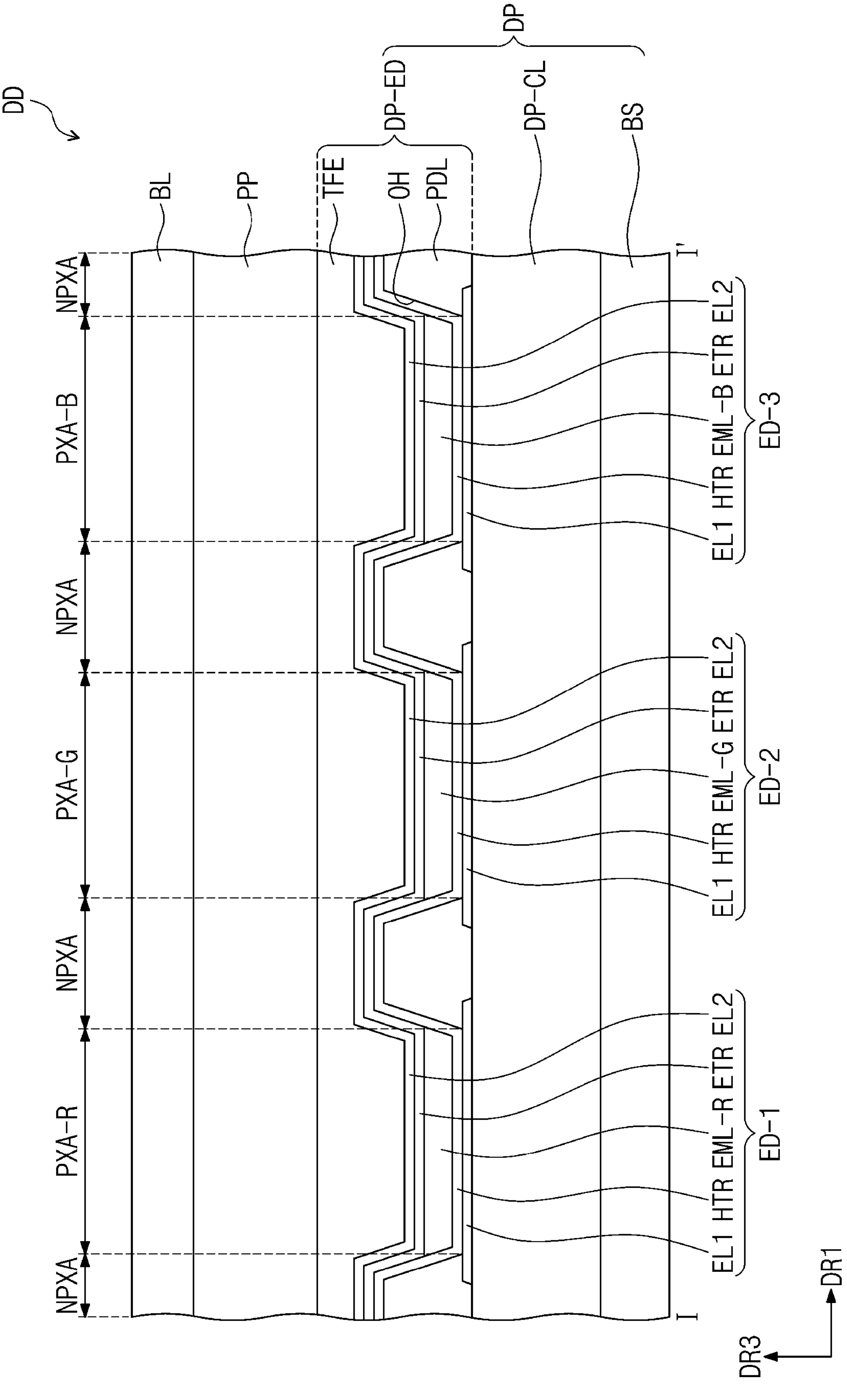

DD
DP
DP-ED
DP-CL
BS
BL
PP
TFE
OH
PDL
I'
I
NPXA
PXA-B
NPXA
PXA-G
NPXA
PXA-R
NPXA
EL2
ETR
EML-B
HTR
EL1
ED-3
EL2
ETR
EML-G
HTR
EL1
ED-2
EL2
ETR
EML-R
HTR
EL1
ED-1
DR1
DR3

FIG. 3

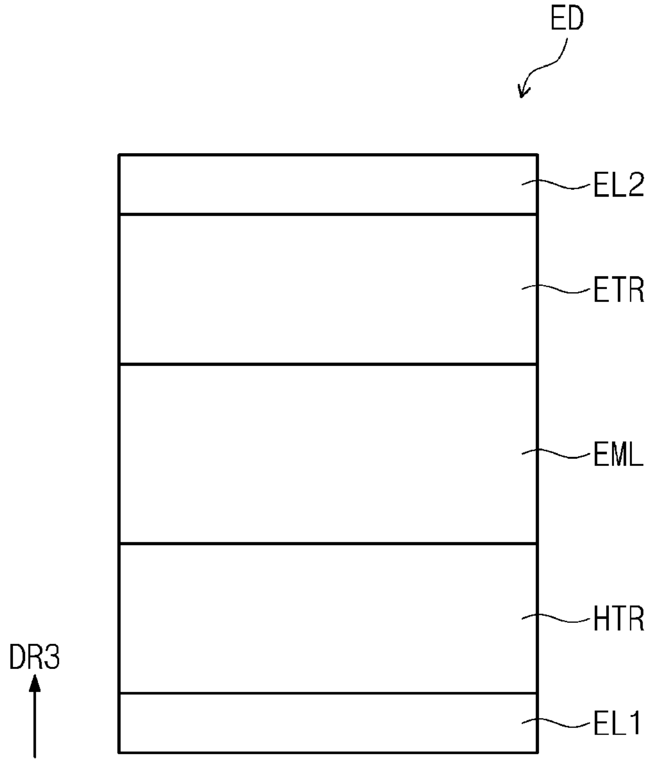
ED
EL2
ETR
EML
HTR
EL1
DR3

FIG. 4

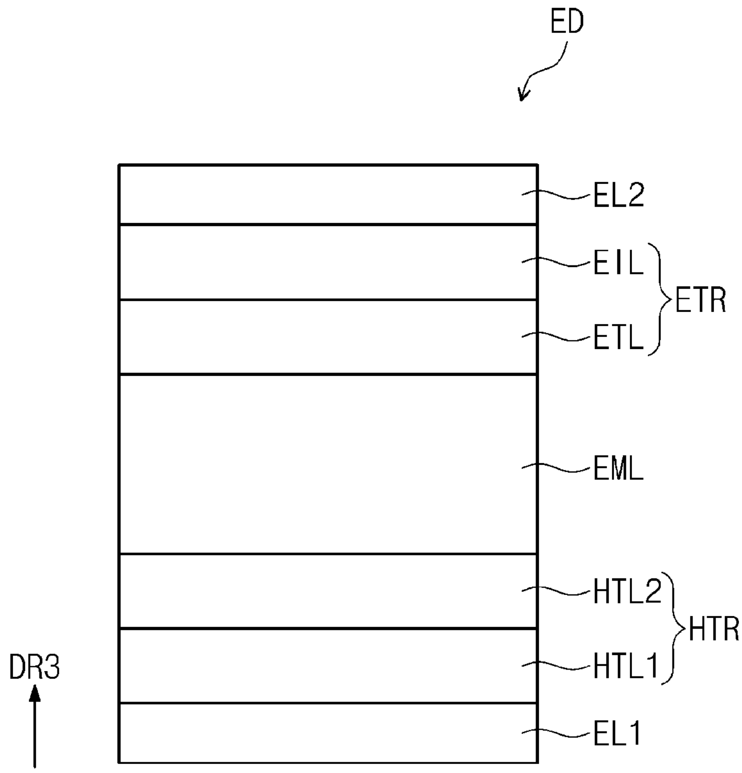
ED
EL2
EIL
ETL
ETR
EML
HTL2
HTL1
HTR
EL1
DR3

FIG. 5A

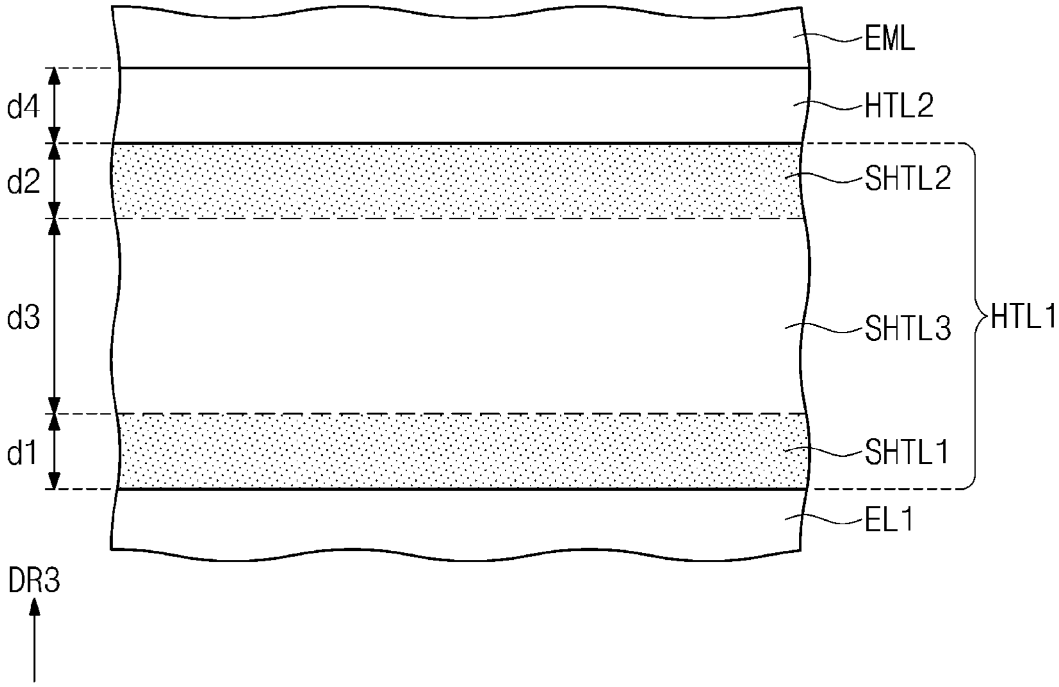
EML
HTL2
SHTL2
SHTL3
HTL1
SHTL1
EL1
d4
d2
d3
d1
DR3

FIG. 5B

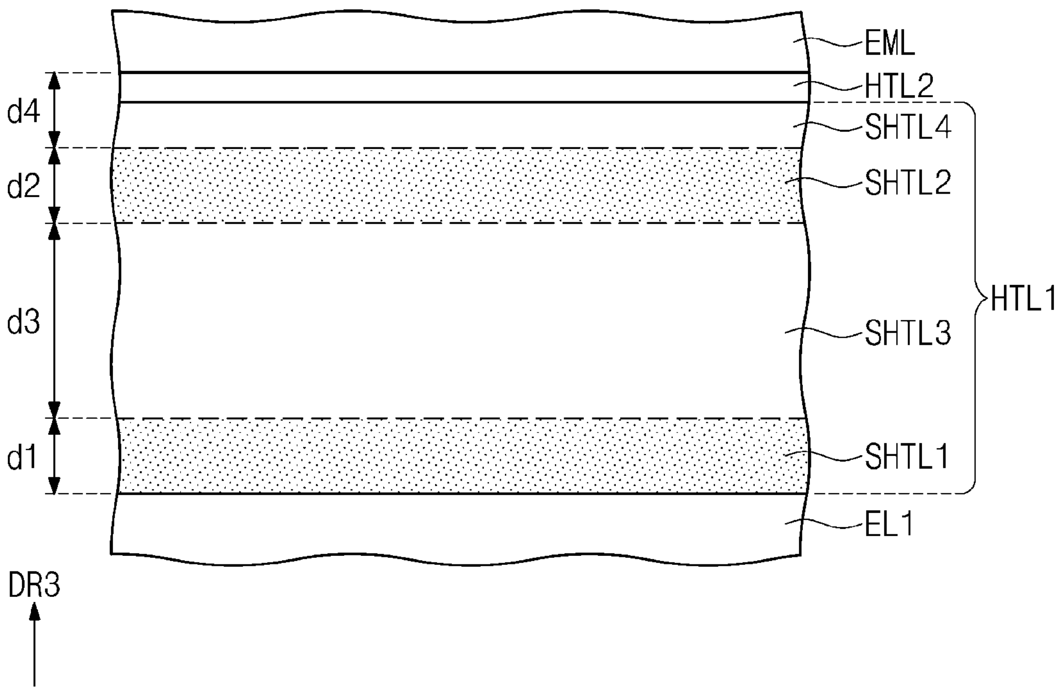
EML
HTL2
SHTL4
SHTL2
SHTL3
HTL1
SHTL1
EL1
d4
d2
d3
d1
DR3

FIG. 6

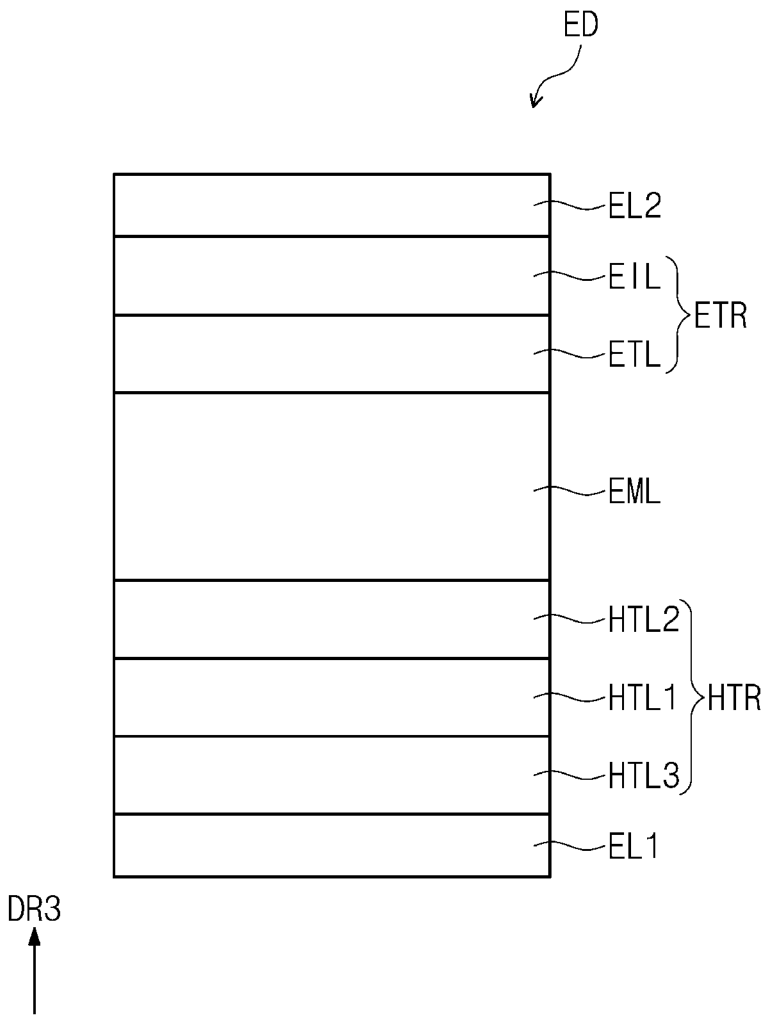

FIG. 7

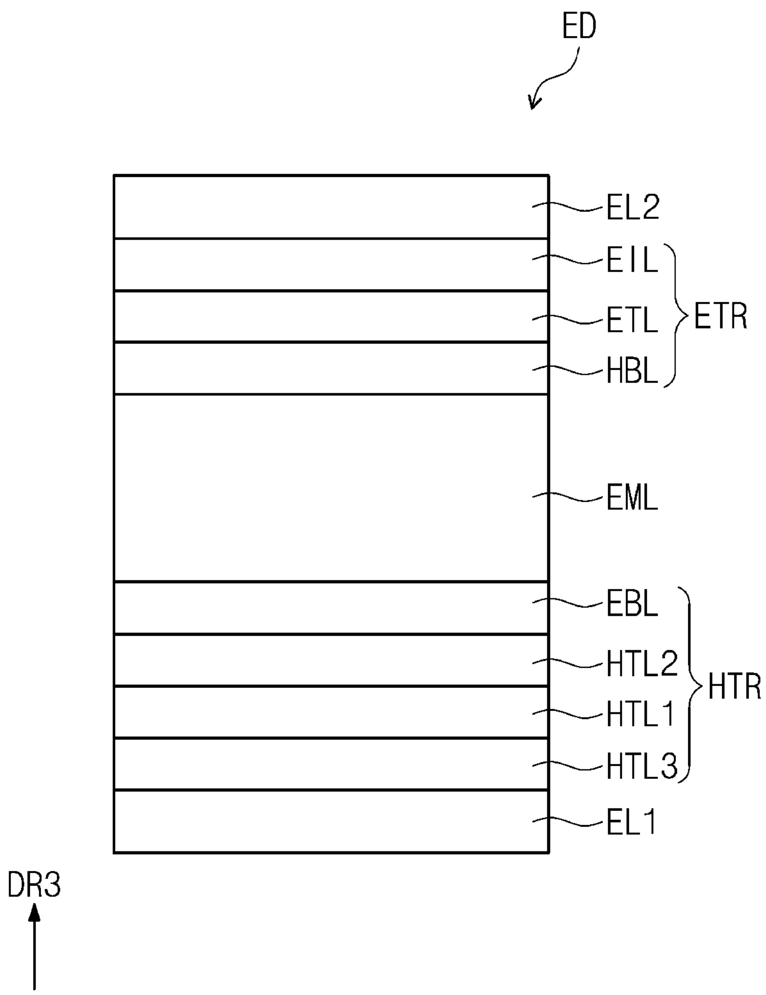

FIG. 8

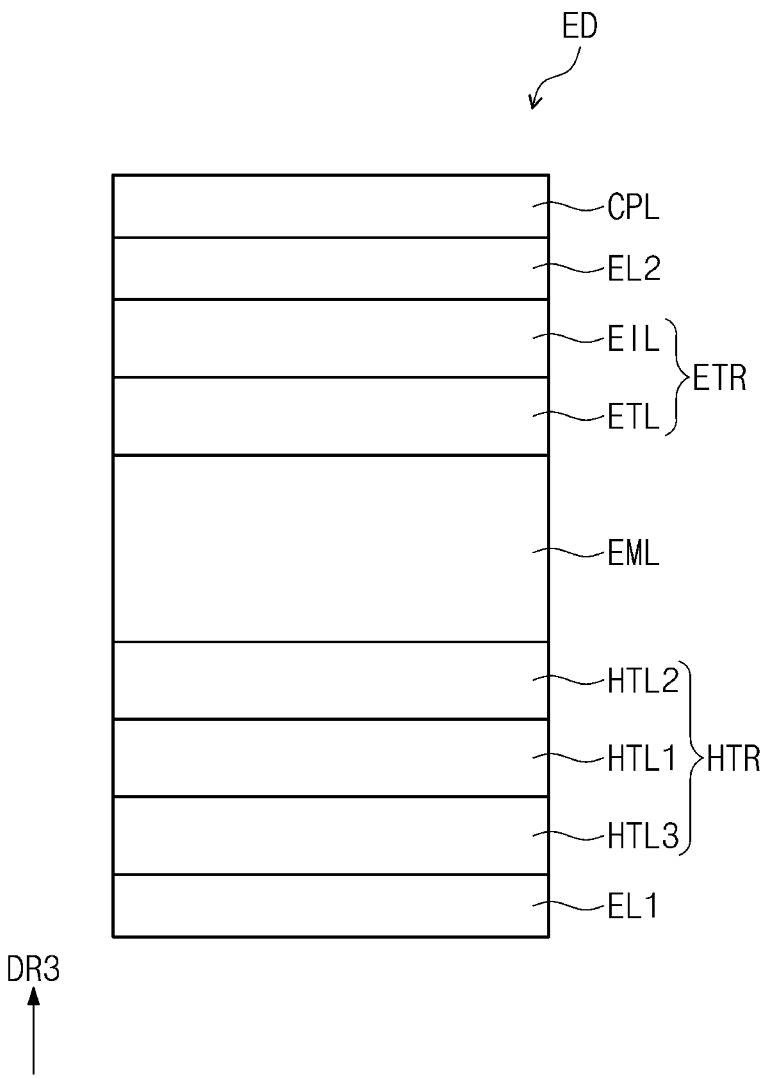

FIG. 9

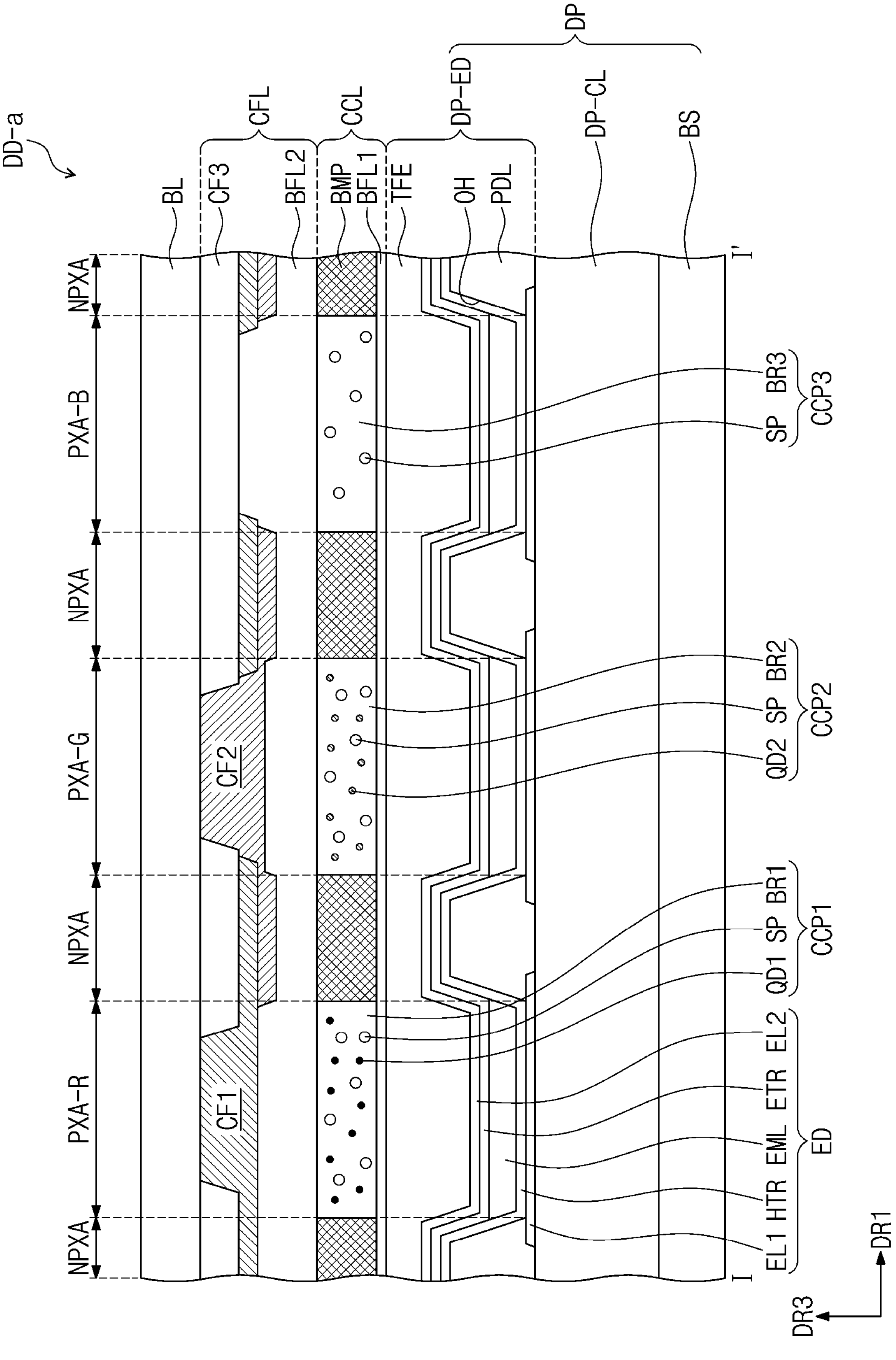
DD-a
DP
DP-ED
DP-CL
BS
CFL
CCL
BL
CF3
BFL2
BMP
BFL1
TFE
OH
PDL
NPXA
PXA-B
NPXA
PXA-G
NPXA
PXA-R
NPXA
CF2
CF1
SP BR3
CCP3
QD2 SP BR2
CCP2
QD1 SP BR1
CCP1
EL1 HTR EML ETR EL2
ED
I
I'
DR3
DR1

FIG. 10

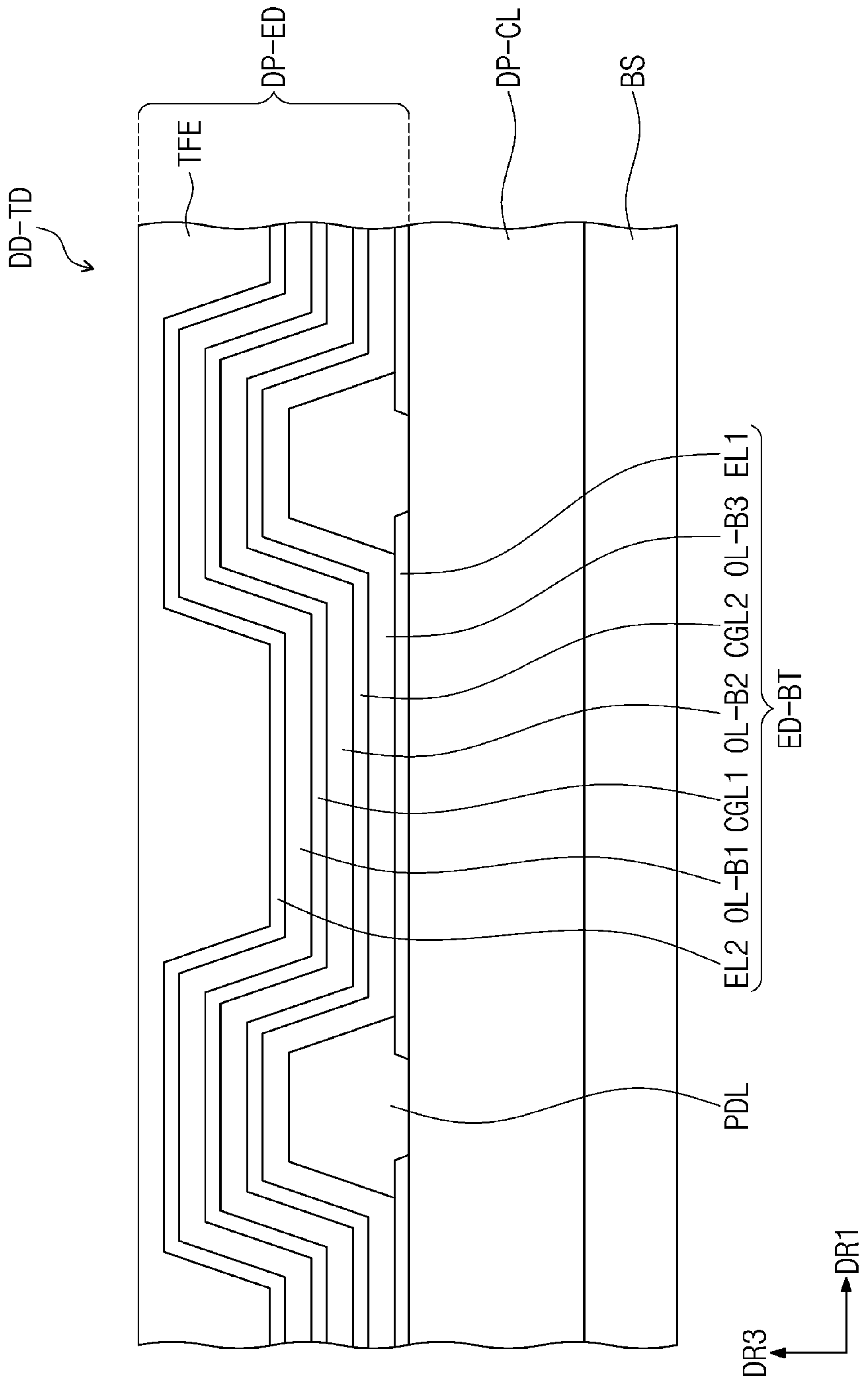
DD-TD
DP-ED
TFE
DP-CL
BS
EL1
OL-B3
CGL2
OL-B2
CGL1
OL-B1
EL2
ED-BT
PDL
DR1
DR3

FIG. 11

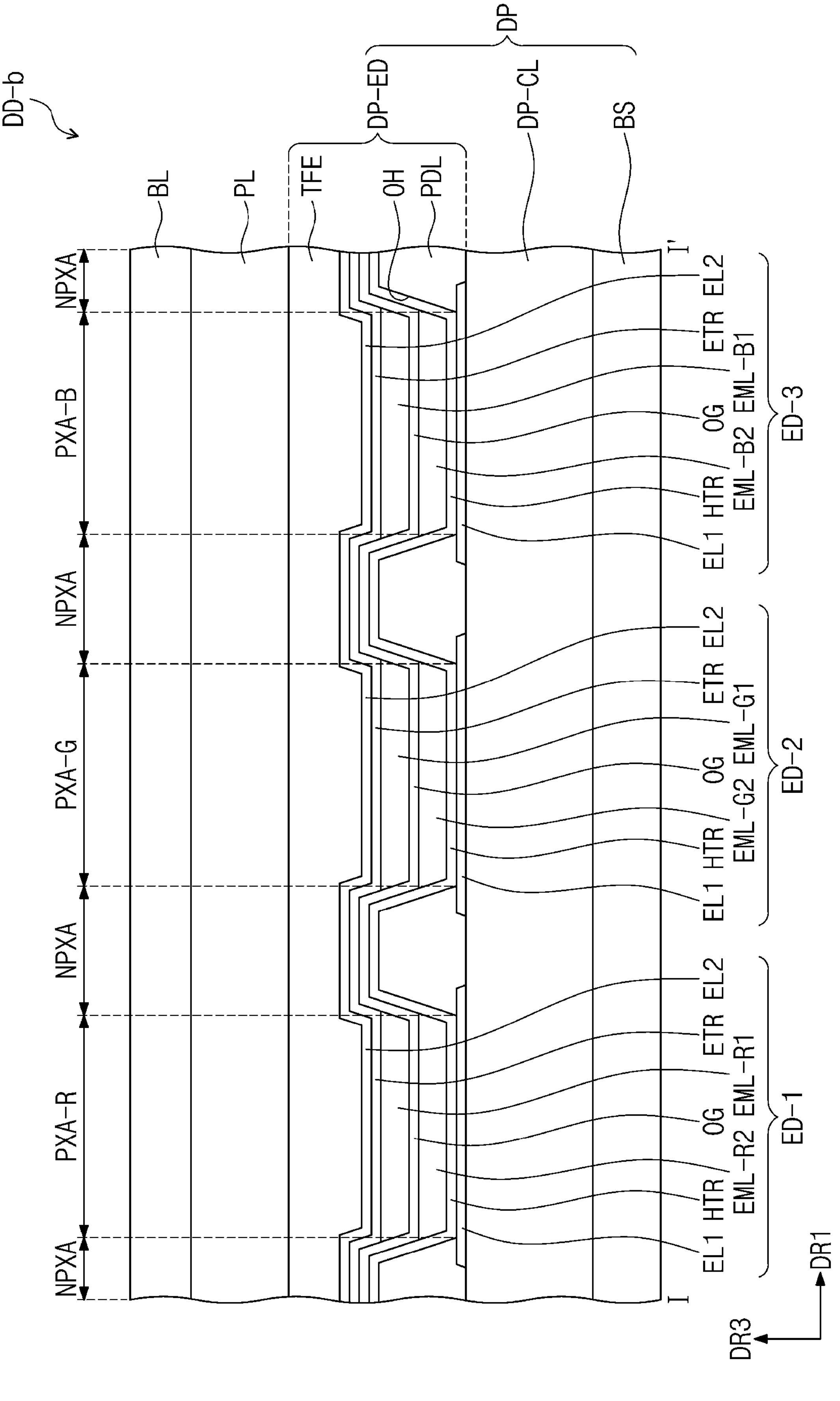
DD-b
DP
DP-ED
DP-CL
BS
BL
PL
TFE
OH
PDL
NPXA
PXA-B
NPXA
PXA-G
NPXA
PXA-R
NPXA
I'
I
EL2
ETR
EML-B1
OG
EML-B2
HTR
EL1
ED-3
EL2
ETR
EML-G1
OG
EML-G2
HTR
EL1
ED-2
EL2
ETR
EML-R1
OG
EML-R2
HTR
EL1
ED-1
DR1
DR3

FIG. 12

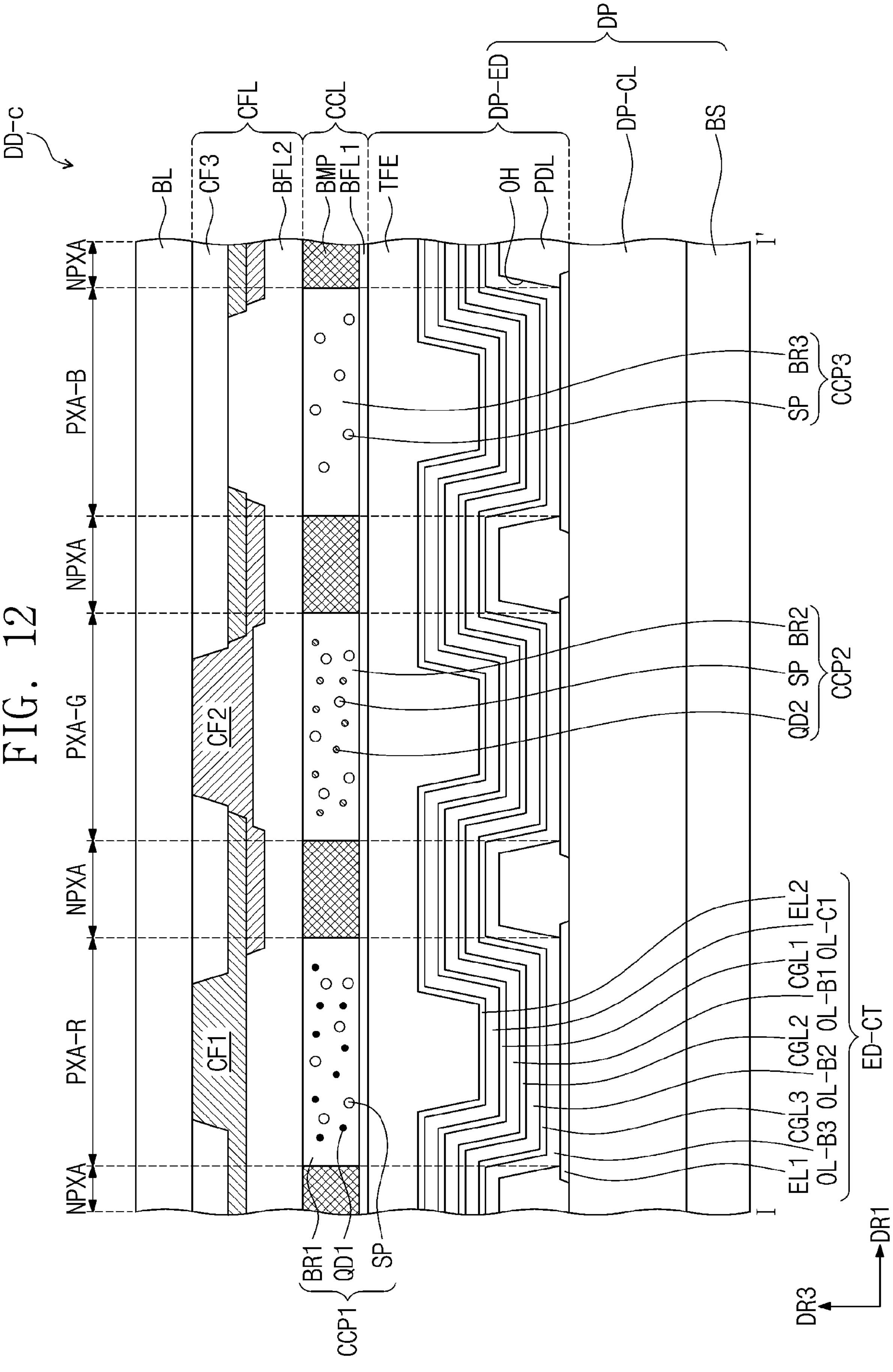
DD-c
BL
CF3
BFL2
BMP
BFL1
TFE
OH
PDL
CFL
CCL
DP-ED
DP-CL
BS
DP
NPXA
PXA-B
NPXA
PXA-G
NPXA
PXA-R
NPXA
CF1
CF2
I'
I
SP
BR3
CCP3
SP
BR2
QD2
CCP2
EL2
OL-C1
CGL1
OL-B1
CGL2
OL-B2
CGL3
OL-B3
EL1
ED-CT
BR1
QD1
SP
CCP1
DR1
DR3

FIG. 13

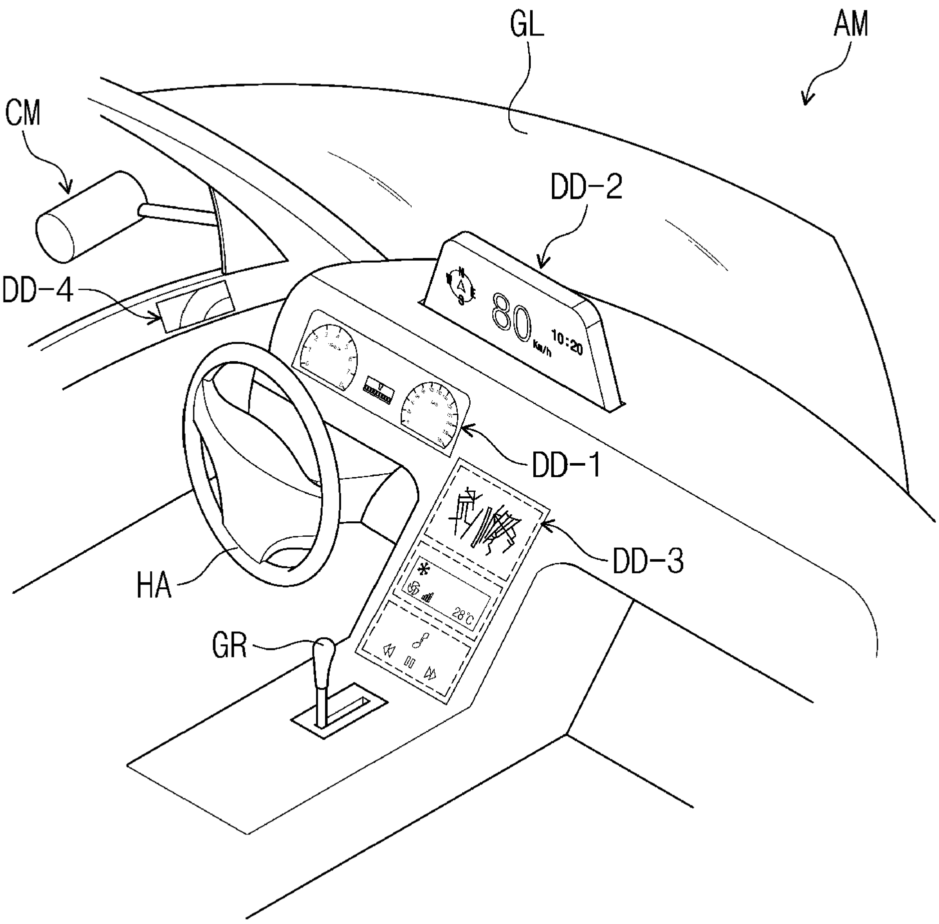

Europäisches Patentamt
European Patent Office
Office européen des brevets

# EUROPEAN SEARCH REPORT

Application Number
EP 25 19 4459

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YANG K ET AL: "Effects of alternate doped structures on organic electroluminescent devices", THIN SOLID FILMS, ELSEVIER, AMSTERDAM, NL, vol. 408, no. 1-2, 3 April 2002 (2002-04-03), pages 206-210, XP004351364, ISSN: 0040-6090, DOI: 10.1016/S0040-6090(02)00147-5 * figure 1b * ----- | 1-15 | INV. H10K50/155 H10K50/15 ADD. H10K101/30 H10K101/40 |
| A | US 2023/422538 A1 (XIE MENGLAN [CN] ET AL) 28 December 2023 (2023-12-28) * examples 1-1 * ----- | 1-15 | |
| A | US 2023/180493 A1 (SONG EUNHYE [KR] ET AL) 8 June 2023 (2023-06-08) * example 2; table 1 * ----- | 1-15 | |
| A | MENGLAN XIE ET AL: "Charge balance in OLEDs: Optimization of hole injection layer using novel p-dopants", JOURNAL OF THE SOCIETY FOR INFORMATION DISPLAY - SID, SOCIETY FOR INFORMATION DISPLAY, US, vol. 32, no. 2, 23 February 2024 (2024-02-23), pages 71-81, XP072593617, ISSN: 1071-0922, DOI: 10.1002/JSID.1271 * figure 7 * ----- | 1-15 | TECHNICAL FIELDS SEARCHED (IPC) H10K |

The present search report has been drawn up for all claims

3

| Place of search | Date of completion of the search | Examiner |
|---|---|---|
| The Hague | 2 December 2025 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 19 4459

This annex lists the patent family members relating to the patent documents cited in the above-mentioned European search report. The members are as contained in the European Patent Office EDP file on The European Patent Office is in no way liable for these particulars which are merely given for the purpose of information.

02-12-2025

| Patent document cited in search report | Publication date | Patent family member(s) | Publication date |
|---|---|---|---|
| US 2023422538 A1 | 28-12-2023 | CN 117377339 A | 09-01-2024 |
| | | JP 7562176 B2 | 07-10-2024 |
| | | JP 2024004487 A | 16-01-2024 |
| | | KR 20240002223 A | 04-01-2024 |
| | | US 2023422538 A1 | 28-12-2023 |
| US 2023180493 A1 | 08-06-2023 | CN 116234344 A | 06-06-2023 |
| | | KR 20230085275 A | 14-06-2023 |
| | | US 2023180493 A1 | 08-06-2023 |

EPO FORM P0459

For more details about this annex : see Official Journal of the European Patent Office, No. 12/82